# EUROPEAN PATENT APPLICATION

(11) **EP 4 650 873 A1**
(43) Date of publication of application: **19.11.2025**
(21) Application number: 25175720.9
(22) Date of filing: 12.05.2025
(51) Int. Cl.: G03F 7/004, G03F 7/039

(54) **CHEMICALLY AMPLIFIED POSITIVE RESIST COMPOSITION AND RESIST PATTERN FORMING PROCESS**

(30) Priority: 16.05.2024 JP 2024080181
(71) Applicant: SHIN-ETSU CHEMICAL CO., LTD., Tokyo 1000005 (JP)
(72) Inventor: FUKUSHIMA, Masahiro, Joetsu-shi (JP); WATANABE, Satoshi, Joetsu-shi (JP); FUNATSU, Kenji, Joetsu-shi (JP); MASUNAGA, Keiichi, Joetsu-shi (JP); KOTAKE, Masaaki, Joetsu-shi (JP); MATSUZAWA, Yuta, Joetsu-shi (JP)
(74) Representative: Ter Meer Steinmeister & Partner

(57) **Abstract**

A chemically amplified positive resist composition is provided comprising a polymer having a dispersity of 1.01-1.19 and comprising repeat units derived from hydroxystyrene or hydroxynaphthalene, and repeat units derived from hydroxystyrene or hydroxynaphthalene having a hydroxy group protected with an acid labile group, a photoacid generator, and an organic solvent. From a resist film of the composition, a resist pattern of small feature size having satisfactory isolated-space resolution, reduced LER, good rectangularity, etch resistance and collapse resistance is formed.

## Description

### TECHNICAL FIELD

This invention relates to a chemically amplified positive resist composition and a resist pattern forming process.

### BACKGROUND ART

Pattern formation to a smaller feature size is required to meet the recent demand for higher integration in integrated circuits. Acid-catalyzed chemically amplified resist compositions are most often used in forming resist patterns with a feature size of 0.2 µm or less. For exposure of these resist compositions, high-energy radiation such as UV, deep-UV, EUV or EB is used as the energy source. In particular, the EB lithography, which is utilized as the ultra-fine microfabrication technique, is also indispensable in processing a photomask blank into a photomask for use in the fabrication of semiconductor devices.

In general, the EB lithography is by writing an image with EB, without using a mask. In the case of positive resist, those regions of a resist film other than the regions to be retained are successively irradiated with EB having a minute area. In the case of negative resist, those regions of a resist film to be retained are successively irradiated with EB. The operation of successively scanning all finely divided regions on the work surface takes a long time as compared with full wafer exposure through a photomask. To prevent any throughput decline, a resist film having a high sensitivity is required. One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. A small line-edge-roughness (LER) is another important performance factor. In recent years, the multibeam mask writing (MBMW) process is used in the processing of mask blanks to achieve further miniaturization. The resist used in the MBMW process is a low-sensitivity resist composition (or high-dose region) which is advantageous in roughness while a spotlight is brought to the optimization of the resist composition in the high-dose region.

Attempts were made to ameliorate resist sensitivity and pattern profile in a controlled way by properly selecting and combining components used in resist compositions and adjusting processing conditions. One outstanding problem is the diffusion of acid, which has a significant impact on the resolution of a chemically amplified resist film. In the processing of photomasks, it is required that the profile of the resist pattern resulting from exposure does not change depending on the time taken until PEB. The major cause for time-dependent changes is the diffusion of acid generated upon exposure. Since the problem of acid diffusion has large impacts on sensitivity and resolution not only in the photomask processing, but also in general resist compositions, many studies are made thereon.

Patent Documents 1 and 2 describe acid generators capable of generating bulky acids upon exposure, for thereby controlling acid diffusion and reducing LER. Since these acid generators are still insufficient to control acid diffusion, it is desired to have an acid generator with more controlled diffusion.

Patent Document 3 discloses a resist composition wherein repeat units having a sulfonium structure capable of generating a sulfonic acid upon light exposure are introduced into a polymer whereby acid diffusion is controlled. This approach of controlling acid diffusion by introducing repeat units capable of generating acid upon exposure into a base polymer is effective in forming a pattern with reduced LER. However, the base polymer having bound therein repeat units capable of generating acid upon exposure encounters a problem with respect to its solubility in organic solvent, depending on the structure and proportion of the relevant units.

Polymers comprising a major proportion of aromatic structure having an acidic side chain, for example, substituted polyhydroxystyrene, i.e., polyhydroxystyrene provided with some functional groups are useful in resist materials for the KrF lithography. See Patent Documents 4 and 5. In preparing these polymers, radical or anionic polymerization is applied. Patent Documents 6 to 8 report methods of preparing substituted polyhydroxystyrene via anionic polymerization. Since the aromatic ring in the base polymer exhibits substantial absorption to light around wavelength 200 nm, polymers like the substituted polyhydroxystyrene are not used as the base polymer in resist materials for the ArF lithography of the next generation. These polymers, however, are expected to form useful resist materials for the EB and EUV lithography for forming patterns of smaller size than the processing limit of ArF lithography because they offer high etching resistance.

Positive resist compositions for EB and EUV lithography use as the base polymer a polymer having an acidic functional group on phenol side chain masked with an acid labile group (or acid-decomposable protective group). Upon exposure to high-energy radiation, the acid labile group is deprotected by the catalysis of an acid generated from a photoacid generator so that the polymer may turn soluble in alkaline developer. Typical of the acid labile group are tertiary alkyl, tert-butoxycarbonyl, and acetal groups. Acetal groups are used as the acid labile group requiring a relatively low level of activation energy for deprotection. See Patent Documents 9 to 13.

Studies are also made to improve the photoacid generators. In particular, as the photoacid generator for use in the positive tone EB lithography, compounds capable of generating aromatic sulfonic acids are often used. Aiming to restrain excessive acid diffusion, Patent Documents 14 to 16 describe to make bulky the molecular structure in the vicinity of the generated acid and of the overall anion. An improvement in resolution is ascertained.

Under the current demand for further pattern miniaturization, the lithography performance is improved to some extent by the development of these materials, but the results are still unsatisfactory. It is desired to develop a resist composition having high resolution and improved lithography properties.

### Citation List

| | |
|---|---|
| Patent Document 1: | JP-A 2009-053518 |
| Patent Document 2: | JP-A 2010-100604 |
| Patent Document 3: | JP-A 2011-022564 (USP 8,361,693, EP 2264525B1) |
| Patent Document 4: | JP 4645789 |
| Patent Document 5: | JP 4742884 |
| Patent Document 6: | JP 3870527 |
| Patent Document 7: | JP 5121045 |
| Patent Document 8: | JP-A H06-32832 |
| Patent Document 9: | JP 3981830 |
| Patent Document 10: | JP 5385017 |
| Patent Document 11: | WO 2019/167419 |
| Patent Document 12: | JP 6987873 (USP 11,953,829) |
| Patent Document 13: | JP 5696254 |
| Patent Document 14: | JP 7032549 (USP 12,164,230) |
| Patent Document 15: | JP 6248882 |
| Patent Document 16: | JP 7067271 (USP 11,036,136, EP 3572877B1) |

### SUMMARY OF INVENTION

An object of the invention is to provide a chemically amplified positive resist composition which is lithographically processed into a resist pattern with a very high resolution of isolated spaces, reduced LER, improved rectangularity, etching resistance, and restrained pattern collapse. Another object of the invention is to provide a resist pattern forming process using the composition.

The inventors have found that when a chemically amplified positive resist composition comprises a polymer having a polydispersity index of 1.01 to 1.19 and comprising repeat units derived from hydroxystyrene or hydroxynaphthalene, and repeat units derived from hydroxystyrene having a hydroxy group protected with an acid labile group or hydroxynaphthalene having a hydroxy group protected with an acid labile group, a photoacid generator capable of generating a specific aromatic sulfonic acid, and an organic solvent, a resist pattern of small feature size having satisfactory isolated-space resolution, good profile, and reduced LER is formed even in high-dose regions, while minimizing residue defects and retaining etch resistance.

Accordingly, the invention provides a chemically amplified positive resist composition and a resist pattern forming process, as defined below.
1. A chemically amplified positive resist composition comprising
   (A) a base polymer comprising repeat units derived from hydroxystyrene or hydroxynaphthalene, and repeat units derived from hydroxystyrene having a hydroxy group protected with an acid labile group or hydroxynaphthalene having a hydroxy group protected with an acid labile group, and adapted to increase its solubility in alkaline aqueous solution under the action of acid, the base polymer having a dispersity of 1.0 to 1.19,
   (B) a photoacid generator having the formula (B), and
   (C) an organic solvent, 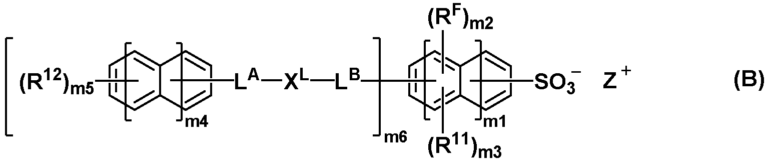 wherein m1 is 0 or 1, m2 is 0, 1, 2, 3 or 4, m3 is 0, 1, 2, 3, 4, 5 or 6, m1 to m3 are in the range: 0 ≤ m2+m3 ≤ 4 when m1=0, and 0 ≤ m2+m3 ≤ 6 when m1=1, m4 is 0 or 1, m5 is 0, 1, 2, 3 or 4 when m4=0 and m5 is 0, 1, 2, 3, 4, 5 or 6 when m4=1, m6 is 0 or 1,
      R¹¹ is halogen exclusive of fluorine, hydroxy, nitro, cyano, or a C₁-C₂₀ hydrocarbyl group which may contain a heteroatom, a plurality of R¹¹ may bond together to form a ring with the carbon atoms to which they are attached when m3 is 2 or more,
      R¹² is halogen, hydroxy, nitro, cyano, or a C₁-C₂₀ hydrocarbyl group which may contain a heteroatom, a plurality of R¹² may bond together to form a ring with the carbon atoms to which they are attached when m5 is 2 or more,
      R^{F} is fluorine, a C₁-C₆ fluorinated saturated hydrocarbyl group, C₁-C₆ fluorinated saturated hydrocarbyloxy group, or C₁-C₆ fluorinated saturated hydrocarbylthio group,
      L^{A} and L^{B} are each independently a single bond, ether bond, ester bond, sulfonate ester bond, sulfonamide bond, carbonate bond or carbamate bond,
      X^{L} is a single bond or a C₁-C₄₀ hydrocarbylene group which may contain a heteroatom, and
      Z⁺ is an onium cation.
2. The resist composition of 1 wherein the base polymer has a weight average molecular weight of 1,000 to 50,000.
3. The resist composition of 1 or 2 wherein the repeat units derived from hydroxystyrene or hydroxynaphthalene have the formula (A1): 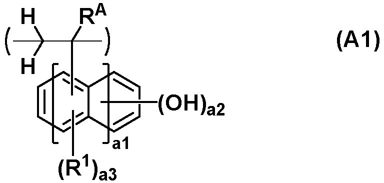 wherein a1 is 0 or 1, a2 is 1, 2 or 3, a3 is 0, 1, 2, 3 or 4, a1 to a3 are in the range: 1 ≤ a2+a3 ≤ 4 when a1=0 and 1 ≤ a2+a3 ≤ 6 when a1 = 1,
   R^{A} is hydrogen, fluorine, methyl or trifluoromethyl, and
   R¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group.
4. The resist composition of any one of 1 to 3 wherein the repeat units derived from hydroxystyrene having a hydroxy group protected with an acid labile group or hydroxynaphthalene having a hydroxy group protected with an acid labile group have the formula (A2): 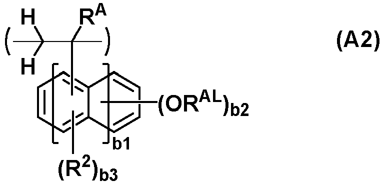 wherein b1 is 0 or 1, b2 is 1, 2 or 3, b3 is 0, 1, 2, 3 or 4, b1 to b3 are in the range: 1 ≤ b2+b3 ≤ 4 when b1=0 and 1 ≤ b2+b3 ≤ 6 when b1=1,
   R^{A} is hydrogen, fluorine, methyl or trifluoromethyl,
   R² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
   when b2=1, R^{AL} is an acid labile group, and when b2=2 or 3, R^{AL} is hydrogen or an acid labile group, at least one thereof being an acid labile group,
   the acid labile group has any one of the formulae (AL-1) to (AL-3): 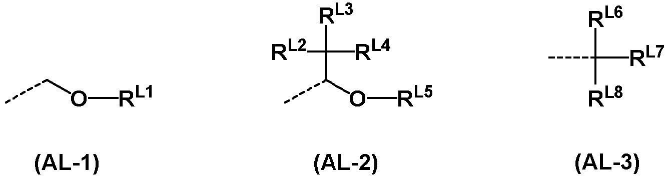 wherein R^{L1} is a C₁-C₂₀ hydrocarbyl group which may contain a heteroatom,
      R^{L2}, R^{L3} and R^{L4} are each independently hydrogen or a C₁-C₂₀ hydrocarbyl group which may contain a heteroatom, any two or three of R^{L2}, R^{L3} and R^{L4} may bond together to form a ring with the carbon atom to which they are attached,
      R^{L5} is a C₁-C₂₀ hydrocarbyl group which may contain a heteroatom, any one of R^{L2}, R^{L3} and R^{L4} and R^{L5} may bond together to form a ring with the carbon and oxygen atoms to which they are attached,
      R^{L6}, R^{L7} and R^{L8} are each independently a C₁-C₂₀ hydrocarbyl group which may contain a heteroatom, any two of R^{L6}, R^{L7} and R^{L8} may bond together to form a ring with the carbon atom to which they are attached,
      the broken line designates a point of attachment to the oxygen atom in formula (A2).
5. The resist composition of any one of 1 to 4 wherein the base polymer further comprises repeat units of at least one type selected from repeat units having the formula (A3), repeat units having the formula (A4), and repeat units having the formula (A5): 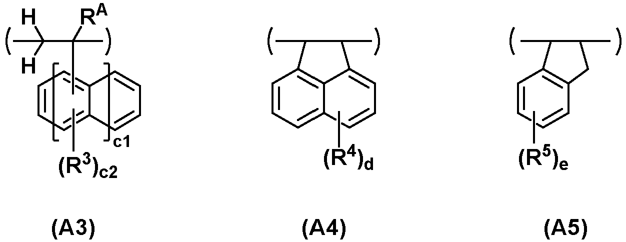 wherein c1 is 0 or 1, c2 is 0, 1, 2, 3, 4 or 5, d is 0, 1, 2, 3, 4, 5 or 6, e is 0, 1, 2, 3 or 4,
   R^{A} is hydrogen, fluorine, methyl or trifluoromethyl,
   R³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, or cyano, R³ may also be hydroxy when c1=1,
   R⁴ and R⁵ are each independently hydroxy, halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group.
6. The resist composition of any one of 1 to 5 wherein the photoacid generator has the formula (B1): 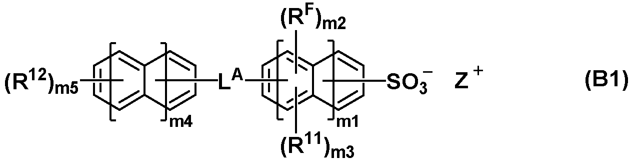 wherein m1 to m5, R¹¹, R¹², R^{F}, L^{A} and Z⁺ are as defined above.
7. The resist composition of any one of 1 to 6 wherein Z⁺ is a sulfonium cation having the formula (cation-1) or iodonium cation having the formula (cation-2): 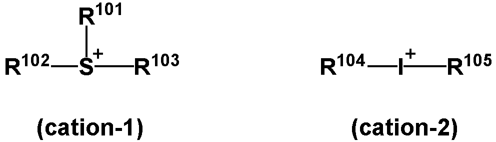 wherein R¹⁰¹ to R¹⁰⁵ are each independently halogen or a C₁-C₃₀ hydrocarbyl group which may contain a heteroatom, and R¹⁰¹ and R¹⁰² may bond together to form a ring with the sulfur atom to which they are attached.
8. The resist composition of any one of 1 to 7, further comprising (D) a quencher.
9. The resist composition of any one of 1 to 8, further comprising a fluorinated polymer comprising repeat units of at least one type selected from repeat units having the formula (E1), repeat units having the formula (E2), repeat units having the formula (E3), and repeat units having the formula (E4): 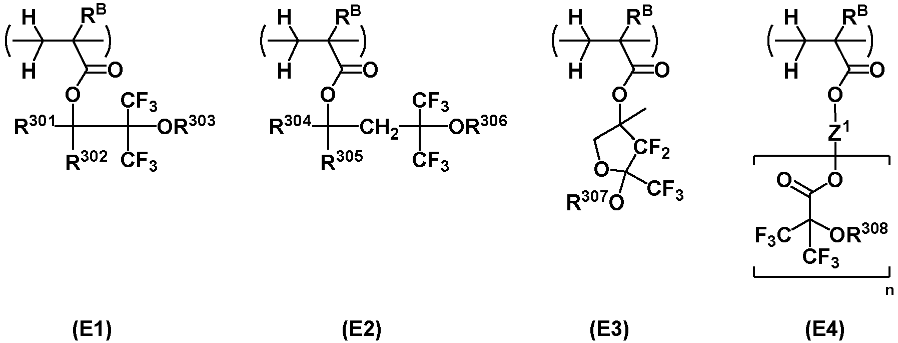 wherein R^{B} is each independently hydrogen, fluorine, methyl or trifluoromethyl,
   R³⁰¹, R³⁰², R³⁰⁴ and R³⁰⁵ are each independently hydrogen or a C₁-C₁₀ saturated hydrocarbyl group,
   R³⁰³, R³⁰⁶, R³⁰⁷ and R³⁰⁸ are each independently hydrogen, a C₁-C₁₅ hydrocarbyl group, C₁-C₁₅ fluorinated hydrocarbyl group, or acid labile group, and when R³⁰³, R³⁰⁶, R³⁰⁷ and R³⁰⁸ each are a hydrocarbyl or fluorinated hydrocarbyl group, an ether bond or carbonyl moiety may intervene in a carbon-carbon bond,
   n is 1, 2 or 3, and
   Z¹ is a C₁-C₂₀ (n+1)-valent hydrocarbon group or C₁-C₂₀ (n+1)-valent fluorinated hydrocarbon group.
10. The resist composition of 9 wherein the fluorinated polymer further comprises repeat units of at least one type selected from repeat units having the formula (E5) and repeat units having the formula (E6): 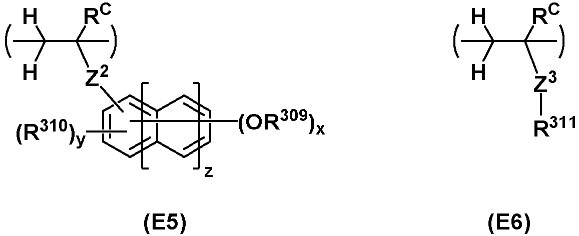 wherein R^{C} is each independently hydrogen or methyl,
   R³⁰⁹ is hydrogen or a C₁-C₅ straight or branched hydrocarbyl group in which a heteroatom-containing moiety may intervene in a carbon-carbon bond,
   R³¹⁰ is a C₁-C₅ straight or branched hydrocarbyl group in which a heteroatom-containing moiety may intervene in a carbon-carbon bond,
   R³¹¹ is a C₁-C₂₀ saturated hydrocarbyl group in which at least one hydrogen is substituted by fluorine, and in which some constituent -CH₂- may be replaced by an ester bond or ether bond,
   x is 1, 2 or 3, y is an integer satisfying 0 ≤ y ≤ 5+2z-x, z is 0 or 1,
   Z² is a single bond, *-C(=O)-O- or *-C(=O)-NH-,
   Z³ is a single bond, -O-, *-C(=O)=O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and
   * designates a point of attachment to the carbon atom in the backbone.
11. A resist pattern forming process comprising the steps of:
   applying the chemically amplified positive resist composition of any one of 1 to 10 onto a substrate to form a resist film thereon,
   exposing the resist film patternwise to high-energy radiation, and
   developing the exposed resist film in an alkaline developer.
12. The process of 11 wherein the high-energy radiation is KrF excimer laser, ArF excimer laser, EUV or EB.
13. The process of 11 or 12 wherein the substrate has the outermost surface of a material containing at least one element selected from chromium, silicon, tantalum, molybdenum, cobalt, nickel, tungsten, and tin.
14. The process of any one of 11 to 13 wherein the substrate is a mask blank of transmission or reflection type.
15. A mask blank of transmission or reflection type which is coated with the chemically amplified positive resist composition of any one of 1 to 10.

### ADVANTAGEOUS EFFECTS OF INVENTION

The chemically amplified positive resist composition can be processed by lithography to form a resist pattern of good profile with a high resolution, reduced LER, and improved rectangularity while controlling the influence of residue defects. It is thus suited as a resist composition for forming a resist film which is sensitive to EB and useful in the processing of semiconductor substrates and photomask blanks. The pattern forming process using the resist composition can form a resist pattern with a high resolution, reduced LER, etch resistance, and minimized influence of residue defects and is thus best suited in the micropatterning technology, typically EUV or EB lithography.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. In chemical formulae, Me stands for methyl, Ac stands for acetyl, and the broken line (---) or asterisk (*) designates a valence bond or point of attachment. As used herein, the term "halogenated" refers to a halogen-substituted or halogen-containing compound or group. The terms "group" and "moiety" are interchangeable.

The abbreviations and acronyms have the following meaning.
- EB:: electron beam
- EUV:: extreme ultraviolet
- Mw:: weight average molecular weight
- Mn:: number average molecular weight
- Mw/Mn:: molecular weight distribution or dispersity
- GPC:: gel permeation chromatography
- PEB:: post-exposure bake
- PAG:: photoacid generator
- LER:: line edge roughness
- CDU:: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Chemically amplified positive resist composition

One embodiment of the invention is a chemically amplified positive resist composition comprising (A) a base polymer comprising repeat units derived from hydroxystyrene or hydroxynaphthalene, and repeat units derived from hydroxystyrene having a hydroxy group protected with an acid labile group or hydroxynaphthalene having a hydroxy group protected with an acid labile group, and adapted to increase its solubility in alkaline aqueous solution under the action of acid, (B) a photoacid generator, and (C) an organic solvent.

### (A) Base polymer

The base polymer is adapted to generate an aromatic hydroxy group with the progress of deprotection reaction under the catalysis of an acid. The aromatic hydroxy group having a higher acidity than an aliphatic hydroxy group ensures that when a resist film of a positive resist composition comprising the base polymer is developed in an alkaline developer, the dissolution contrast between exposed and unexposed regions is enhanced. Then a satisfactory resolution is available.

The repeat units derived from hydroxystyrene or hydroxynaphthalene preferably have the formula (A1). The units are also referred to as repeat units A1, hereinafter.

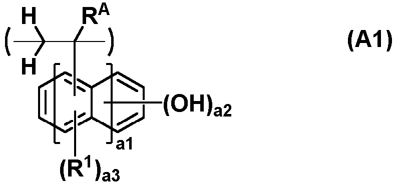

In formula (A1), a1 is 0 or 1. The relevant structure represents a benzene ring when a1=0 and a naphthalene ring when a1=1. The subscript a2 is 1, 2 or 3, and a3 is 0, 1, 2, 3 or 4. The subscripts a1 to a3 are in the range: 1 ≤ a2+a3 ≤ 4 when a1=0 and 1 ≤ a2+a3 ≤ 6 when a1=1.

In formula (A1), R^{A} is hydrogen, fluorine, methyl or trifluoromethyl. Of these, hydrogen or methyl is preferred, with hydrogen being most preferred from the aspect of polymerization.

In formula (A1), R¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. Suitable halogen atoms include fluorine, chlorine, bromine and iodine. The saturated hydrocarbyl group and saturated hydrocarbyl moiety in the saturated hydrocarbyloxy and saturated hydrocarbylcarbonyloxy groups may be straight, branched or cyclic. Examples thereof include alkyl groups such as methyl, ethyl, n-propyl, isopropyl, butyl, pentyl, hexyl, and structural isomers thereof; cycloalkyl groups such as cyclopropyl, cyclobutyl, cyclopentyl and cyclohexyl; and combinations thereof. A carbon count within the upper limit ensures a satisfactory solubility in alkaline developer. When a3 is 2 or more, a plurality of R¹ may be identical or different.

Preferred examples of repeat units A1 are shown below, but not limited thereto. Herein R^{A} is as defined above.

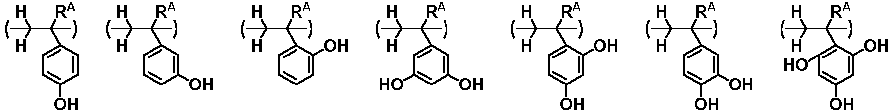

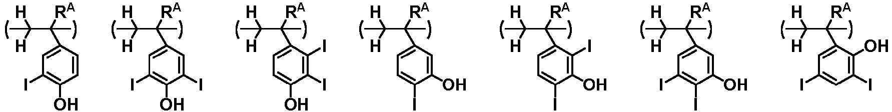

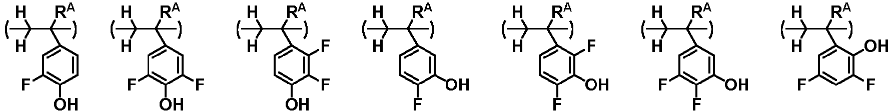

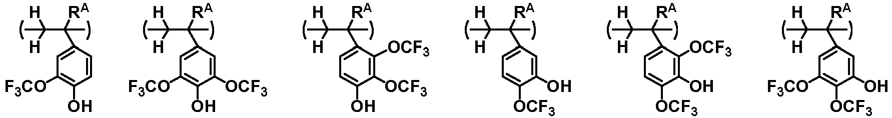

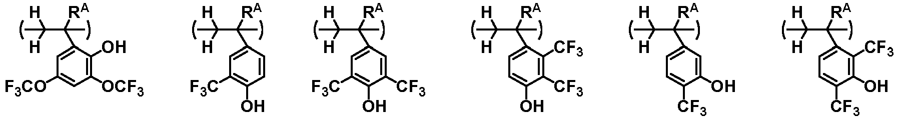

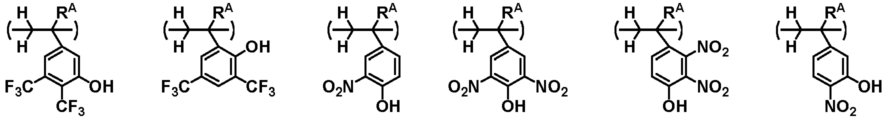

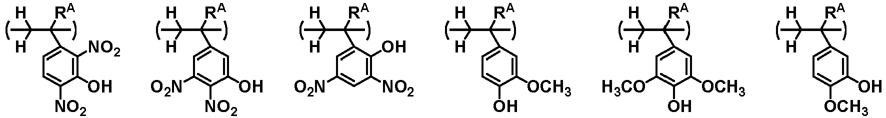

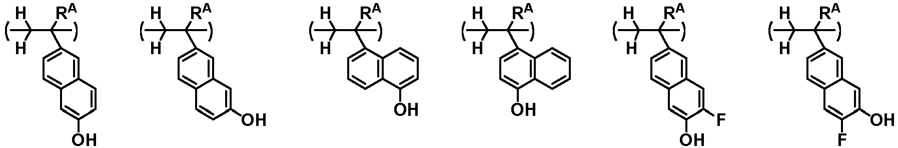

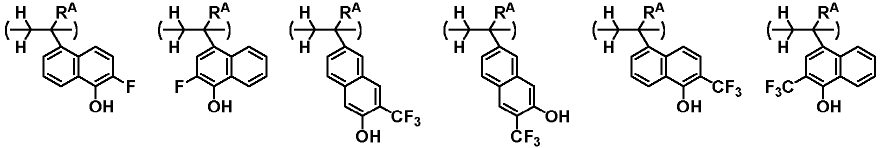

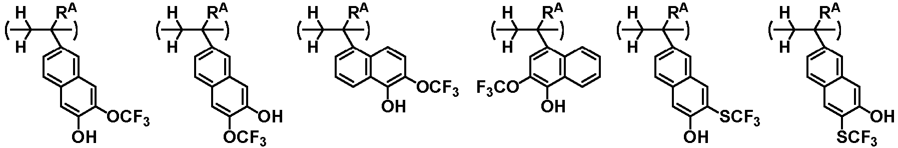

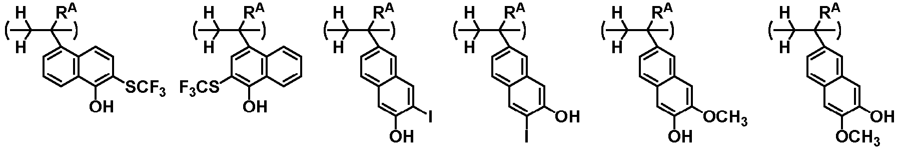

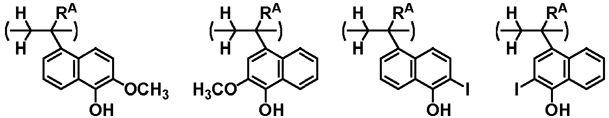

The content of repeat units A1 is preferably 40 to 90 mol%, more preferably 40 to 85 mol%, even more preferably 40 to 80 mol% of the overall units of the base polymer. The repeat units A1 may be of one type or a combination of plural types.

The repeat units derived from hydroxystyrene having a hydroxy group protected with an acid labile group or hydroxynaphthalene having a hydroxy group protected with an acid labile group preferably have the formula (A2). The units are also referred to as repeat units A2, hereinafter.

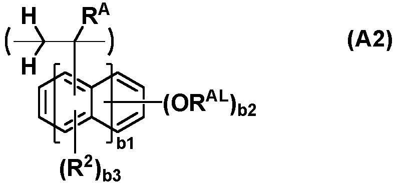

In formula (A2), b1 is 0 or 1, b2 is 1, 2 or 3, and b3 is 0, 1, 2, 3 or 4. The subscripts b1 to b3 are in the range: 1 ≤ b2+b3 ≤ 4 when b1=0 and 1 ≤ b2+b3 ≤ 6 when b1=1.

In formula (A2), R^{A} is hydrogen, fluorine, methyl or trifluoromethyl. Of these, hydrogen or methyl is preferred, with hydrogen being most preferred from the aspect of polymerization.

In formula (A2), R² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. Suitable halogen atoms include fluorine, chlorine, bromine and iodine. The saturated hydrocarbyl group and saturated hydrocarbyl moiety in the saturated hydrocarbyloxy and saturated hydrocarbylcarbonyloxy groups may be straight, branched or cyclic. Examples thereof include alkyl groups such as methyl, ethyl, n-propyl, isopropyl, butyl, pentyl, hexyl, and structural isomers thereof; cycloalkyl groups such as cyclopropyl, cyclobutyl, cyclopentyl and cyclohexyl; and combinations thereof. A carbon count within the upper limit ensures a satisfactory solubility in alkaline developer. When b3 is 2 or more, a plurality of R² may be identical or different.

In formula (A2), when b2=1, R^{AL} is an acid labile group. When b2=2 or 3, R^{AL} is hydrogen or an acid labile group, at least one thereof being an acid labile group.

Typically the acid labile group has any one of the formulae (AL-1) to (AL-3).

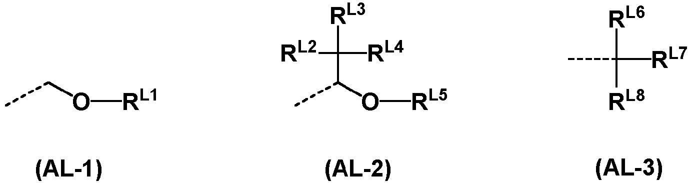

The group of formula (AL-1) or (AL-2) forms an acetal structure with the oxygen atom originating from the aromatic hydroxy group in repeat unit A2 so that it may be utilized as an acid labile group. It is a useful choice as the acid labile group that ensures to form a pattern defining a relatively rectangular interface with the substrate.

**In** formula (AL-1), R^{L1} is a C₁-C₂₀ hydrocarbyl group which may contain a heteroatom. **In** formula (AL-2), R^{L2}, R^{L3} and R^{L4} are each independently hydrogen or a C₁-C₂₀ hydrocarbyl group which may contain a heteroatom. R^{L5} is a C₁-C₂₀ hydrocarbyl group which may contain a heteroatom.

The hydrocarbyl group represented by R^{L1} to R^{L5} may be saturated or unsaturated and straight, branched or cyclic. Examples thereof include, but are not limited to, C₁-C₂₀ alkyl groups such as methyl, ethyl, n-propyl, isopropyl, n-butyl, and tert-butyl; C₃-C₂₀ cyclic saturated hydrocarbyl groups such as cyclopropyl, cyclopentyl, cyclohexyl, and cyclopropylmethyl; C₂-C₂₀ alkenyl groups such as vinyl, 1-propenyl, 2-propenyl, butenyl, and hexenyl; C₃-C₂₀ cyclic unsaturated hydrocarbyl groups such as cyclohexenyl; and C₆-C₂₀ aryl groups such as phenyl and naphthyl.

Any two or three of R^{L2}, R^{L3} and R^{L4} may bond together to form a ring with the carbon atom to which they are attached. Examples of the ring include cyclopropane, cyclobutane, cyclopentane, cyclohexane, norbornane, adamantane, benzene and naphthalene rings, but are not limited thereto.

Any one of R^{L2}, R^{L3} and R^{L4} and R^{L5} may bond together to form a ring with the carbon and oxygen atoms to which they are attached. Exemplary rings are tetrahydrofuran and tetrahydropyran rings, but not limited thereto.

From the groups of formulae (AL-1) and (AL-2), a proper one is selected in accordance with how to design the sensitivity of the labile group to acid. For example, a methylene acetal structure corresponding to a group of formula (AL-1) wherein hydrogen is substituted is selected for the design that the group having a relatively high stability is decomposed with a strong acid. A group of formula (AL-2) wherein -C(R^{L2})(R^{L3})(R^{L4}) is a straight alkyl group is selected for the design that utilizes a relatively high reactivity to provide a high sensitivity relative to pH changes. Depending on a combination with an acid generator and a quencher blended in a resist composition, a relatively large hydrocarbyl group is preferably selected as R^{L5} for the design that is substituted at an end with a relatively higher alkyl group, and a combination of R^{L2}, R^{L3} and R^{L4} wherein any one is hydrogen and the carbon atom attached to the acetal carbon is a secondary carbon atom is selected for the design that experiences a large solubility change upon decomposition. Examples of the group -C(R^{L2})(R^{L3})(R^{L4}) attached to the acetal carbon via a secondary carbon atom include isopropyl, sec-butyl, cyclopentyl and cyclohexyl.

Of the acetal groups, those groups wherein R^{L1} or R^{L5} is a C₇-C₃₀ polycyclic saturated hydrocarbyl group are preferred in order to gain a higher resolution. When R^{L1} or R^{L5} is a polycyclic saturated hydrocarbyl group, it is preferred that the secondary carbon in the polycyclic structure form a bond with the acetal oxygen. A polymer relying on an attachment on the secondary carbon atom in the cyclic structure is stable as compared with an attachment on the tertiary carbon atom, ensuring that the resist composition is improved in shelf stability and not degraded in resolution. The polymer has a high glass transition temperature (Tg) as compared with the case wherein R^{L1} or R^{L5} is attached on the primary carbon atom via a straight alkyl group of at least one carbon atom, so that the resist pattern after development may not undergo geometrical failure during bake.

Preferred examples of the acid labile group having formula (AL-1) or (AL-2) are shown below, but not limited thereto. The asterisk (*) designates a point of attachment to the adjacent oxygen atom.

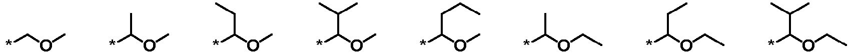

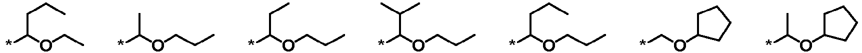

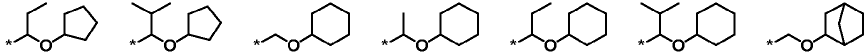

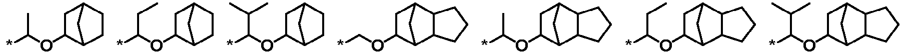

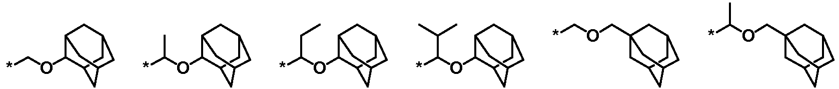

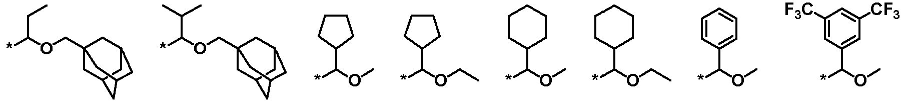

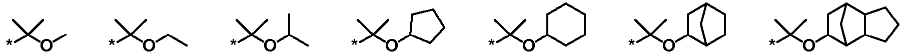

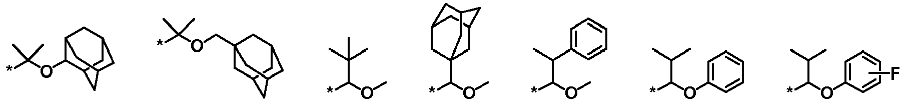

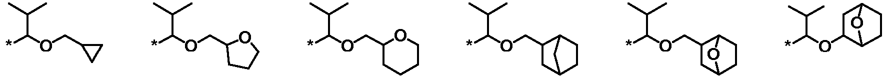

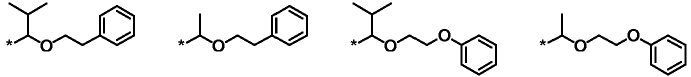

Since the acetal acid labile group is also effective for suppressing the influence of back scattering during EB image writing, the corresponding resist composition avoids the pattern profile from being inversely tapered in a sensitivity region of at least 50 µC/cm², preferably at least 80 µC/cm², more preferably at least 100 µC/cm² and displays excellent rectangular performance.

The group of formula (AL-3) is a tertiary hydrocarbyl group, which forms a tertiary ether structure with the oxygen atom originating from the aromatic hydroxy group in repeat unit A2, which is utilized as an acid labile group. A base polymer having a group of formula (AL-3) is preferred, because a pattern with reduced LER is obtained even when a resist film is formed to a thickness of 10 to 100 nm and exposed to a small size pattern of light so as to provide a line width of 45 nm or less. The tertiary hydrocarbyl group is preferably of 4 to 18 carbon atoms because a monomer for polymerization is collectable through distillation. The group attached to the tertiary carbon atom in the tertiary hydrocarbyl group is typically a C₁-C₁₅ saturated hydrocarbyl group which may contain an oxygen-containing functional group such as an ether bond or carbonyl group while the groups attached to the tertiary carbon atom may bond together to form a ring.

In formula (AL-3), R^{L6}, R^{L7} and R^{L8} are each independently a C₁-C₂₀ hydrocarbyl group which may contain a heteroatom. The hydrocarbyl group may be saturated or unsaturated and straight, branched or cyclic. Examples thereof are as exemplified above for the hydrocarbyl group R^{L1} to R^{L5}. Any two of R^{L6}, R^{L7} and R^{L8} may bond together to form a ring with the carbon atom to which they are attached.

Preferred examples of the acid labile group having formula (AL-3) are shown below, but not limited thereto. The asterisk (*) designates a point of attachment to the adjacent oxygen atom.

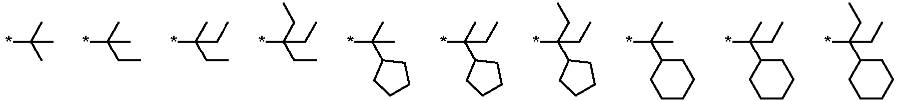

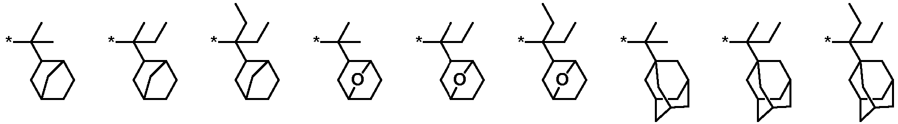

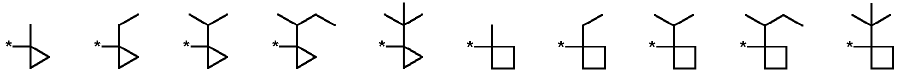

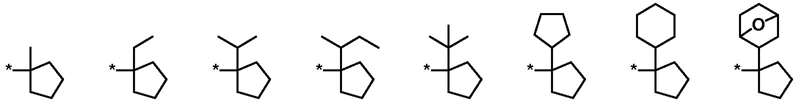

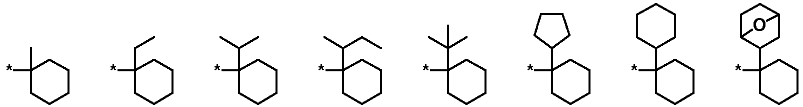

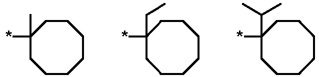

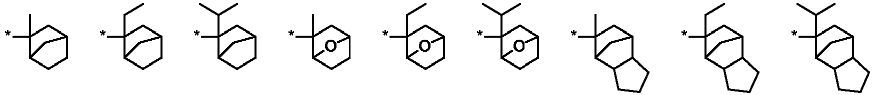

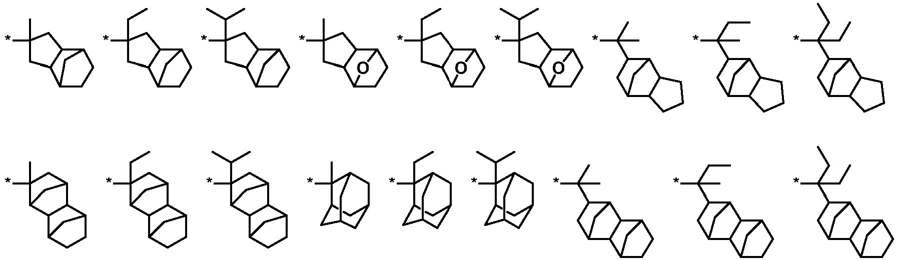

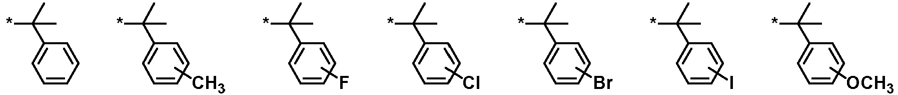

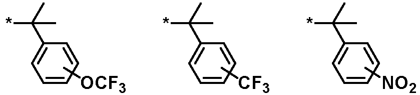

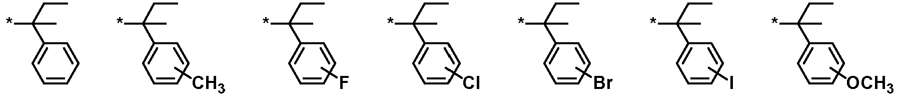

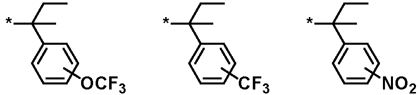

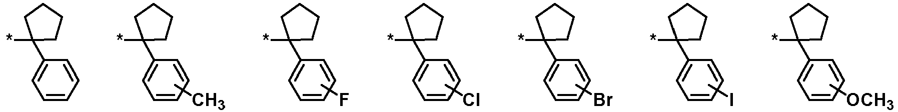

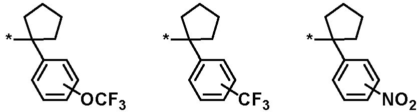

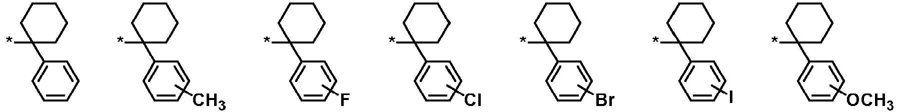

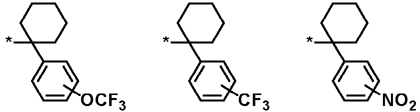

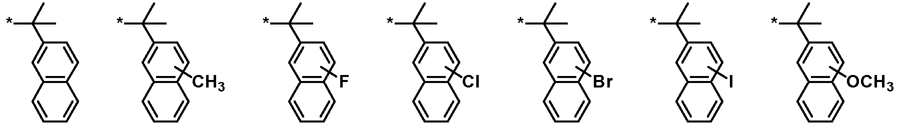

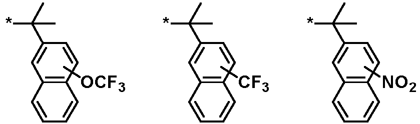

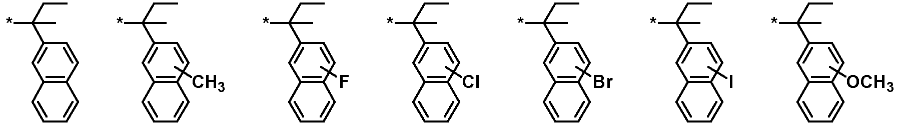

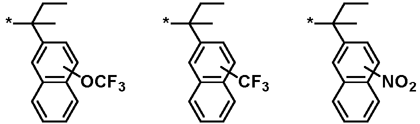

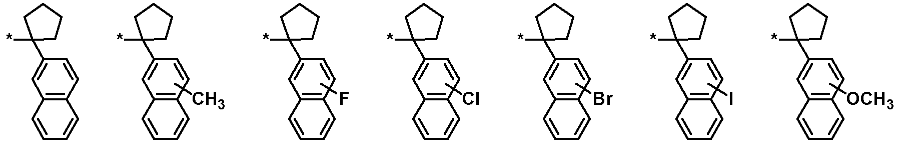

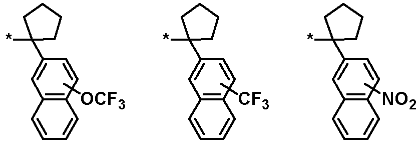

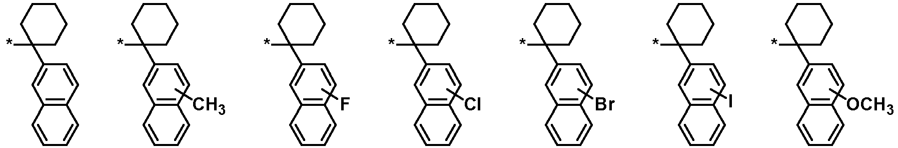

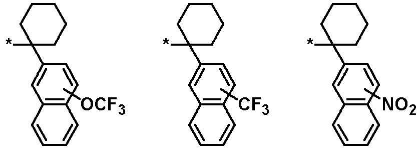

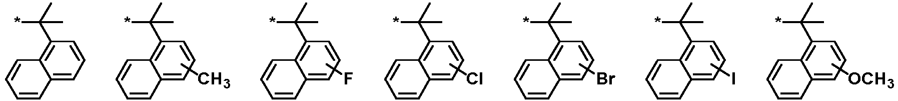

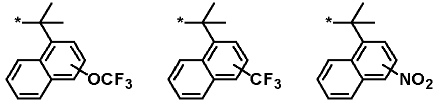

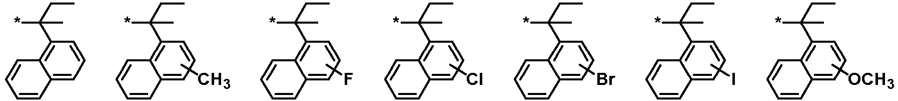

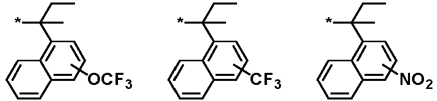

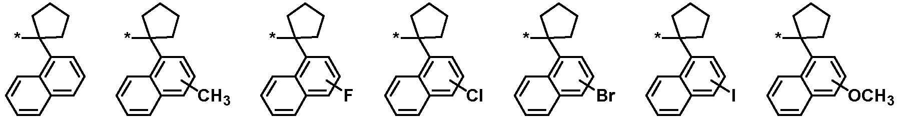

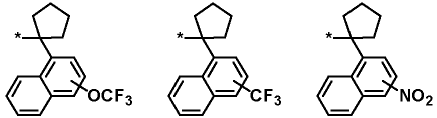

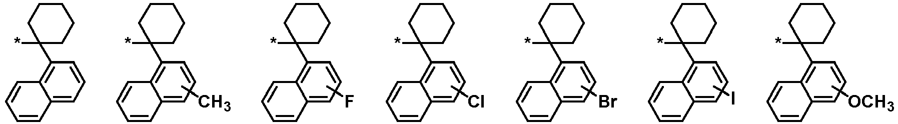

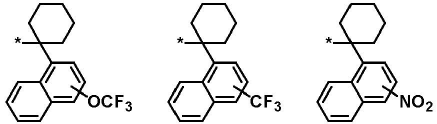

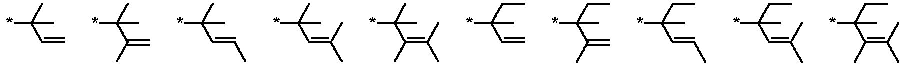

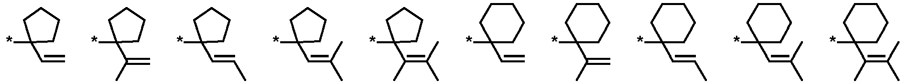

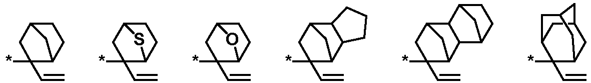

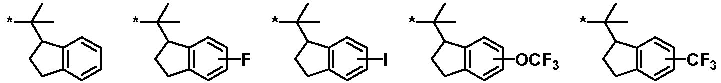

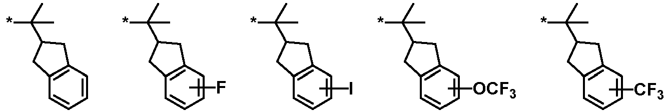

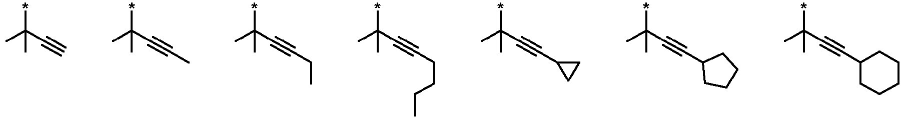

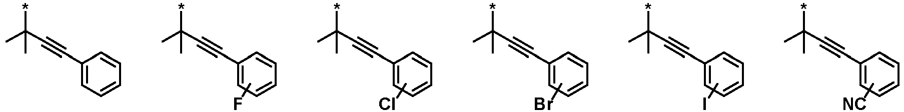

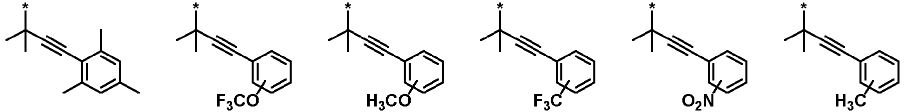

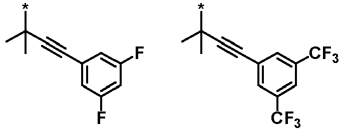

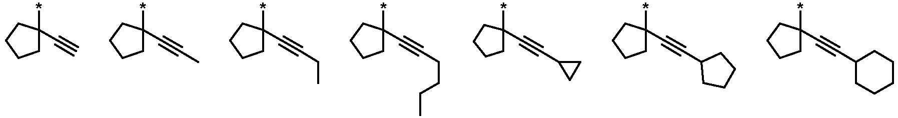

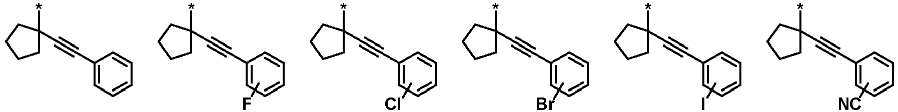

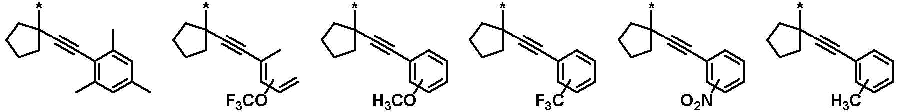

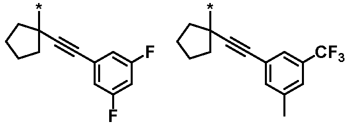

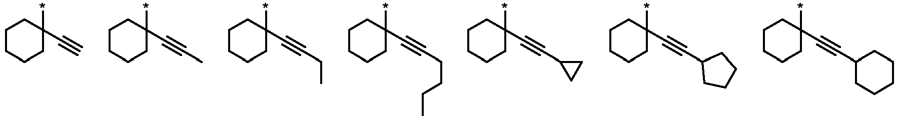

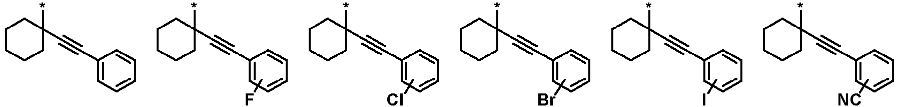

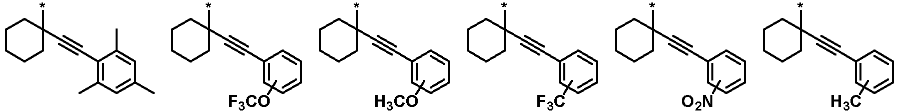

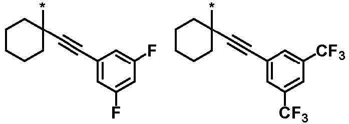

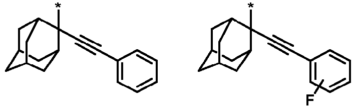

Another acid labile group which can be used herein is a phenolic hydroxy group whose hydrogen is substituted by -O(C=O)O-(tertiary saturated hydrocarbyl group). The tertiary saturated hydrocarbyl group may be the same as the foregoing tertiary saturated hydrocarbyl group used for the protection of a phenolic hydroxy group.

The content of repeat units A2 is preferably 10 to 40 mol%, more preferably 10 to 35 mol%, even more preferably 20 to 30 mol% of the overall units of the base polymer. The repeat units A2 may be of one type or a combination of plural types.

**In** a preferred embodiment, the base polymer further comprises repeat units of at least one type selected from repeat units having the formula (A3), repeat units having the formula (A4), and repeat units having the formula (A5). These units are also referred to as repeat units A3, A4 and A5.

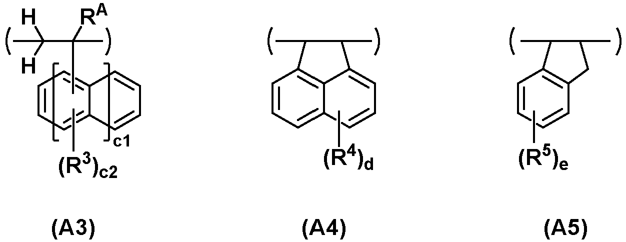

In formula (A3), c1 is 0 or 1. The relevant structure represents a benzene ring when c1=0 and a naphthalene ring when c1=1. The subscript c2 is 0, 1, 2, 3, 4 or 5. When c1=0, c2 is preferably 0, 1, 2 or 3. When c1=1, c2 is preferably 0, 1, 2, 3 or 4.

In formula (A3), R^{A} is hydrogen, fluorine, methyl or trifluoromethyl.

In formula (A3), R³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, or cyano. R³ may also be hydroxy when c1=1. The saturated hydrocarbyl group, saturated hydrocarbyloxy group, saturated hydrocarbylcarbonyloxy group, saturated hydrocarbyloxyhydrocarbyl group, and saturated hydrocarbylthiohydrocarbyl group may be straight, branched or cyclic. When c2 is 2 or more, a plurality of R³ may be identical or different.

In formulae (A4) and (A5), d is 0, 1, 2, 3, 4, 5 or 6, and e is 0, 1, 2, 3 or 4.

In formulae (A4) and (A5), R⁴ and R⁵ are each independently hydroxy, halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group, saturated hydrocarbyloxy group, and saturated hydrocarbylcarbonyloxy group may be straight, branched or cyclic. When d is 2 or more, a plurality of R⁴ may be identical or different. When e is 2 or more, a plurality of R⁵ may be identical or different.

When repeat units of at least one type selected from repeat units A3 to A5 are used as constituent units of the base polymer, better performance is obtained because not only the aromatic ring possesses etch resistance, but the cyclic structure incorporated into the backbone also exerts the effect of improving etch resistance and resistance to EB irradiation during pattern inspection step.

The content of repeat units A3 to A5 is preferably at least 5 mol% based on the overall repeat units of the polymer for obtaining the effect of improving etch resistance. Also, the content of repeat units A3 to A5 is preferably up to 25 mol%, more preferably up to 20 mol% based on the overall repeat units of the polymer. When the relevant units are free of functional groups or have a functional group other than hydroxy, their content of up to 25 mol% is preferred because the risk of forming development defects is eliminated. Each of the repeat units A3 to A5 may be of one type or a combination of plural types.

The base polymer is designed such that the dissolution rate in alkaline developer is preferably up to 10 nm/min, more preferably up to 7 nm/min, even more preferably up to 5 nm/min. In the advanced generation of lithography wherein the coating film on the substrate is in a thin film range of up to 100 nm, the influence of pattern film thickness loss during alkaline development becomes strong. When the polymer has an alkaline dissolution rate of greater than 10 nm/min, pattern collapse occurs, i.e., a small size pattern cannot be formed. The problem becomes outstanding in the fabrication of photomasks requiring to be defectless and having a tendency of strong development process. It is noted that the dissolution rate of a base polymer in alkaline developer is computed by spin coating a 16.7 wt% solution of a polymer in propylene glycol monomethyl ether acetate (PGMEA) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness.

The base polymer may be synthesized by copolymerizing monomers providing the desired repeat units in the standard way. The monomer which is protected with a protective group may be used. In this case, polymerization is followed by deprotection reaction, yielding the desired polymer.

The base polymer may also be synthesized by copolymerizing a monomer mixture which contains a monomer providing repeat unit A1, but not a monomer providing repeat unit A2, and protecting the aromatic hydroxy group on the resulting polymer with an acetal group. For this synthesis, a method using a vinyl ether and an acid catalyst and a method using an acetalizing agent having a haloalkoxy group and a base are known. Either of these methods may be utilized.

For example, in the former method using an acetal modifier having a vinyl ether structure and an acid catalyst, examples of the acid catalyst include hydrochloric acid, sulfuric acid, nitric acid, methanesulfonic acid, p-toluenesulfonic acid, trifluoromethanesulfonic acid, trifluoroacetic acid, oxalic acid, and methanesulfonic acid pyridine salt. The reaction temperature is preferably 5 to 30°C. The reaction time is preferably 0.2 to 10 hours, more preferably 0.5 to 6 hours.

In the latter method using an acetal modifier having a haloalkoxy group and a base, the acetalizing agent having a haloalkoxy group is added dropwise in the presence of a basic compound such as triethylamine, diisopropylethylamine, pyridine, 2,6-lutidine, sodium hydroxide, potassium hydroxide, lithium hydroxide, sodium carbonate, potassium carbonate, or cesium carbonate. The reaction temperature is preferably -20°C to 50°C. The reaction time is preferably 0.2 to 10 hours, more preferably 0.5 to 6 hours.

It is noted that the latter method using an acetalizing agent having a haloalkoxy group and a base has the risk of generating a corrosive strong acid such as hydrochloric acid which can corrode metallic reactors and piping, suggesting that the polymer can be contaminated with metal impurities which cause defects to semiconductor products. Since the lithography of advanced generation requires that raw materials for use in resist compositions have a metal impurity content of less than 10 ppb, the former method using a vinyl ether and an acid catalyst is recommended.

The copolymerization reaction may be any of well-known radical, anionic and other polymerization reactions, preferably anionic polymerization. For the anionic polymerization, reference may be made to Patent Documents 6 to 8.

The base polymer should preferably have a Mw of 1,000 to 50,000, and more preferably 2,000 to 20,000. A Mw of at least 1,000 eliminates the risk that pattern features are rounded at their top to invite degradations of resolution and LER. A Mw of up to 50,000 eliminates the risk that LER is degraded when a pattern with a line width of up to 100 nm is formed. As used herein, Mw is measured by GPC versus polystyrene standards using tetrahydrofuran (THF) or dimethylformamide (DMF) solvent.

The base polymer preferably has a narrow molecular weight distribution. Specifically, the base polymer should have a dispersity (Mw/Mn) of 1.0 to 1.19, preferably 1.0 to 1.17, more preferably 1.01 to 1.15. A polymer with such a narrow dispersity eliminates the risk that foreign particles are left on the pattern after development and the pattern profile is aggravated.

The chemically amplified positive resist composition is characterized by comprising a base polymer having a dispersity (Mw/Mn) of 1.0 to 1.19. If a base polymer having a dispersity in excess of the range is used in forming a small-size pattern, the effect of polymer chains of different length in the base polymer becomes outstanding to invite development defects and pattern collapse. Since some copolymerized units have an aromatic vinyl structure and some copolymerized units have a fused ring structure of acenaphthylene or indene, the π-π stacking interaction between aromatic rings becomes active enough to provide very high etch resistance after pattern formation. Since an aromatic sulfonic acid having an aromatic ring structure is used in a photoacid generator as will be described later, a robust acid with low diffusion is generated, which is effective for restraining excessive acid diffusion and improving lithography properties. By virtue of the synergy of these effects, a satisfactory resolution is achieved in forming small-size patterns, which is advantageous especially for photomask processing of the sub-10 nm generation.

### (B) Photoacid generator

The chemically amplified positive resist composition should comprise (B) a photoacid generator (PAG). The PAG used herein is a compound capable of generating an acid upon exposure to high-energy radiation. Specifically, the PAG has the formula (B).

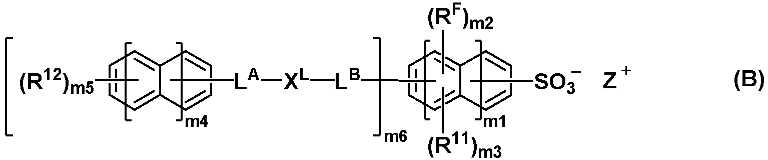

In formula (B), m1 is 0 or 1, m2 is 0, 1, 2, 3 or 4, and m3 is 0, 1, 2, 3, 4, 5 or 6. The subscripts m1 to m3 are in the range: 0 ≤ m2+m3 ≤ 4 when m1=0, and 0 ≤ m2+m3 ≤ 6 when m1=1.

In formula (B), m4 is 0 or 1. The relevant structure represents a benzene ring when m4=0 and a naphthalene ring when m4=1. The benzene ring corresponding to m4=0 is preferred from the aspect of solvent solubility. The subscript m5 is 0, 1, 2, 3 or 4 when m4=0 and m5 is 0, 1, 2, 3, 4, 5 or 6 when m4=1. The subscript m6 is 0 or 1. It is preferred from the aspects of control of acid diffusion and inhibition of dissolution in alkaline developer that m6 be 1.

In formula (B), L^{A} and L^{B} are each independently a single bond, ether bond, ester bond, sulfonate ester bond, sulfonamide bond, carbonate bond or carbamate bond, preferably a single bond, ether bond, ester bond or sulfonate ester bond. More preferably, L^{A} is an ether bond, ester bond or sulfonate ester bond and L^{B} is a single bond, ether bond or ester bond.

In formula (B), X^{L} is a single bond or a C₁-C₄₀ hydrocarbylene group which may contain a heteroatom. The hydrocarbylene group may be straight, branched or cyclic. Examples thereof include alkanediyl groups and cyclic saturated hydrocarbylene groups. Exemplary of the heteroatom are oxygen, nitrogen and sulfur.

Examples of the C₁-C₄₀ hydrocarbylene group which may contain a heteroatom, represented by X^{L}, are shown below, but not limited thereto. Herein, * designates a point of attachment to L^{A} or L^{B}.

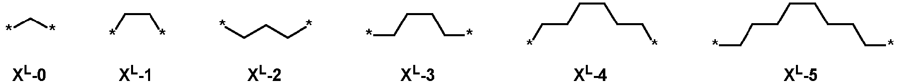

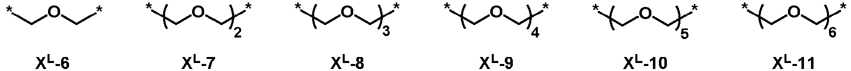

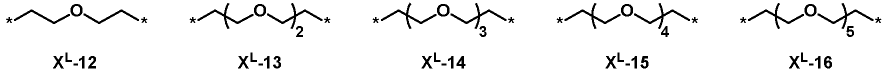

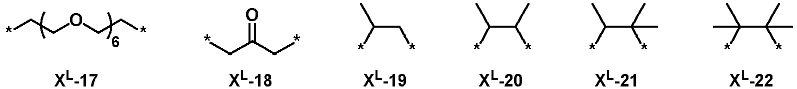

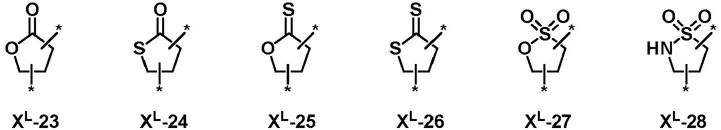

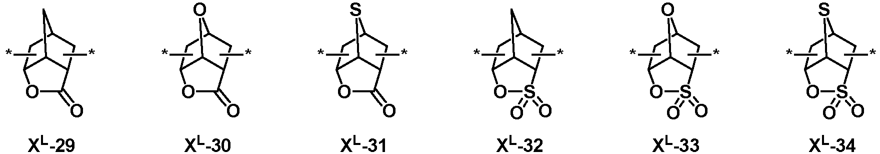

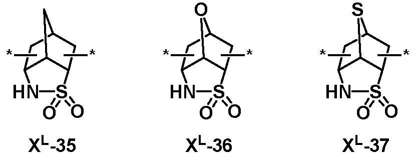

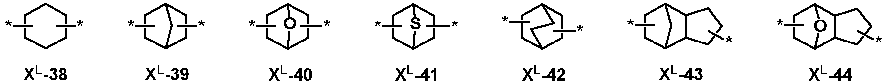

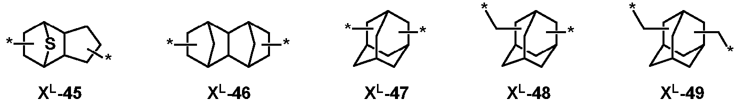

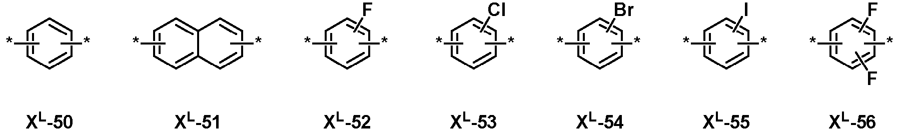

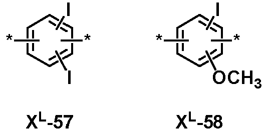

Of these, X^{L}-0 to X^{L}-22 and X^{L}-47 to X^{L}-58 are preferred.

In formula (B), R¹¹ is halogen exclusive of fluorine, hydroxy, nitro, cyano, or a C₁-C₂₀ hydrocarbyl group which may contain a heteroatom. Examples of the halogen exclusive of fluorine include chlorine, bromine and iodine. The C₁-C₂₀ hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl and icosyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₂₀ alkenyl groups such as vinyl, allyl, propenyl, butenyl and hexenyl; C₃-C₂₀ cyclic unsaturated hydrocarbyl groups such as cyclohexenyl; C₆-C₂₀ aryl groups such as phenyl and naphthyl; C₇-C₂₀ aralkyl groups such as benzyl, 1-phenylethyl and 2-phenylethyl, and combinations thereof. In the hydrocarbyl groups, some or all of the hydrogen atoms may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, fluorine, chlorine, bromine, iodine, cyano, carbonyl, ether bond, ester bond, sulfonic ester bond, carbonate bond, lactone ring, sultone ring, carboxylic anhydride (-C(=O)-O-C(=O)-) or haloalkyl moiety. When m3 is 2 or more, a plurality of R¹¹ may be identical or different.

When m3 is 2 or more, a plurality of R¹¹ may bond together to form a ring with the carbon atoms to which they are attached. The ring is preferably 5 to 8-membered.

When m3 is 2 or more, at least one of R¹¹ is preferably bonded to the carbon atom disposed adjacent to the carbon atom to which -SO₃⁻ group is attached.

In formula (B), R¹² is halogen, hydroxy, nitro, cyano, or a C₁-C₂₀ hydrocarbyl group which may contain a heteroatom. Examples of the halogen include fluorine, chlorine, bromine and iodine. The C₁-C₂₀ hydrocarbyl group may be saturated or unsaturated and straight, branched or cyclic. Examples thereof are as exemplified above for the hydrocarbyl group R¹¹.

When m5 is 2 or more, a plurality of R¹² may bond together to form a ring with the carbon atoms to which they are attached. The ring is preferably 5 to 8-membered.

When m5 is 2 or more, at least one of R¹² is preferably bonded to the carbon atom disposed adjacent to the carbon atom to which L^{A} is attached. This attachment restrains the rotation of the bond axis of the divalent linking group for linking two aromatic rings in the formula whereby acid diffusion is controlled.

In formula (B), R^{F} is fluorine, a C₁-C₆ fluorinated saturated hydrocarbyl group, C₁-C₆ fluorinated saturated hydrocarbyloxy group, or C₁-C₆ fluorinated saturated hydrocarbylthio group. Inter alia, fluorine, trifluoromethyl, trifluoromethoxy and trifluoromethylthio are preferred, with fluorine being most preferred. When m2 is 2, 3 or 4, a plurality of R^{F} may be identical or different.

Of the PAGs having formula (B), those having the formula (B1): 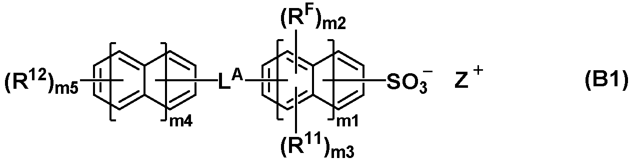 wherein m1 to m5, R¹¹, R¹², R^{F}, L^{A} and Z⁺ are as defined above are preferred.

Preferred examples of the anion in the PAG are shown below, but not limited thereto.

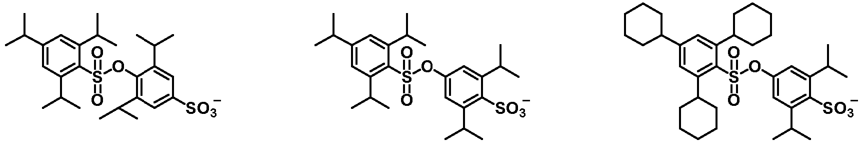

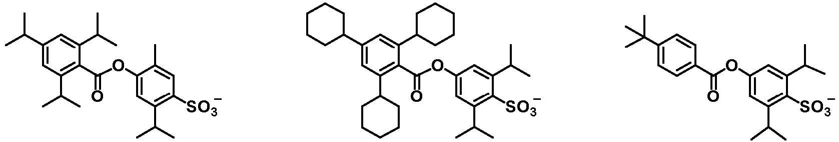

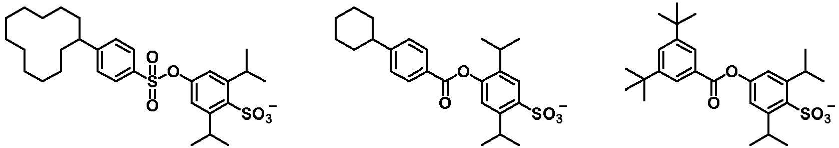

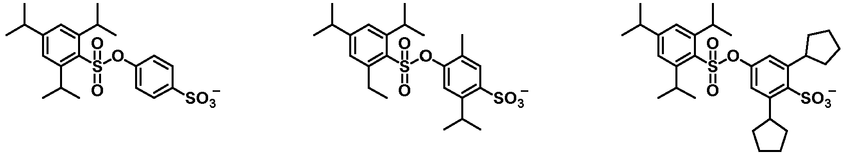

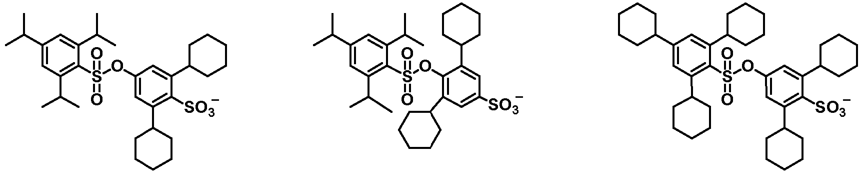

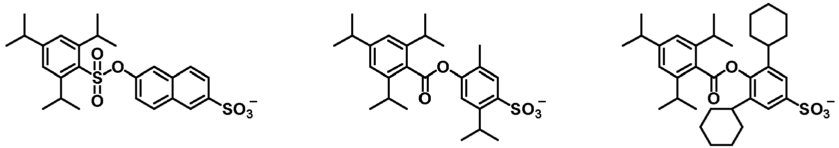

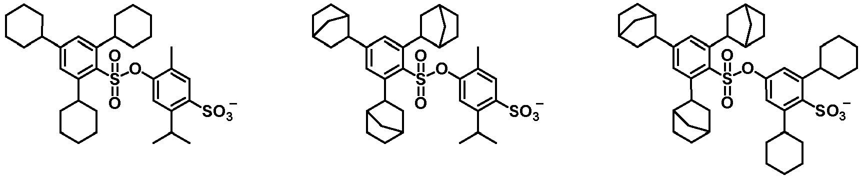

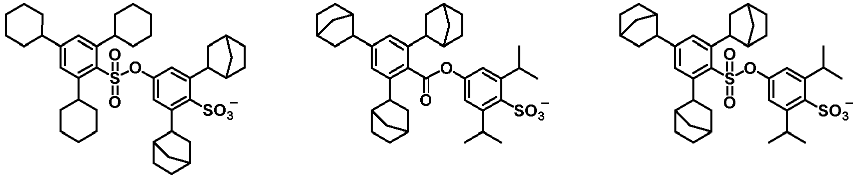

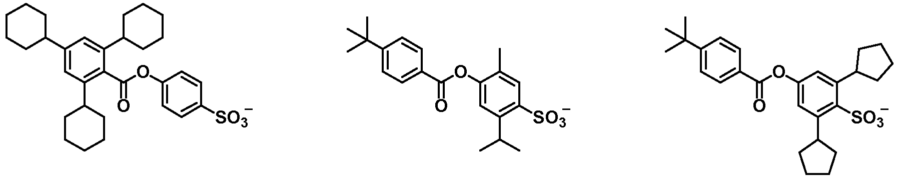

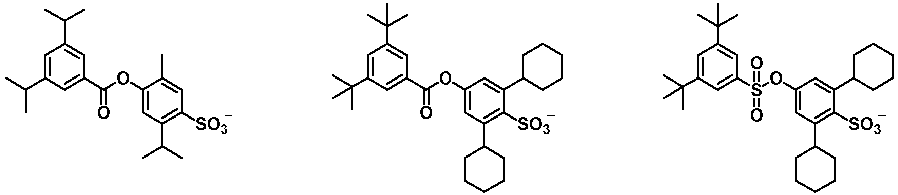

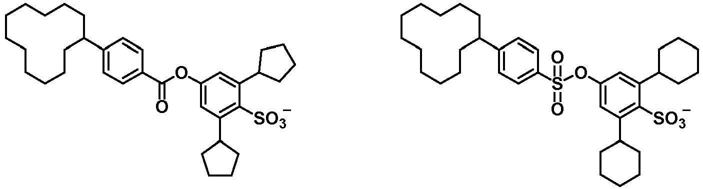

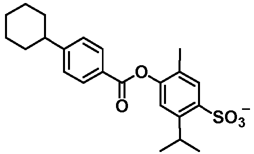

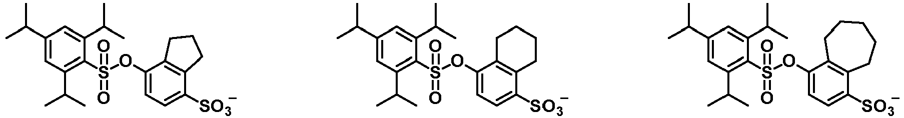

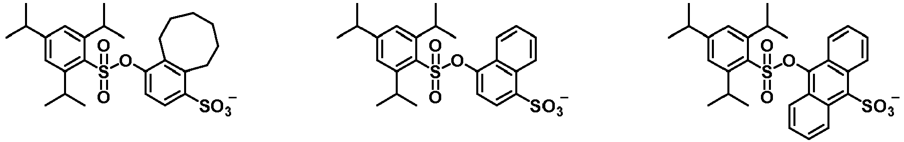

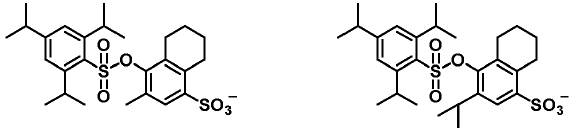

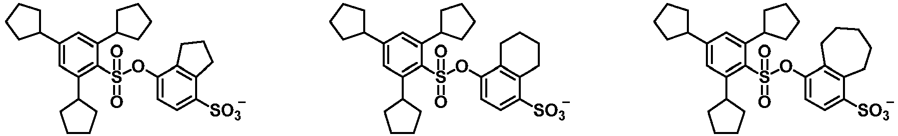

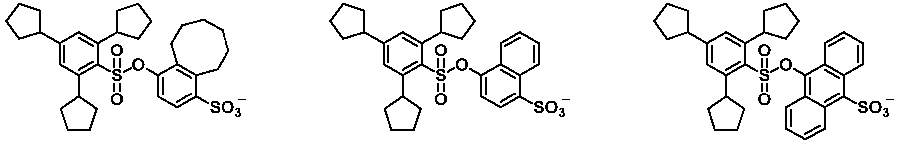

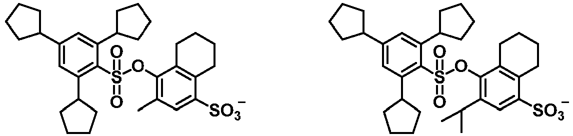

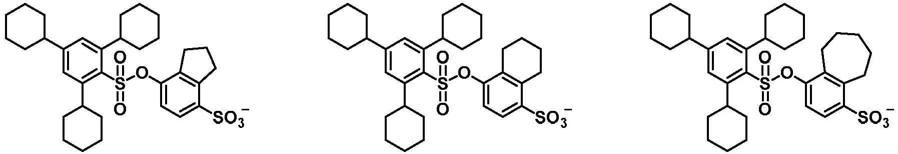

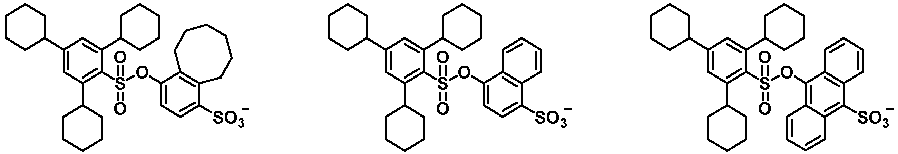

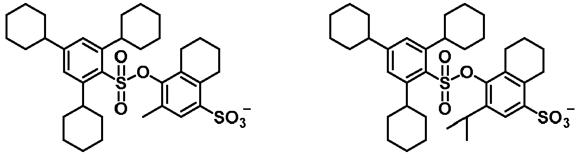

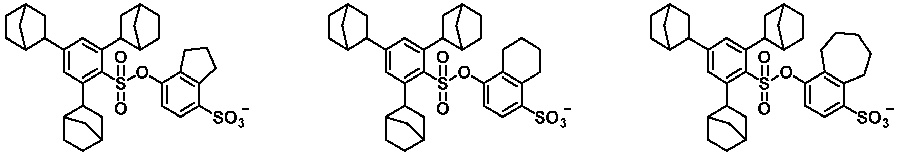

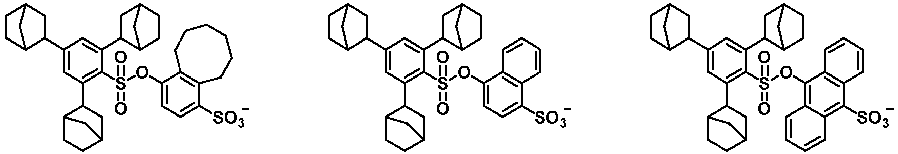

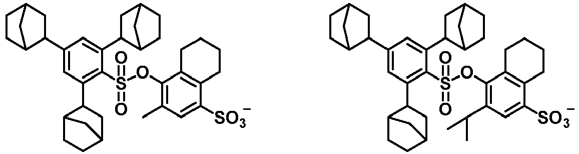

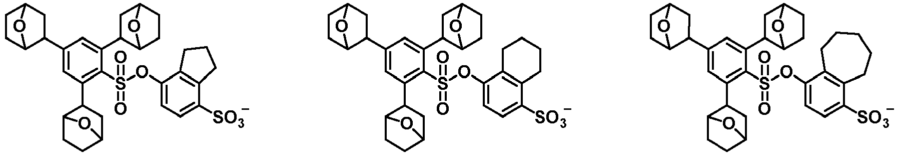

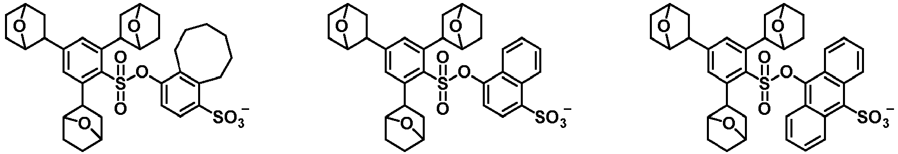

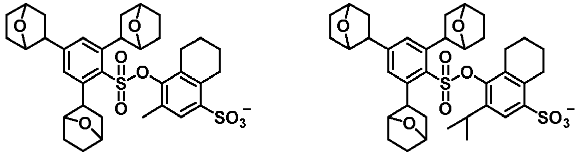

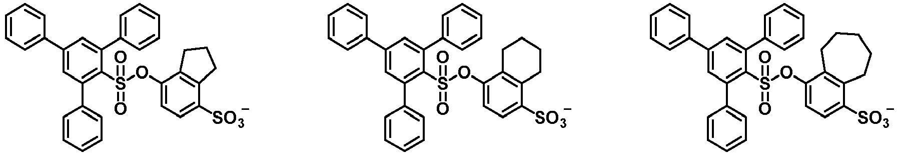

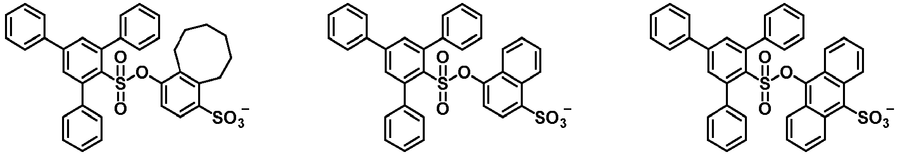

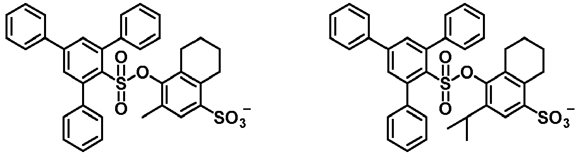

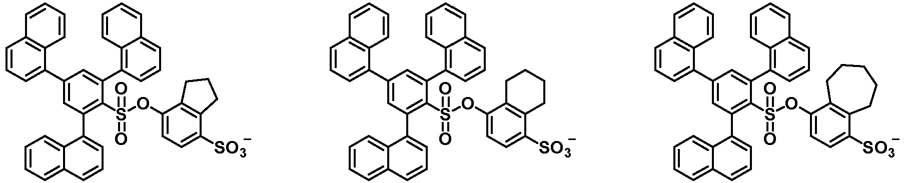

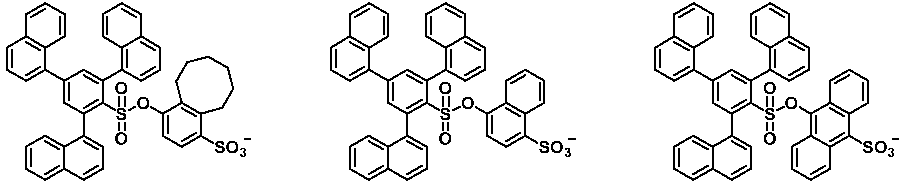

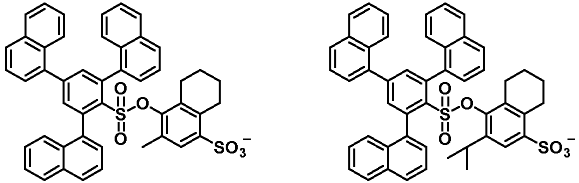

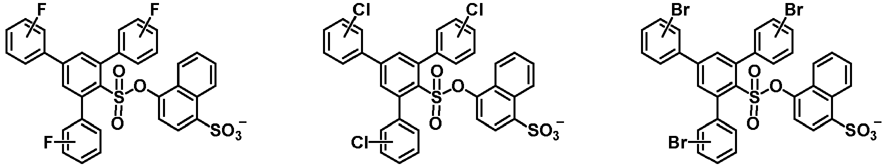

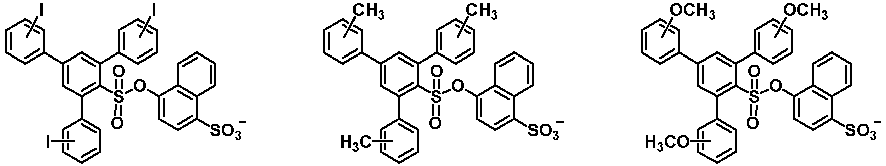

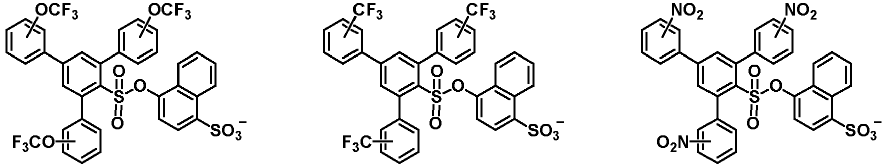

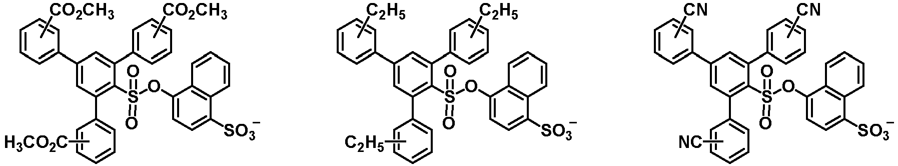

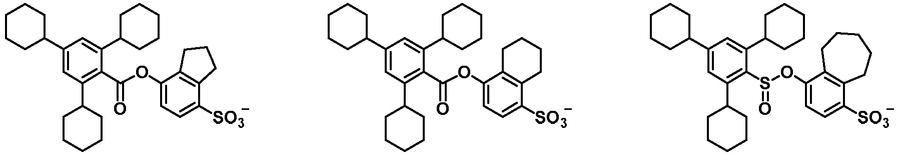

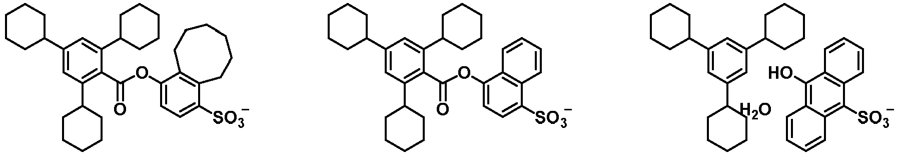

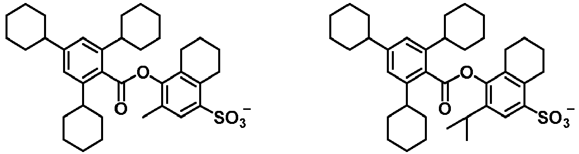

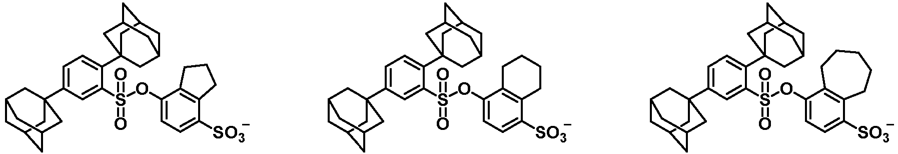

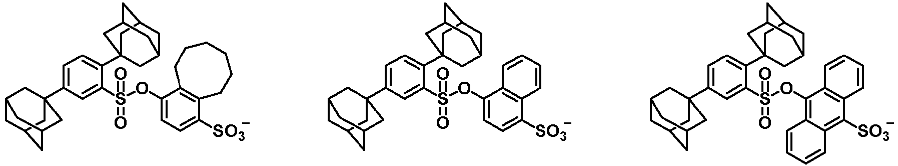

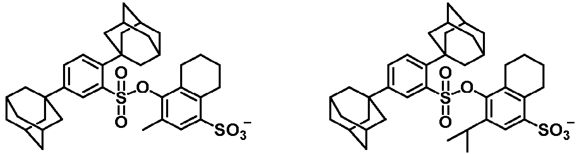

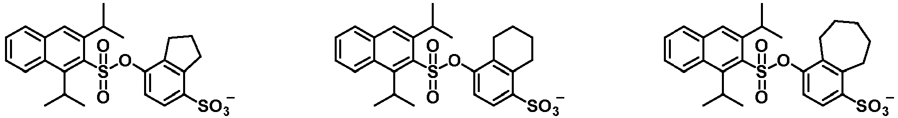

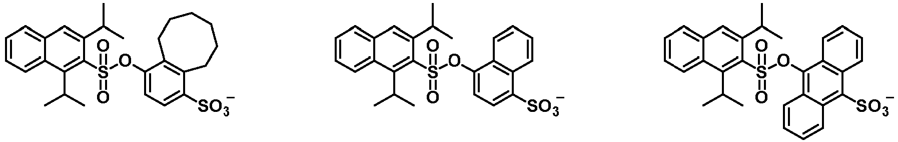

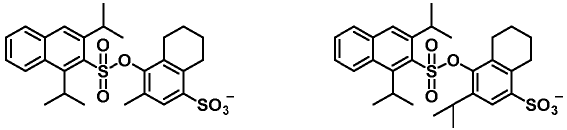

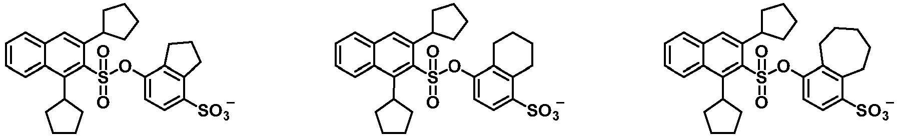

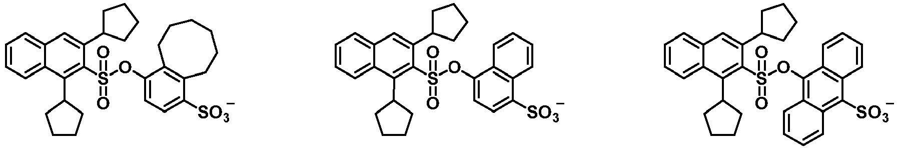

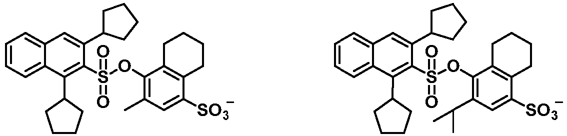

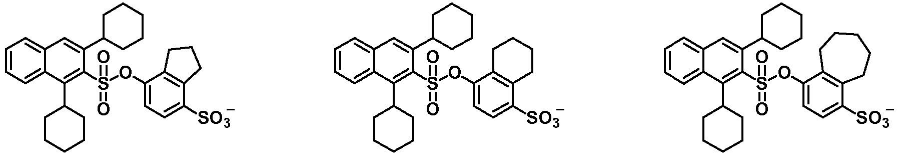

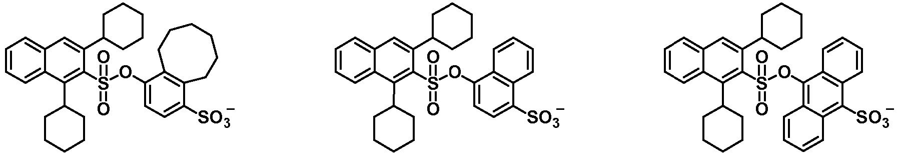

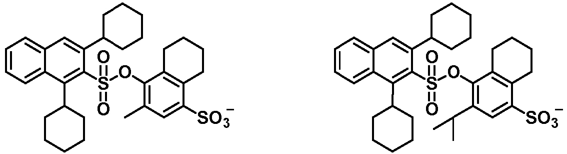

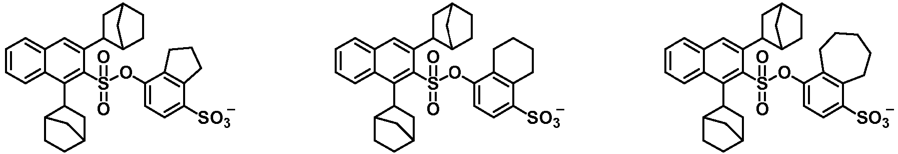

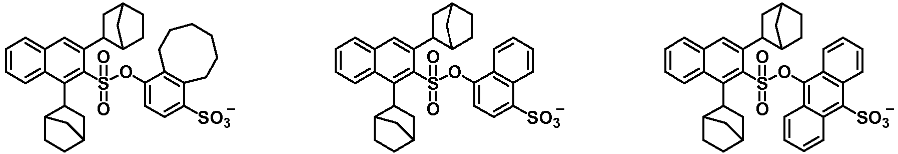

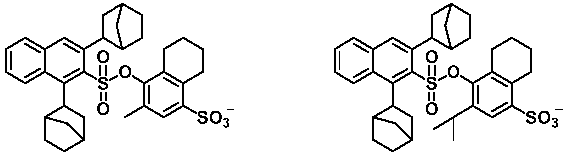

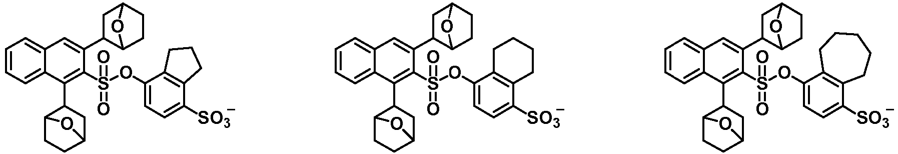

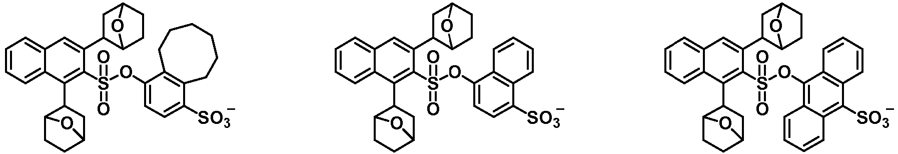

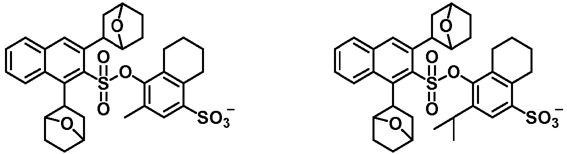

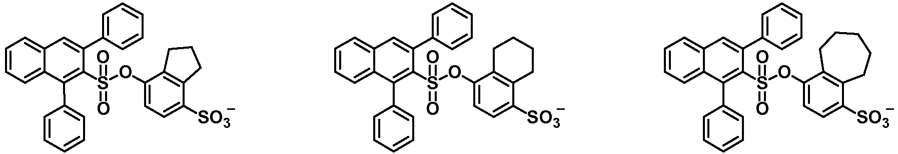

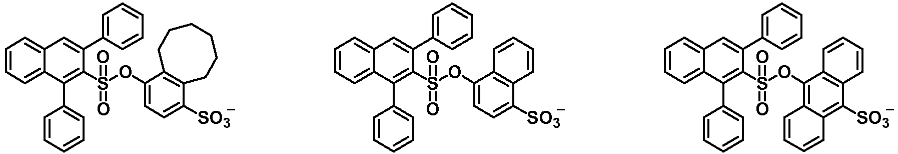

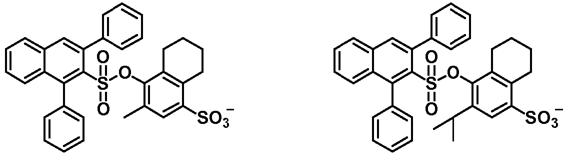

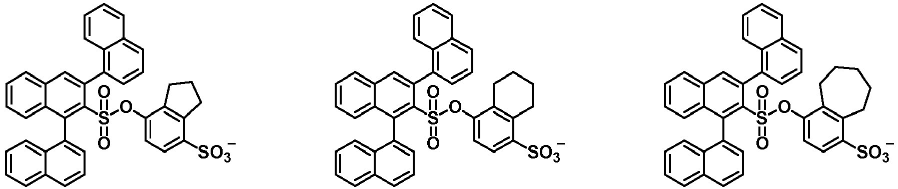

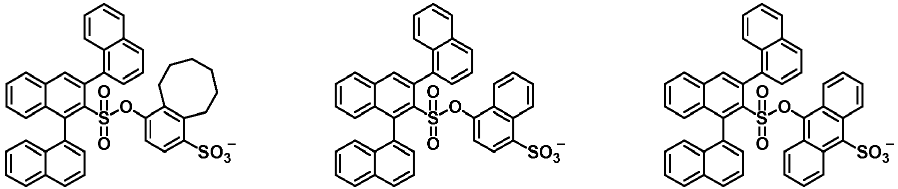

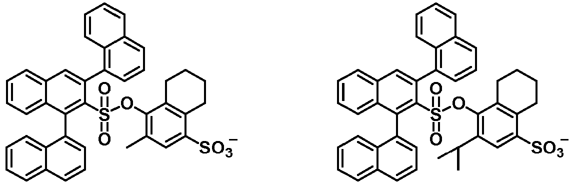

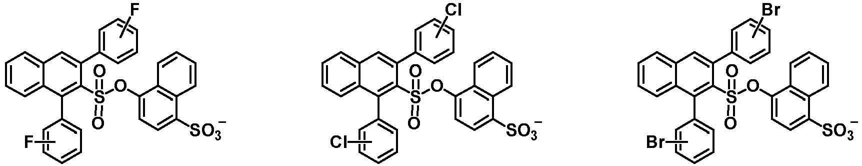

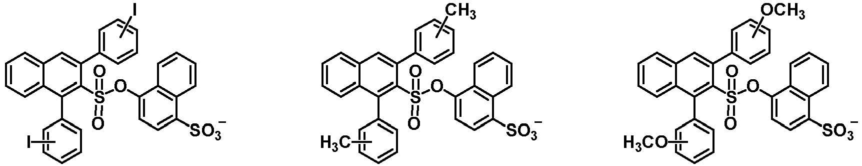

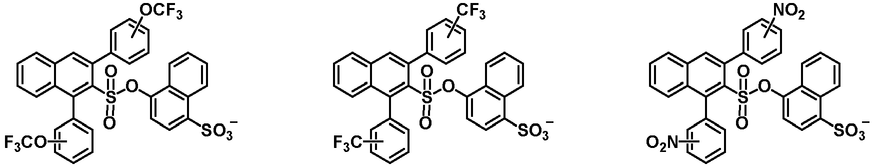

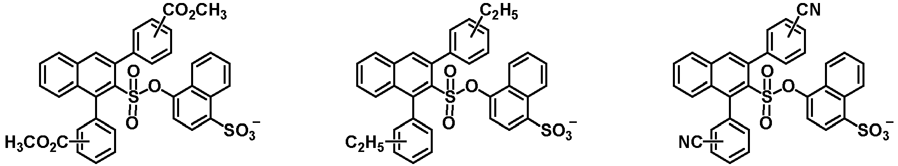

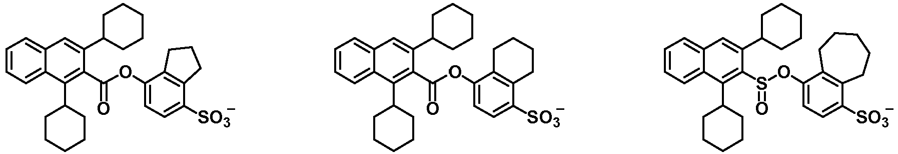

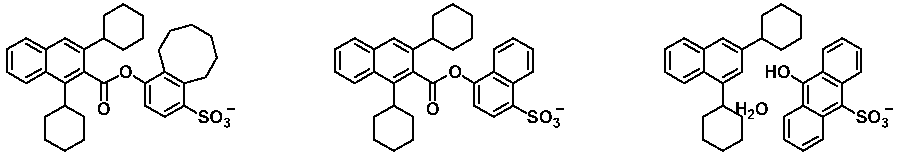

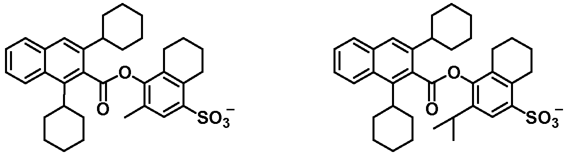

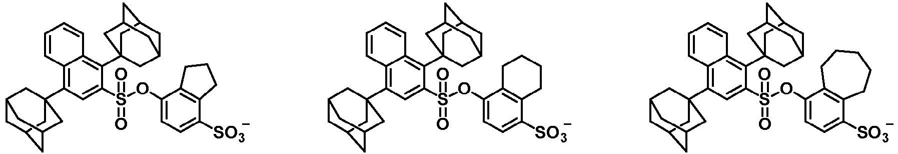

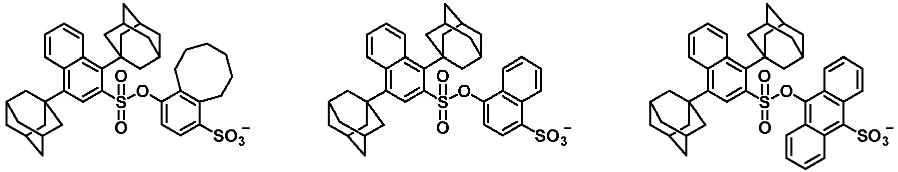

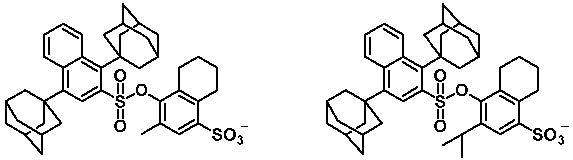

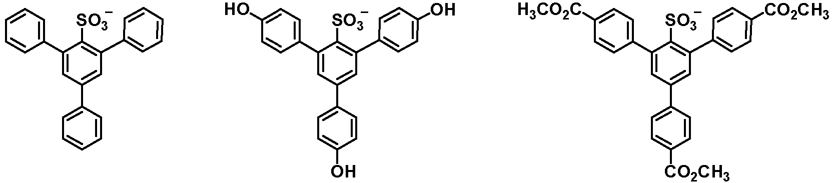

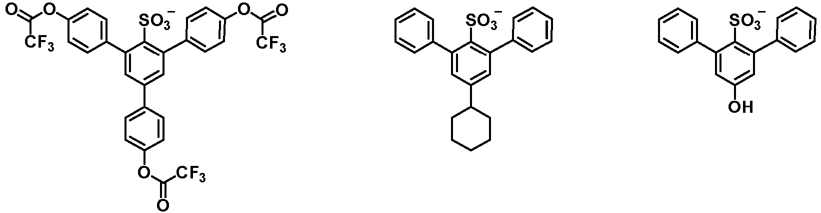

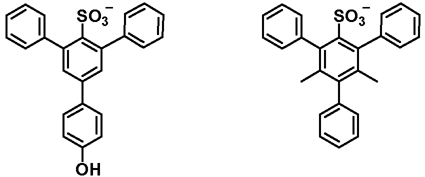

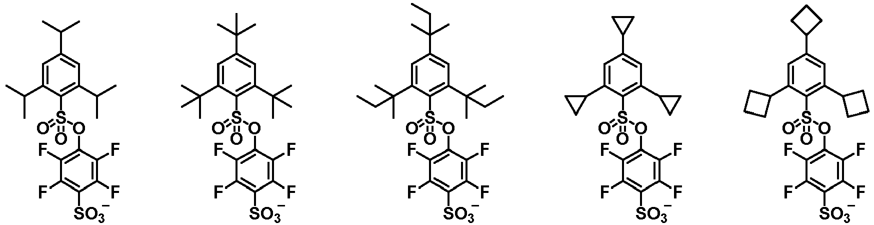

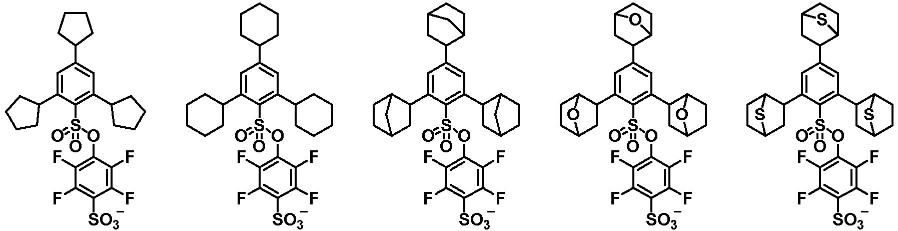

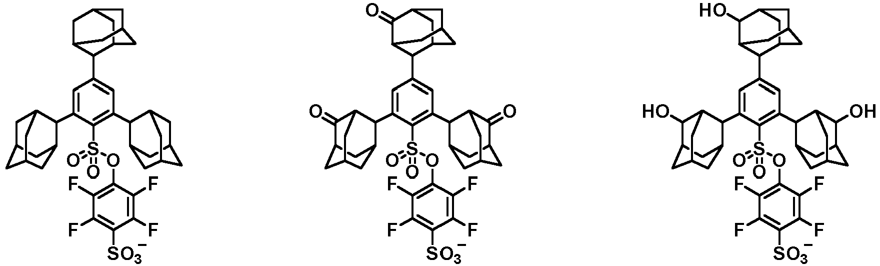

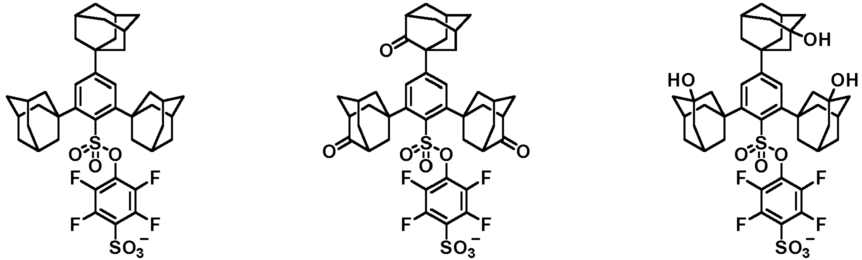

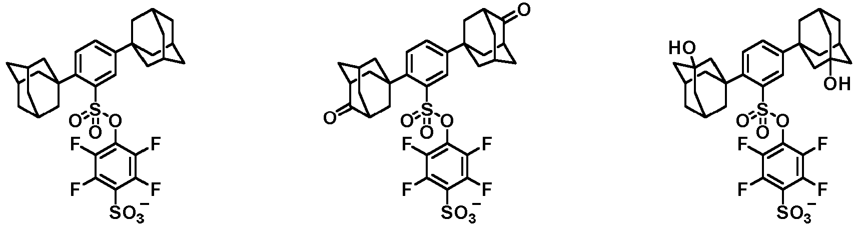

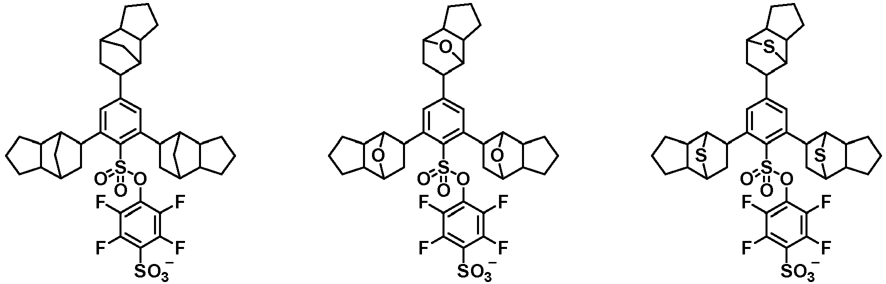

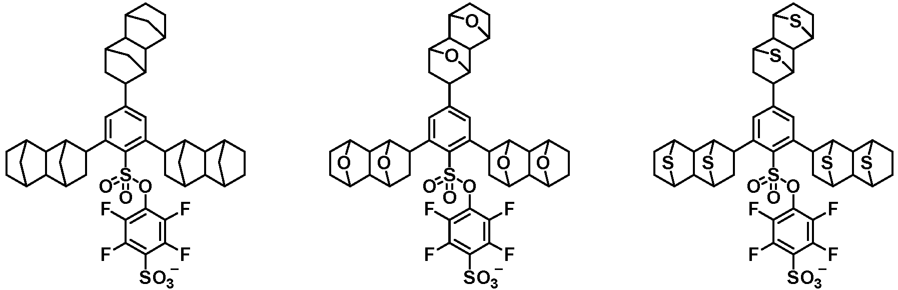

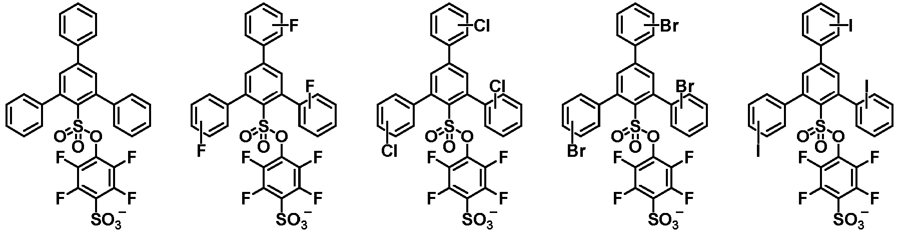

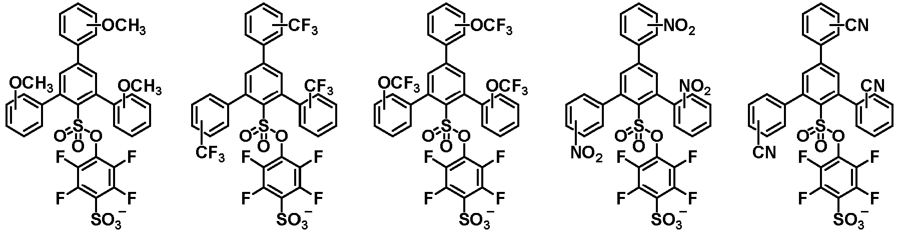

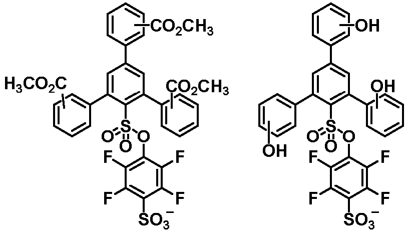

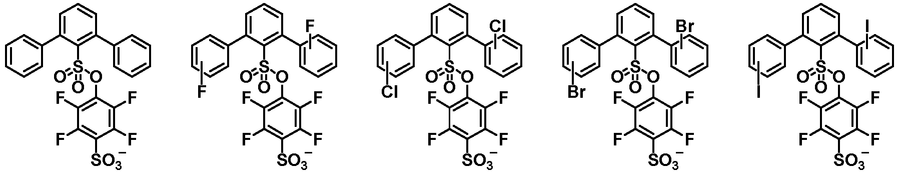

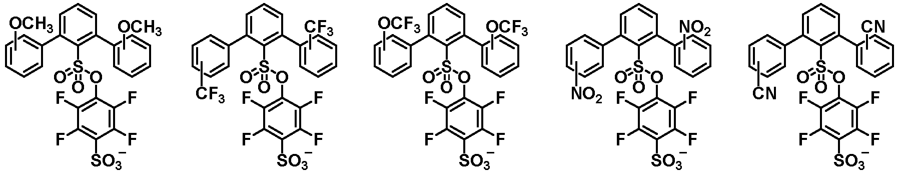

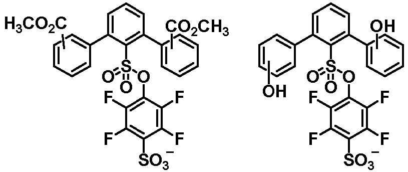

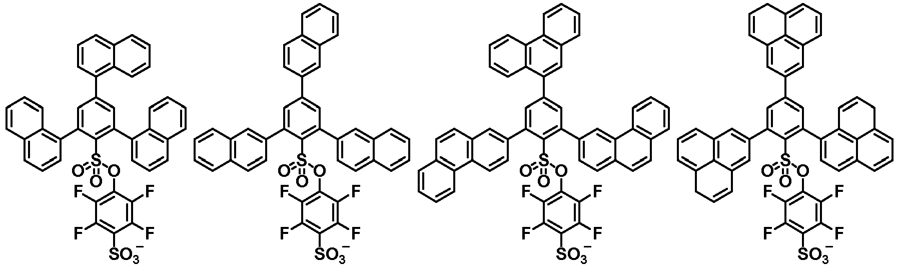

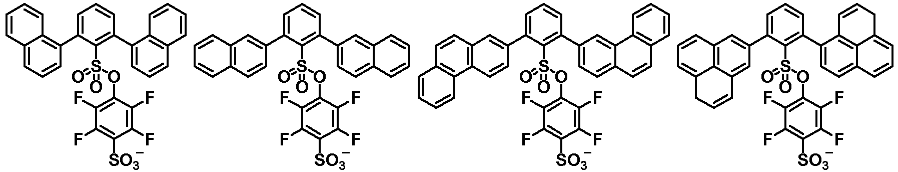

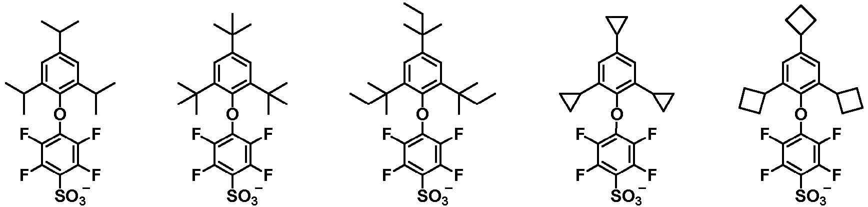

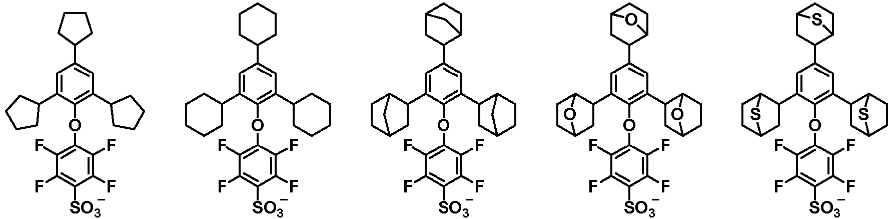

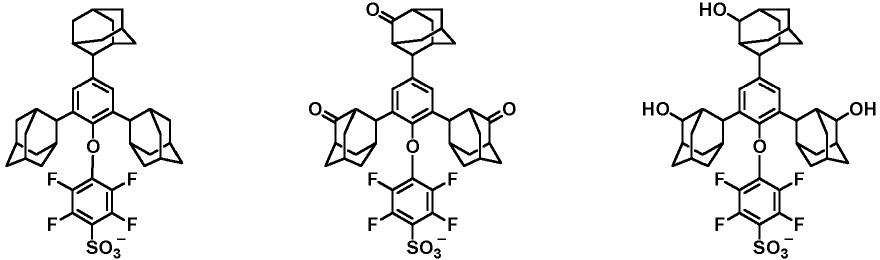

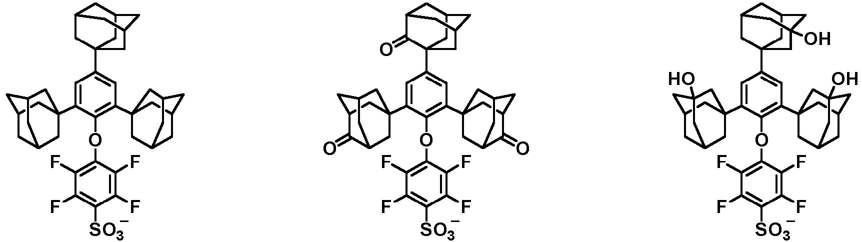

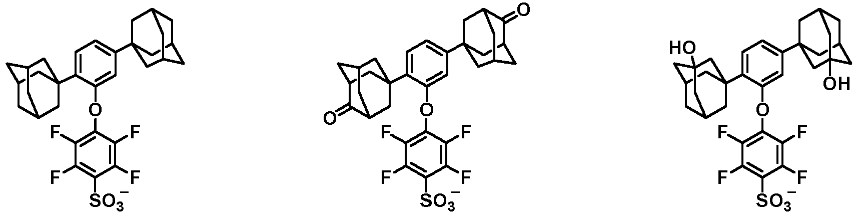

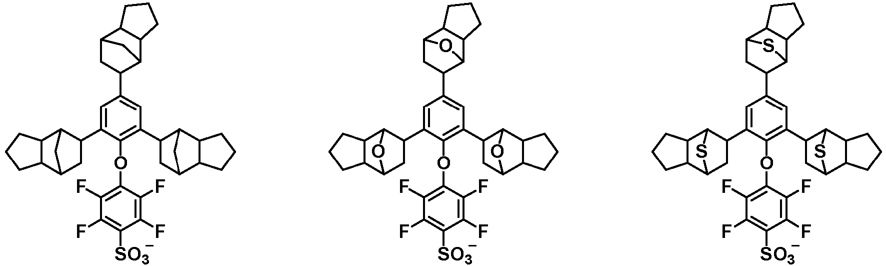

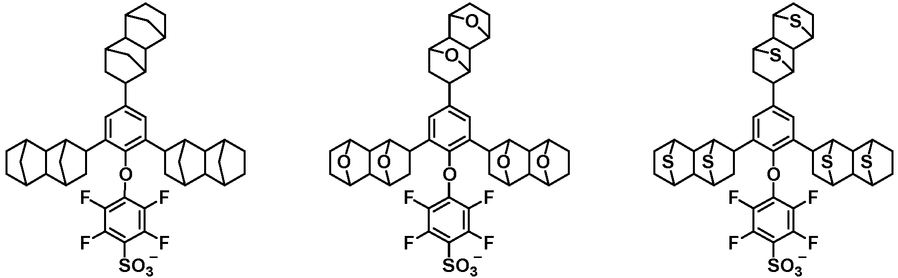

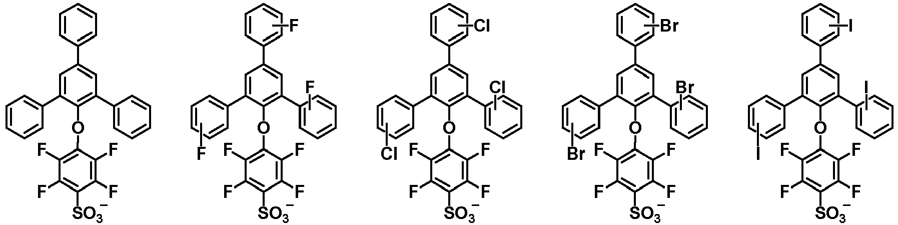

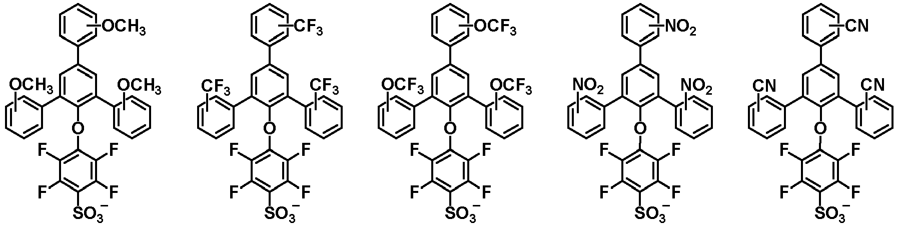

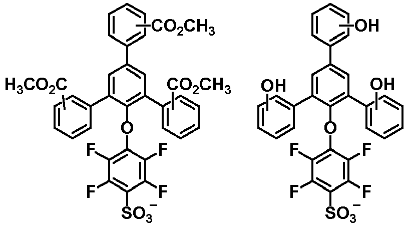

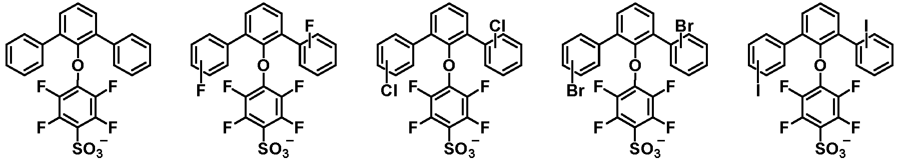

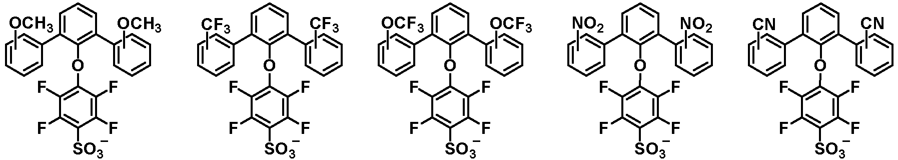

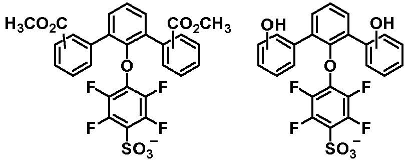

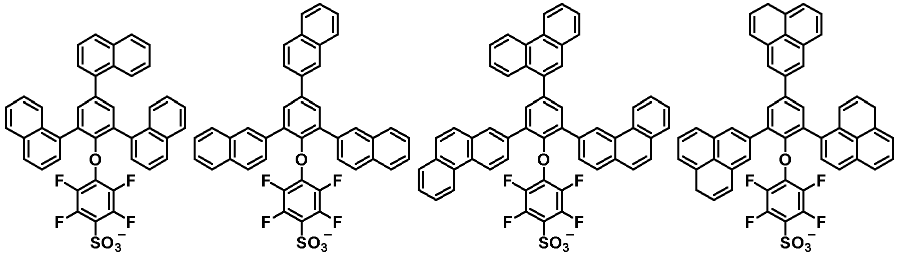

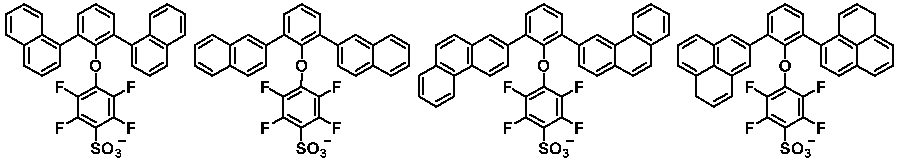

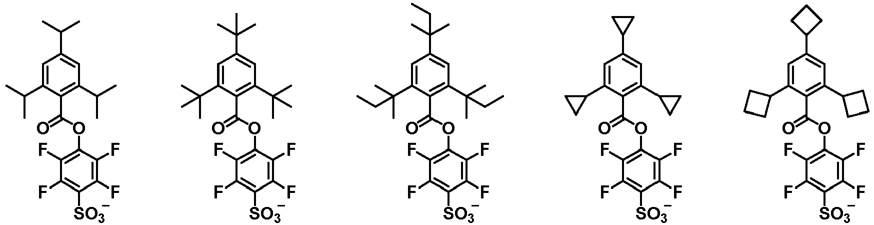

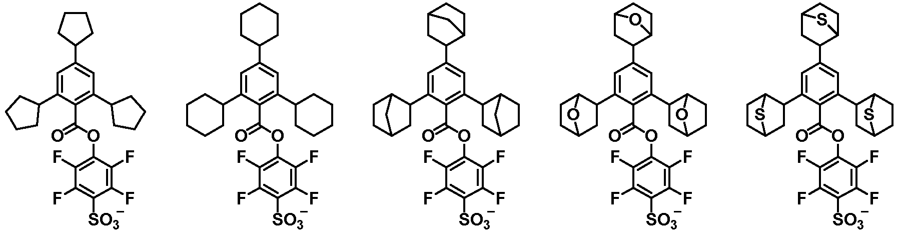

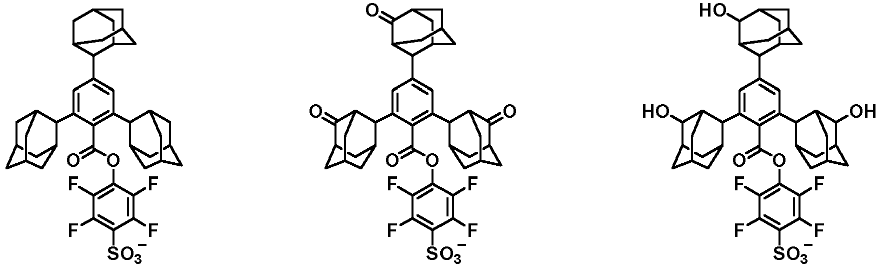

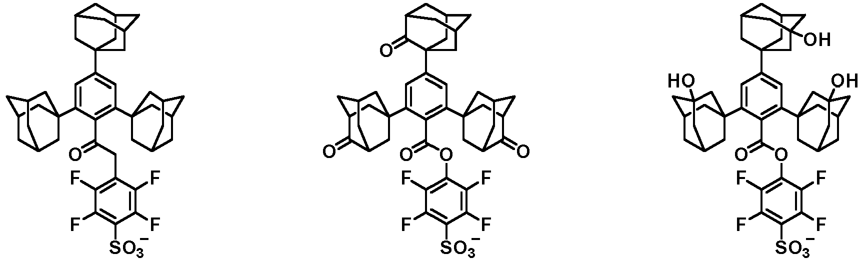

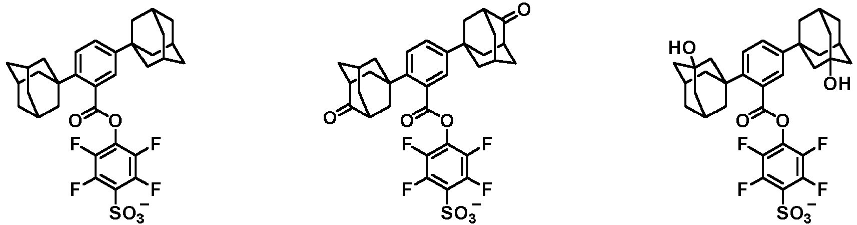

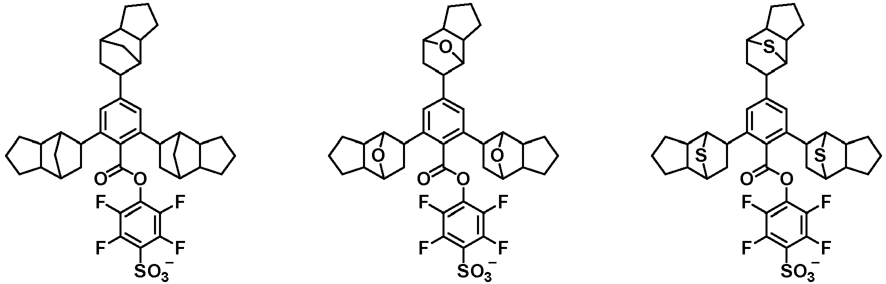

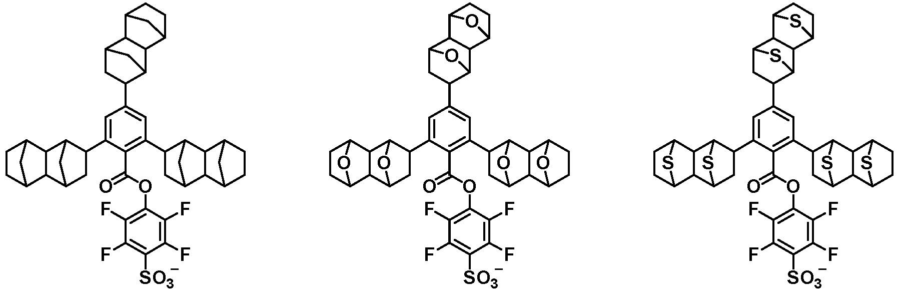

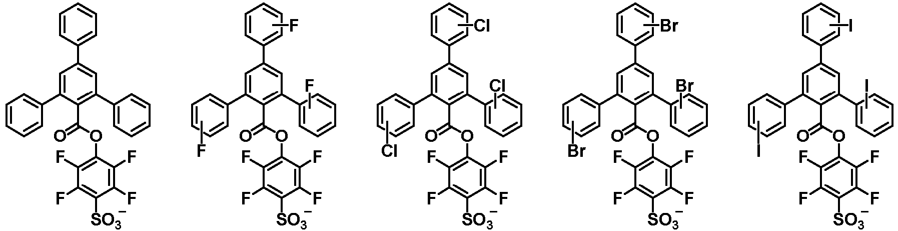

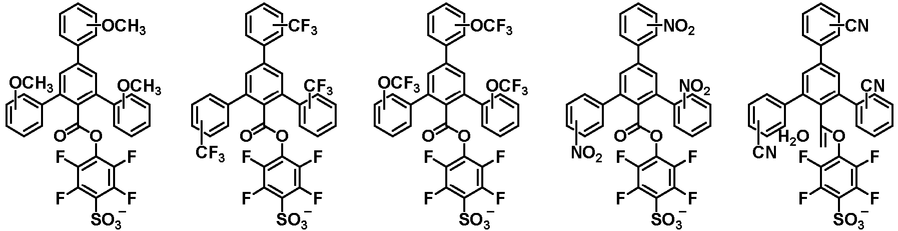

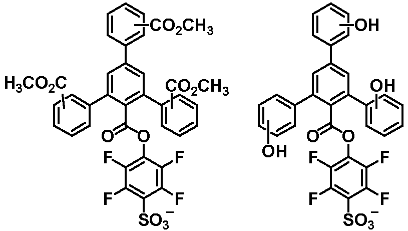

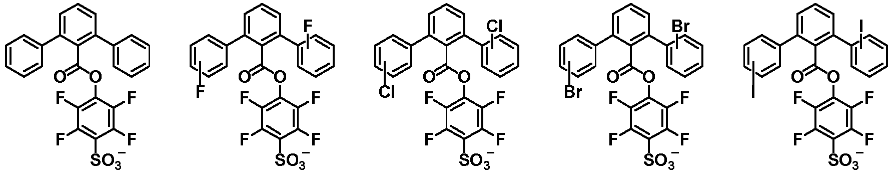

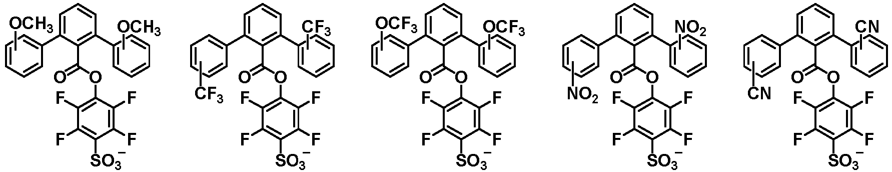

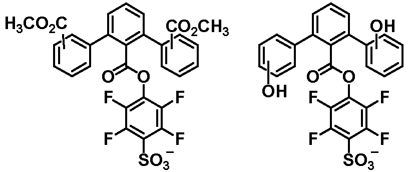

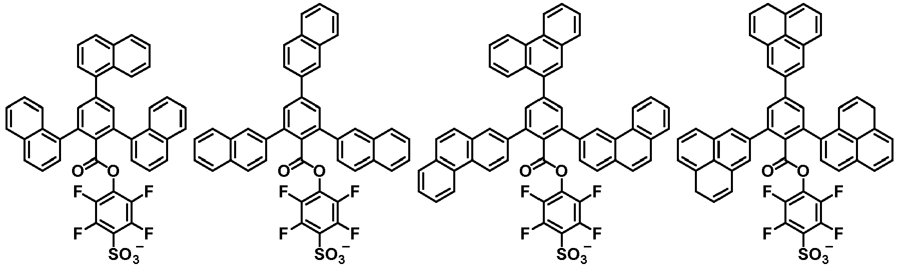

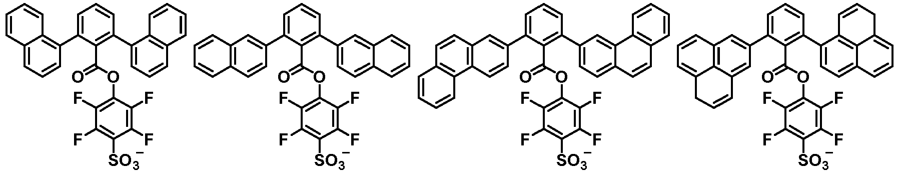

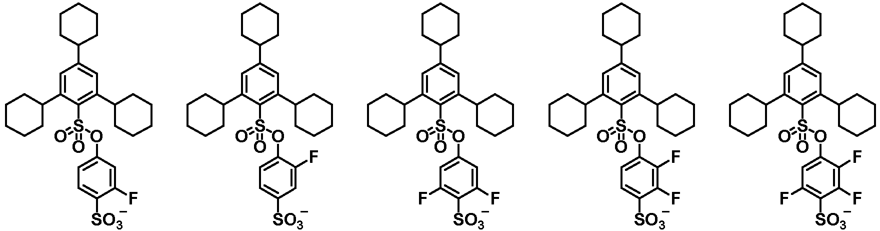

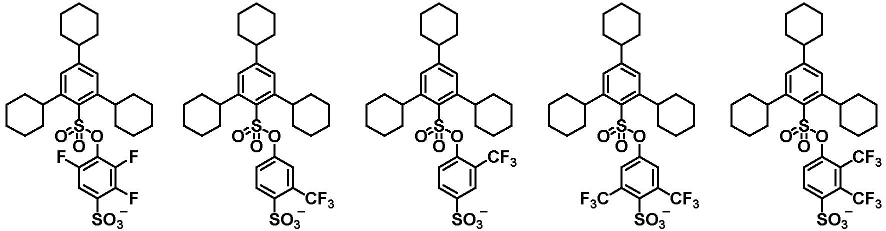

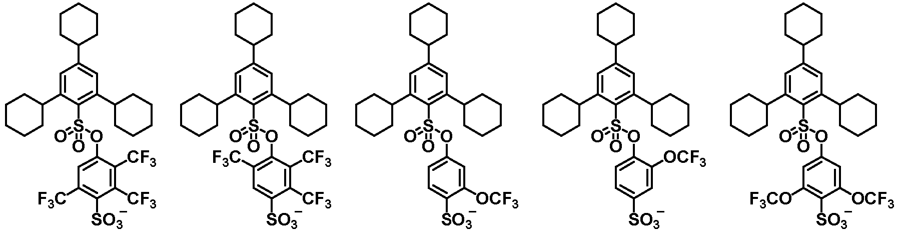

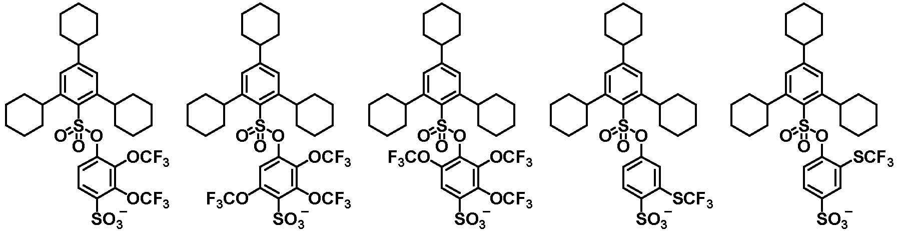

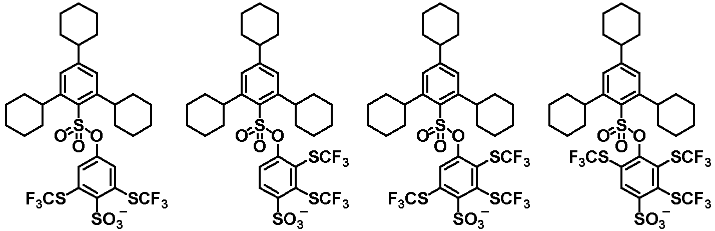

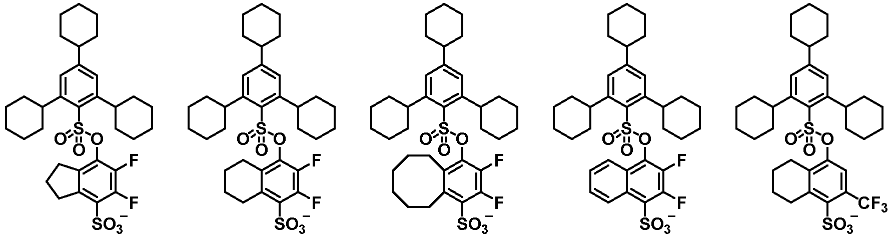

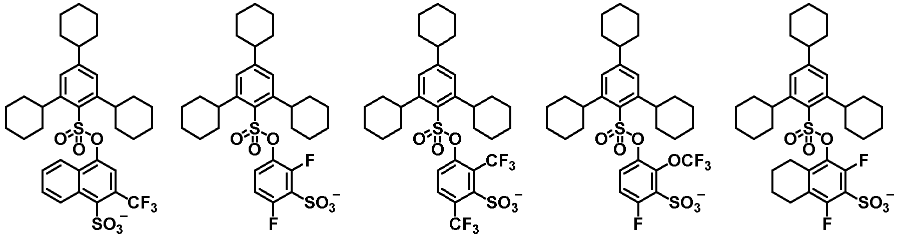

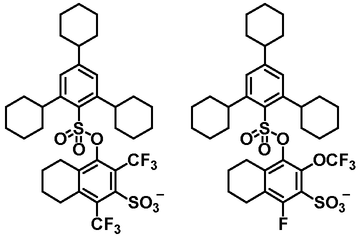

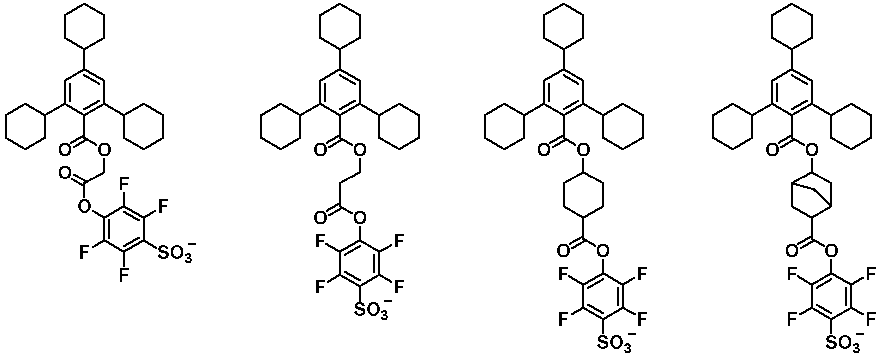

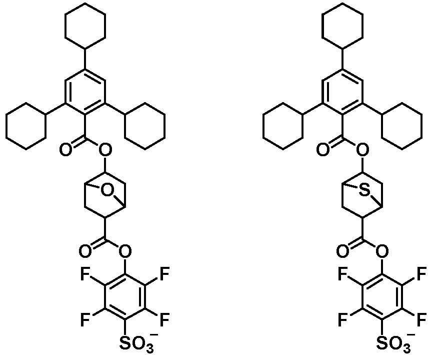

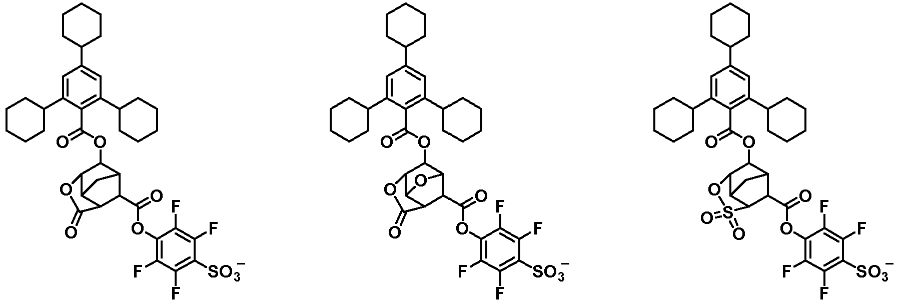

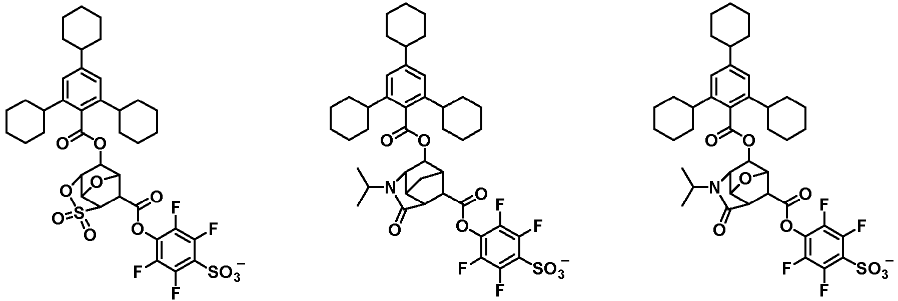

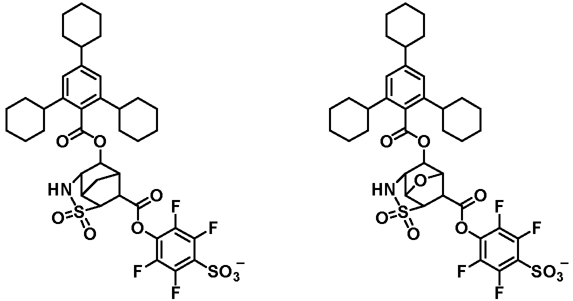

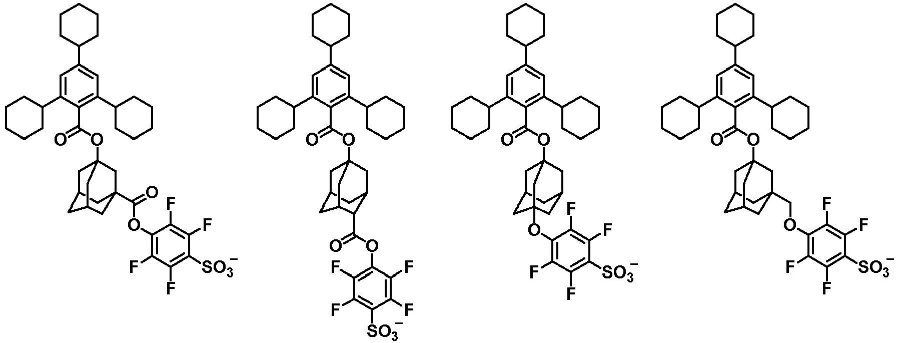

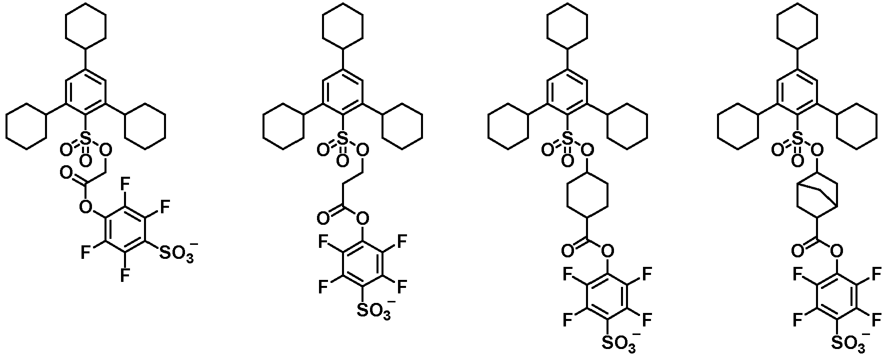

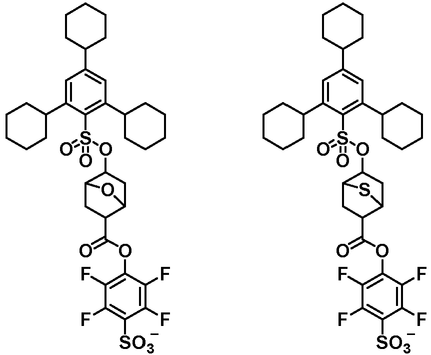

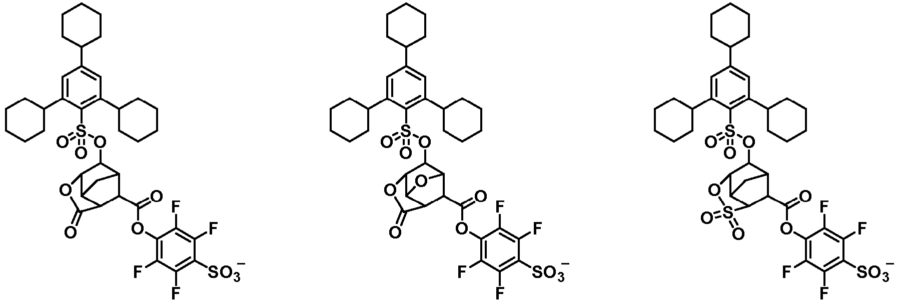

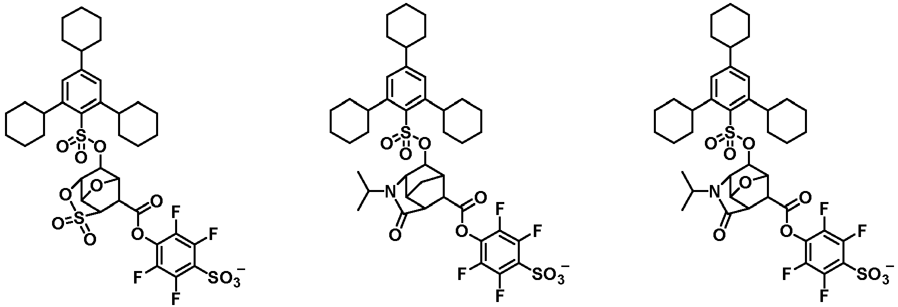

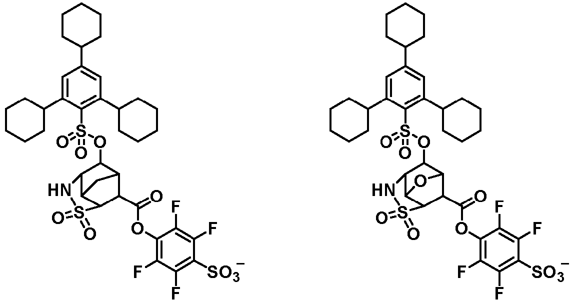

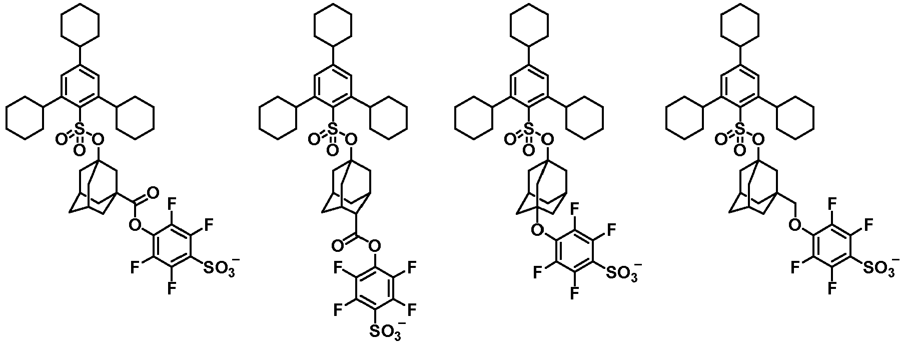

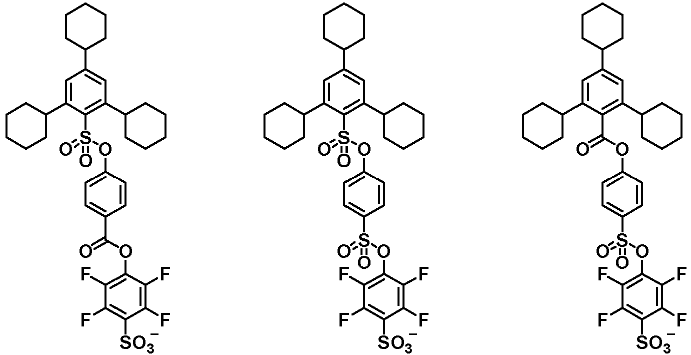

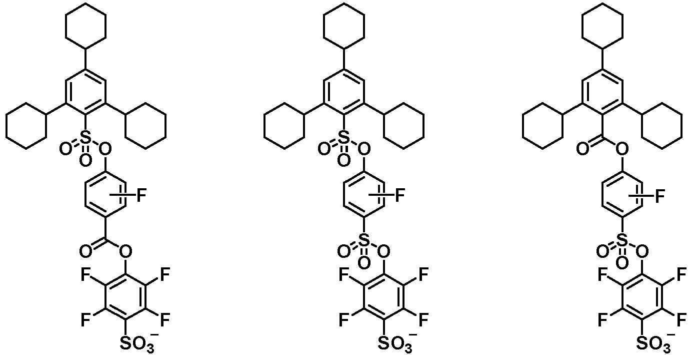

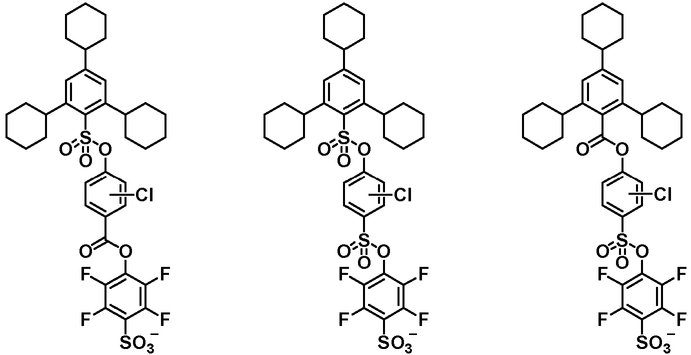

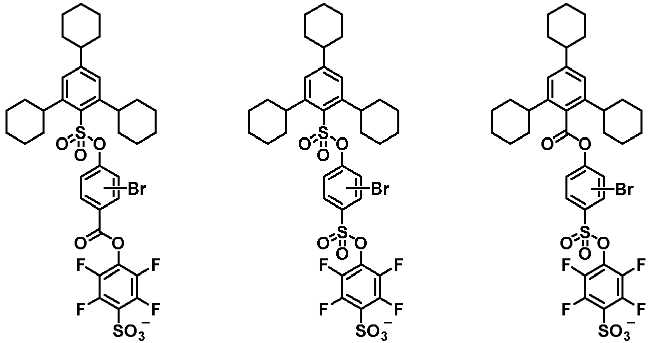

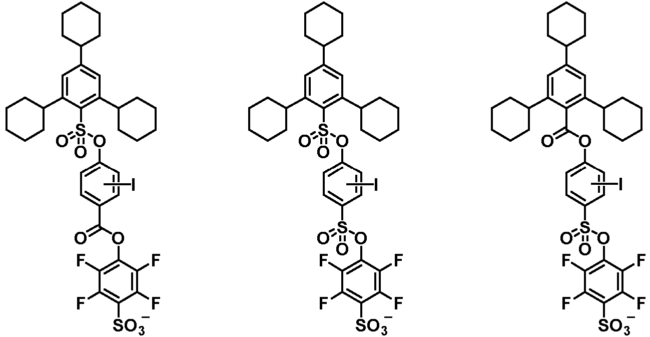

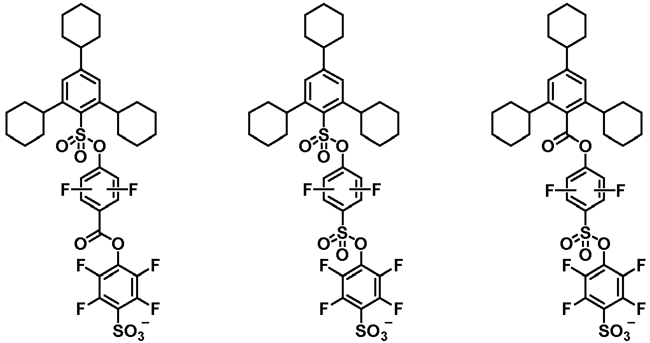

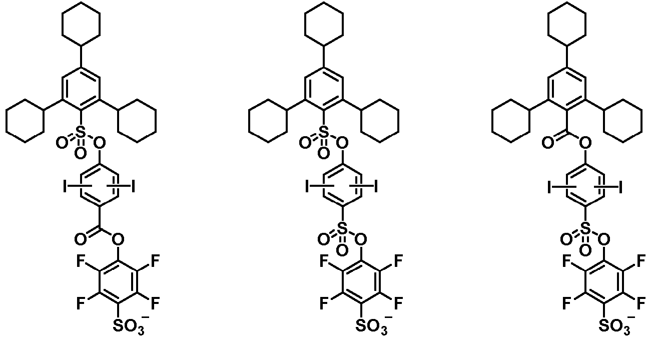

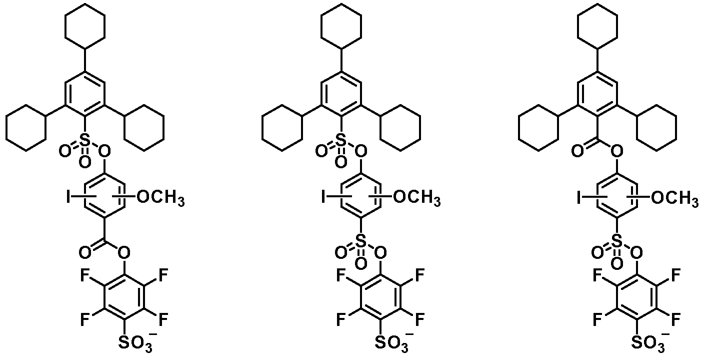

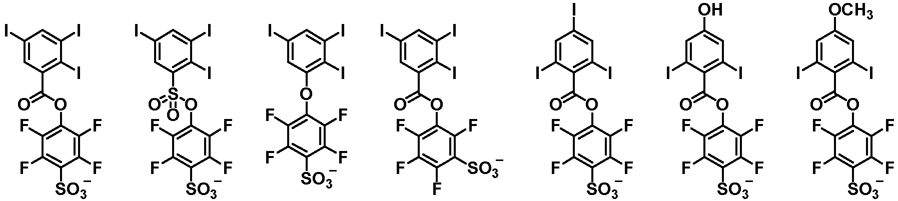

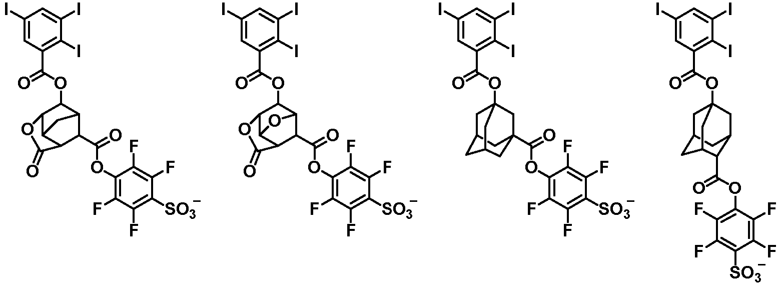

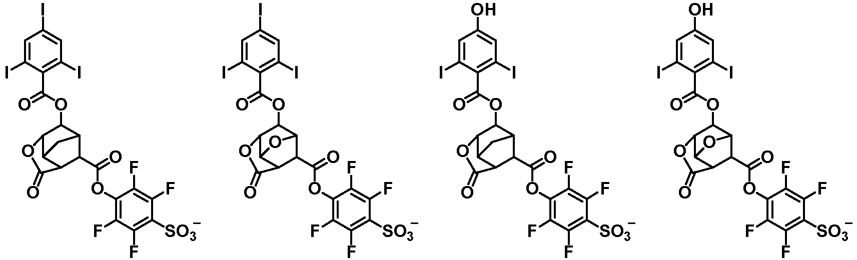

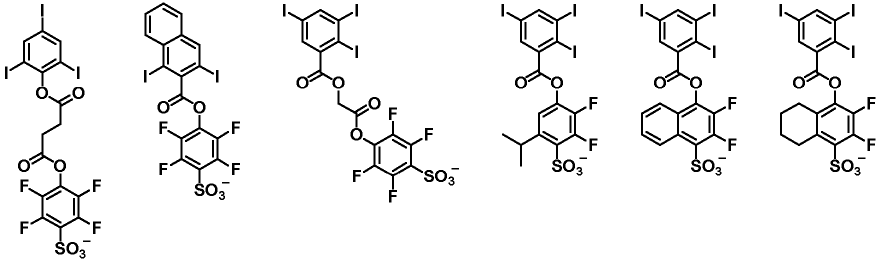

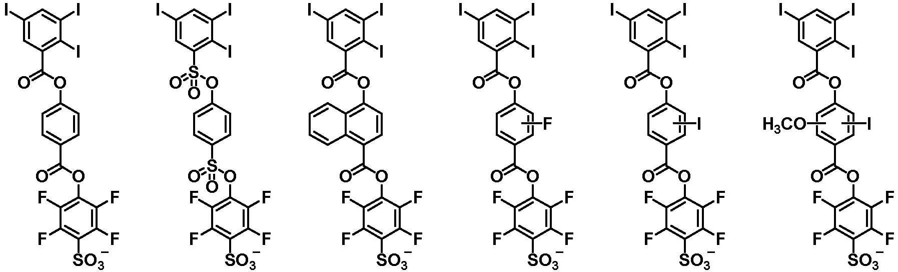

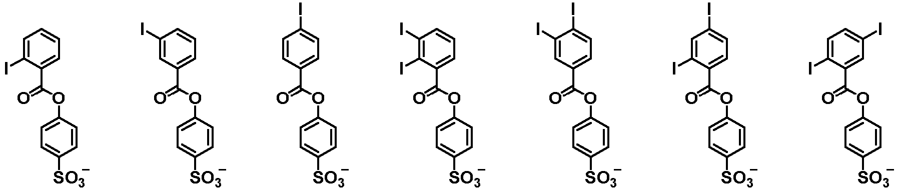

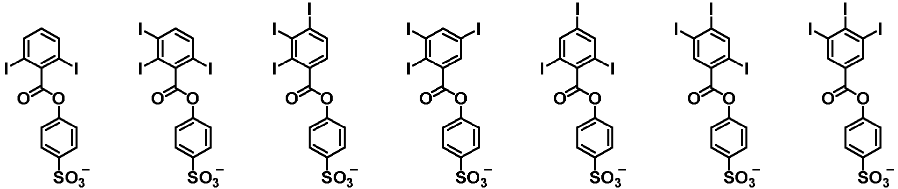

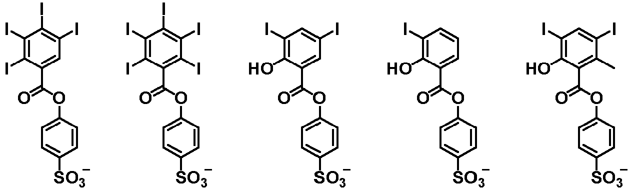

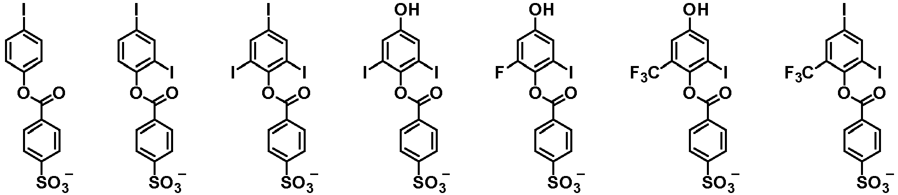

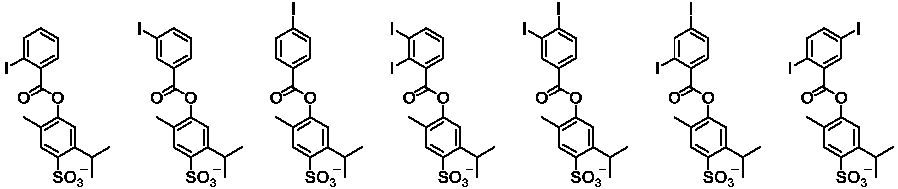

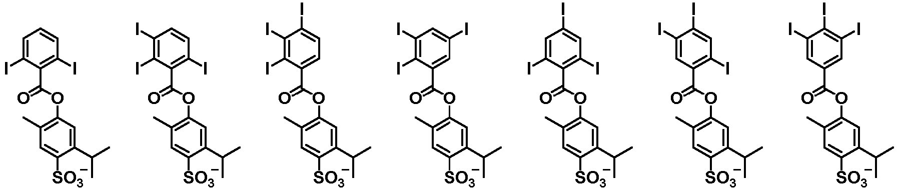

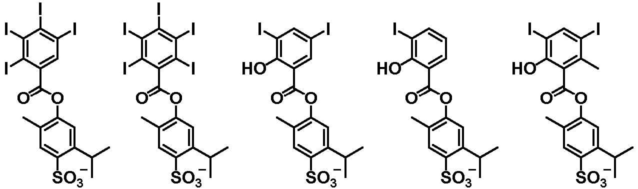

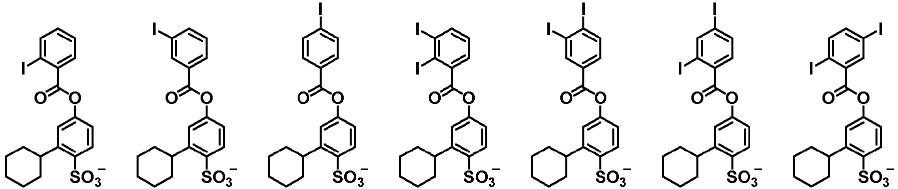

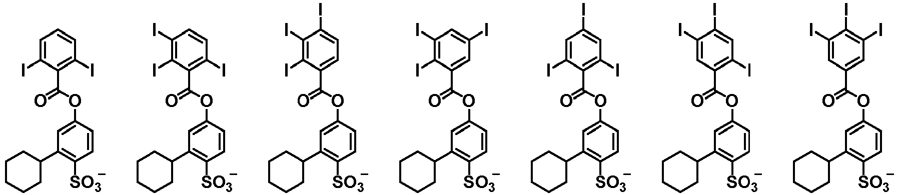

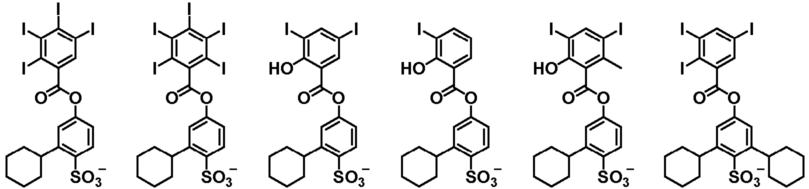

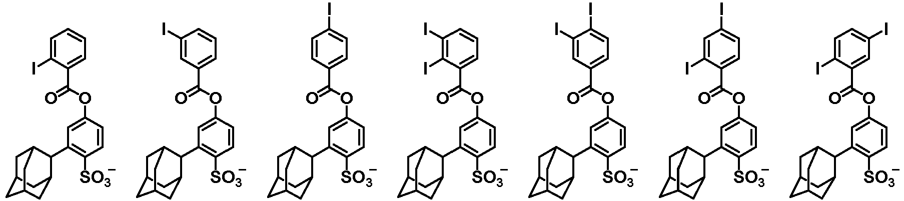

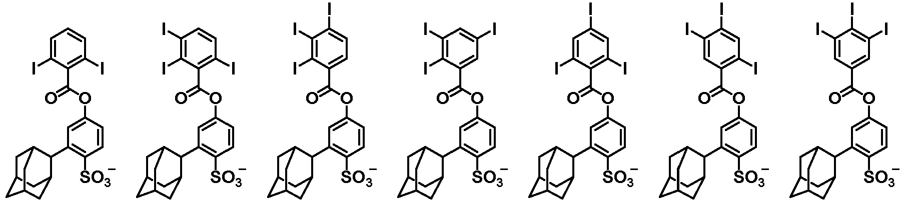

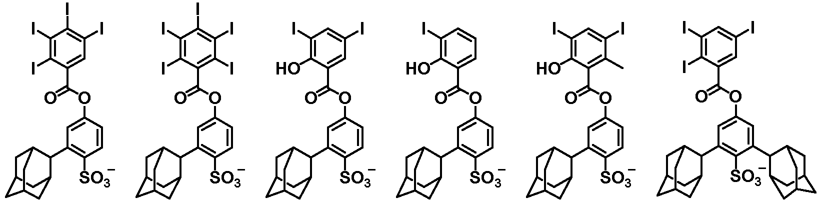

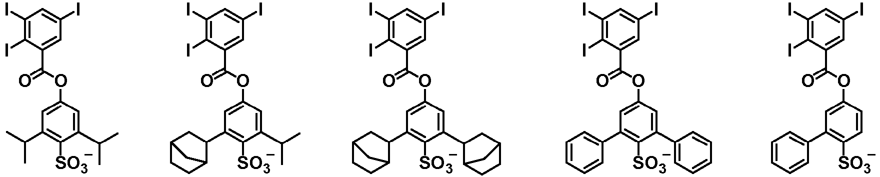

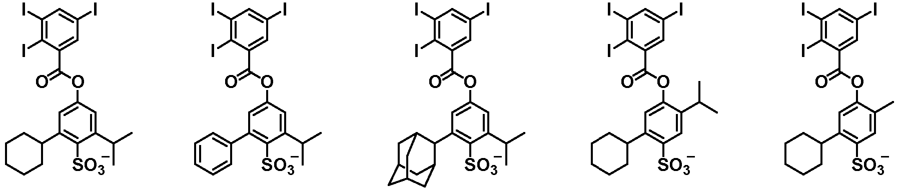

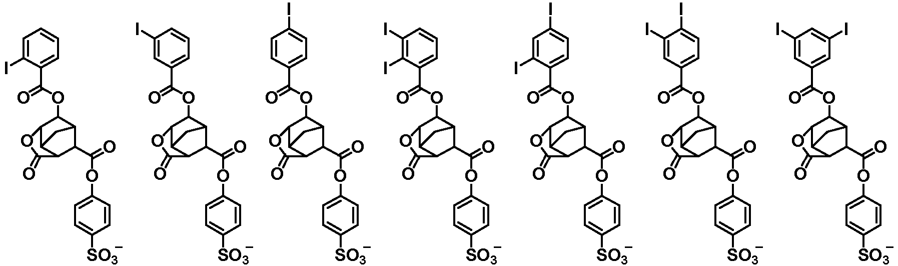

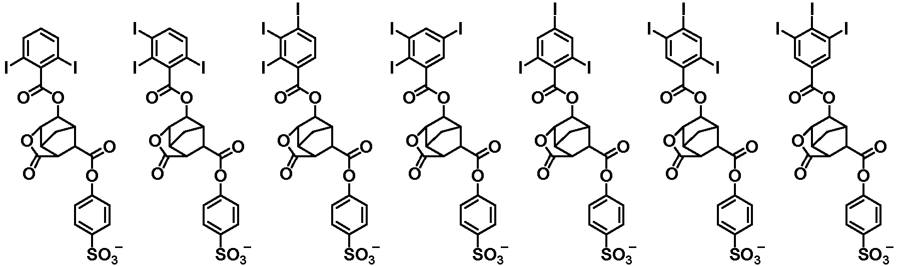

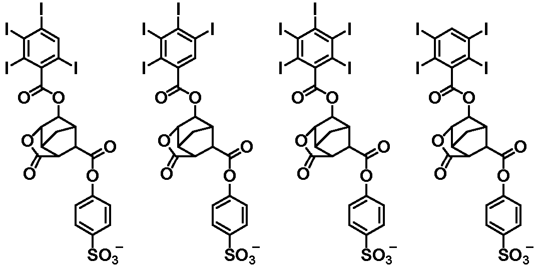

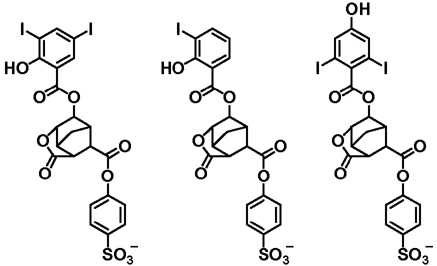

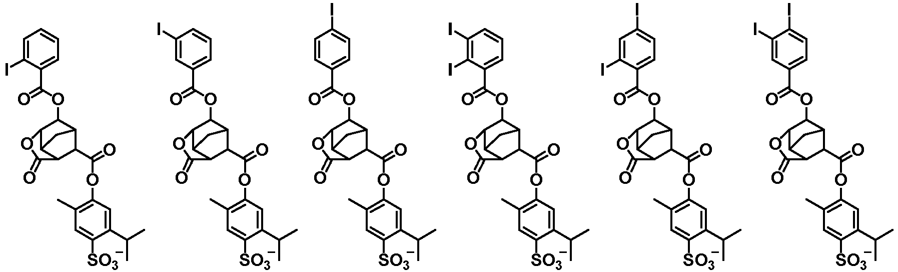

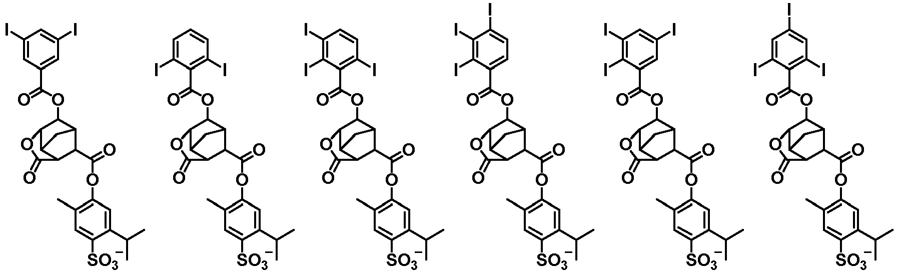

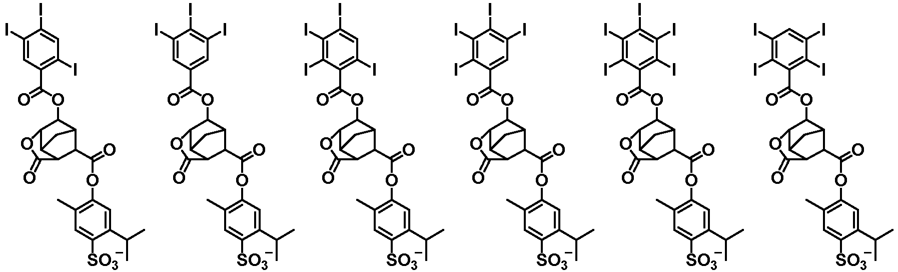

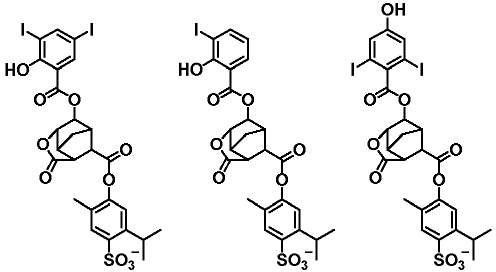

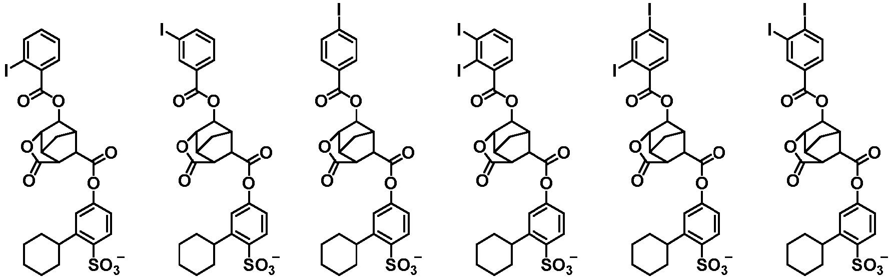

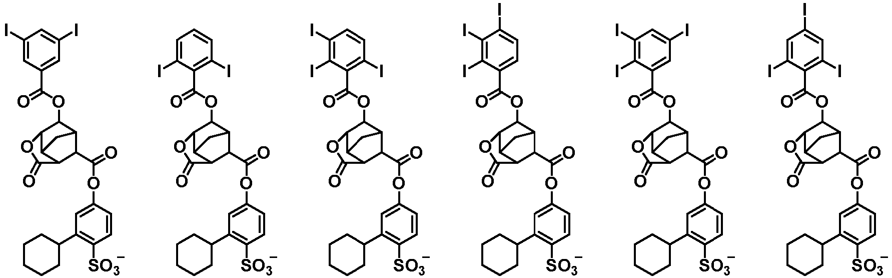

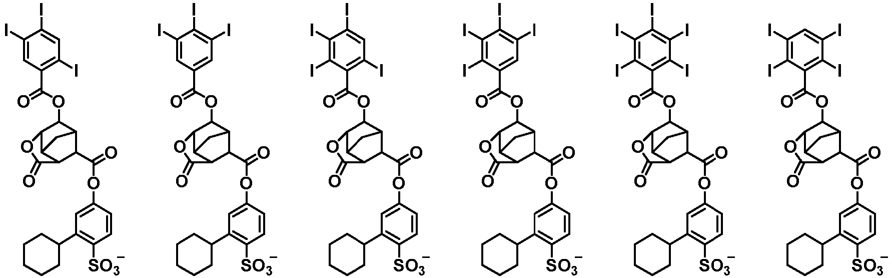

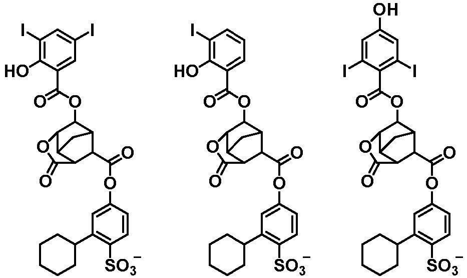

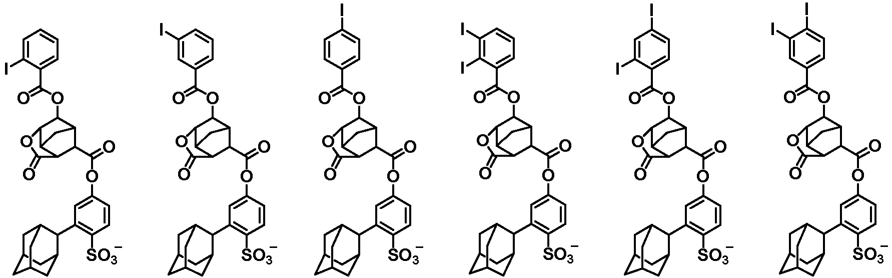

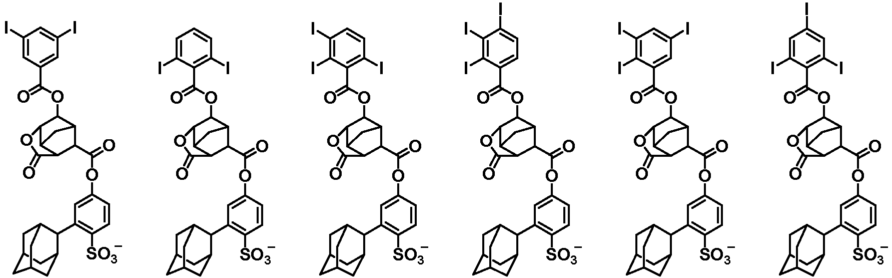

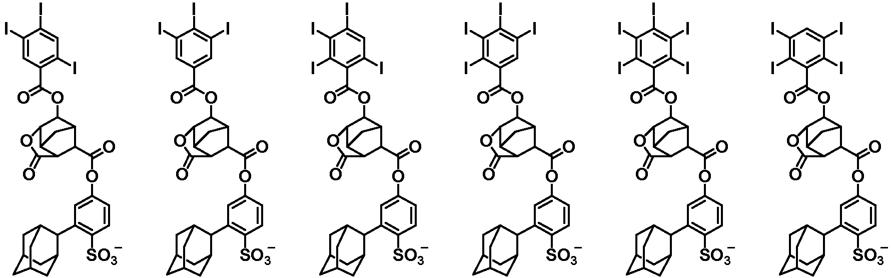

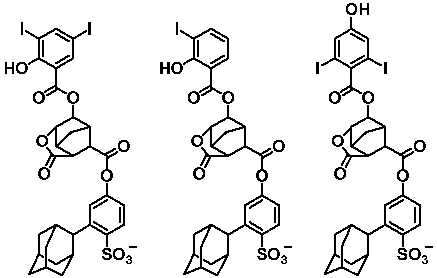

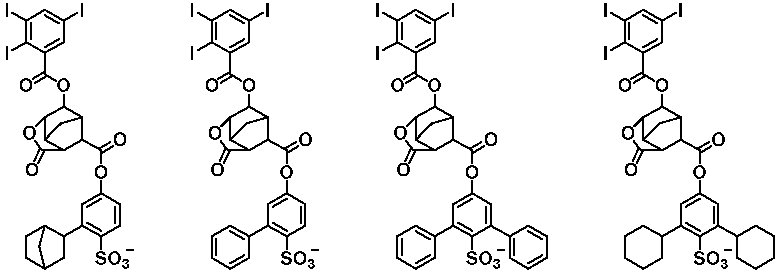

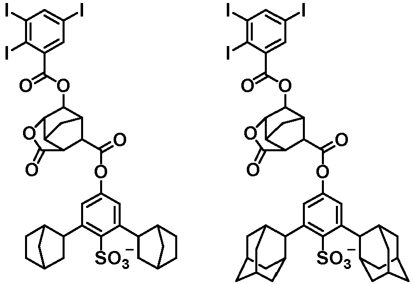

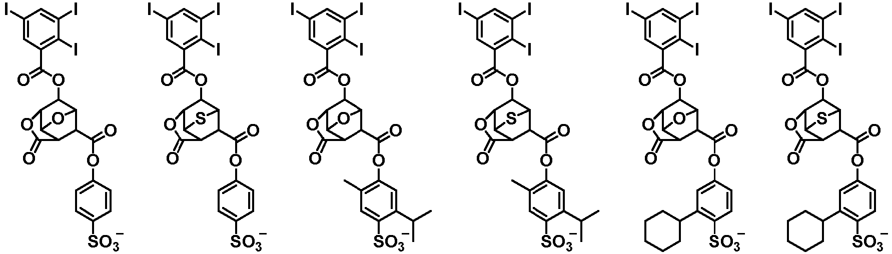

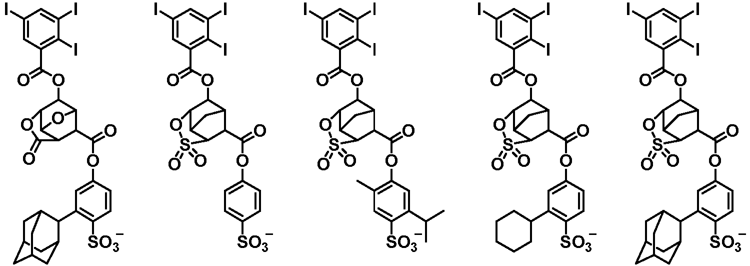

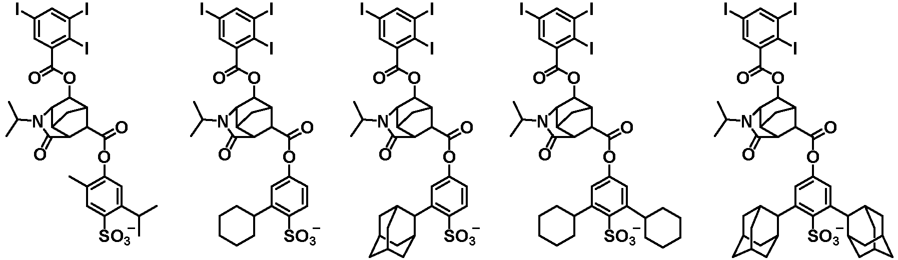

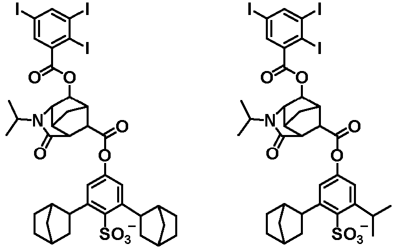

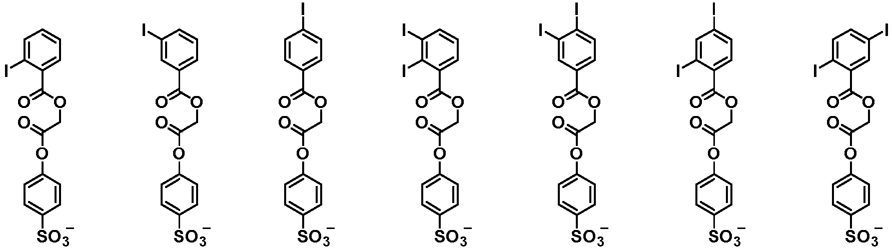

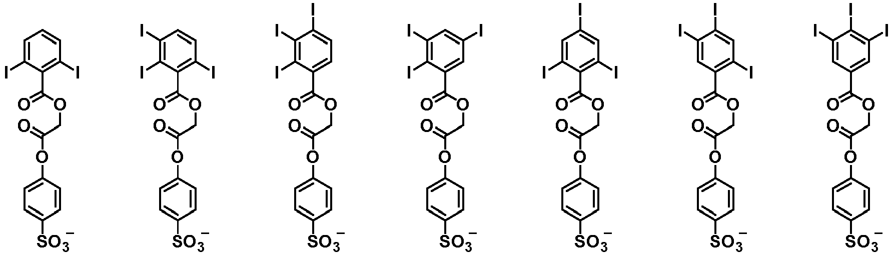

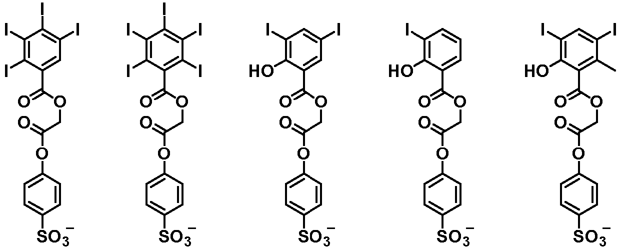

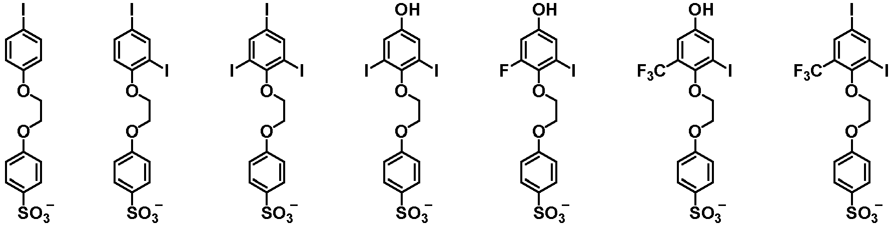

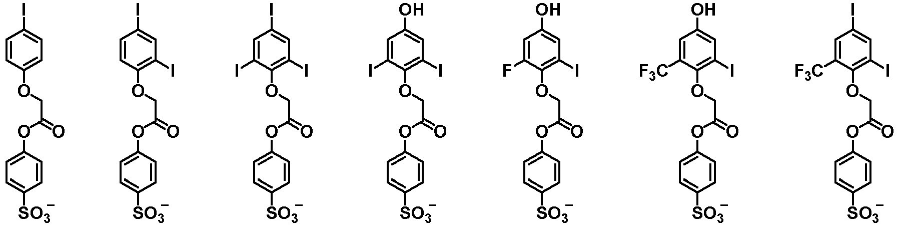

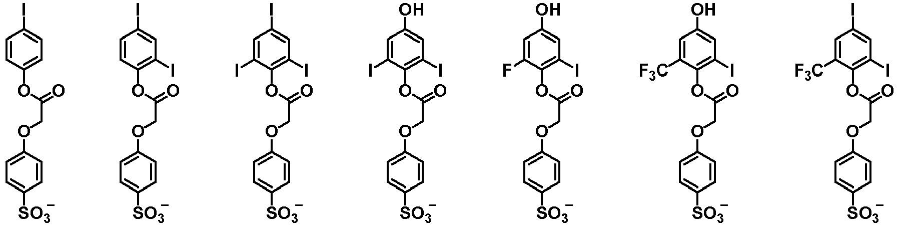

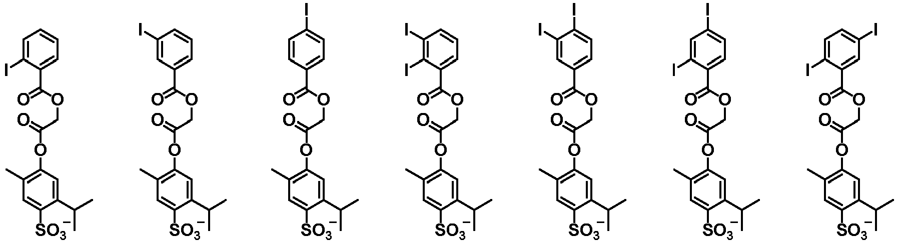

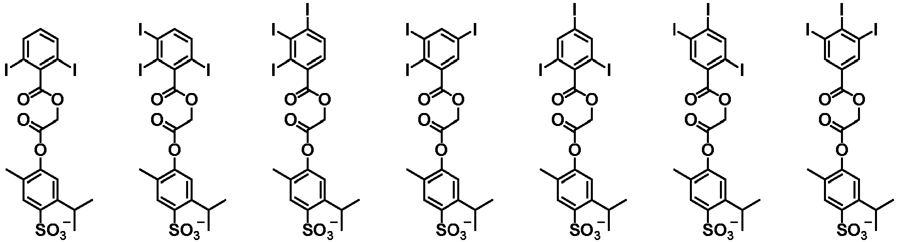

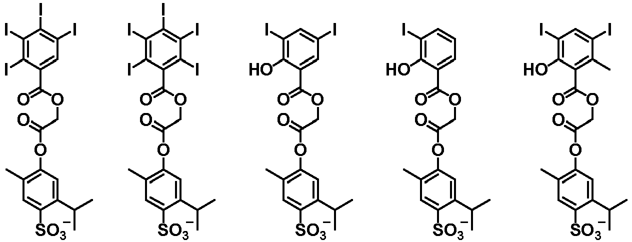

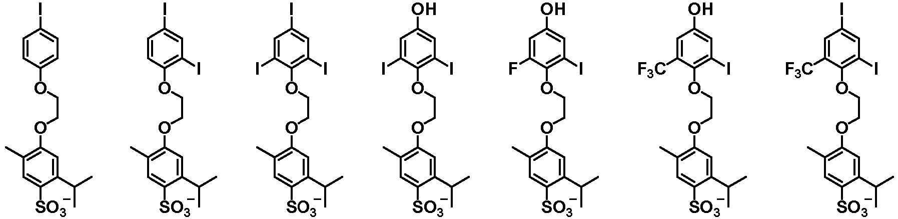

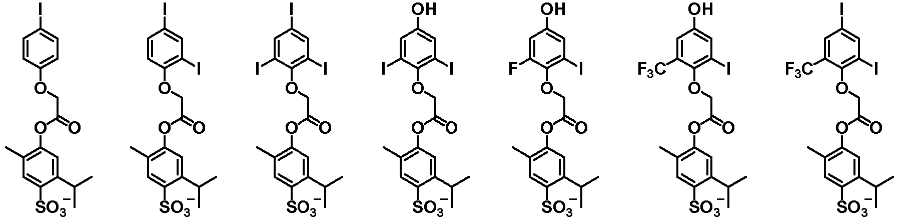

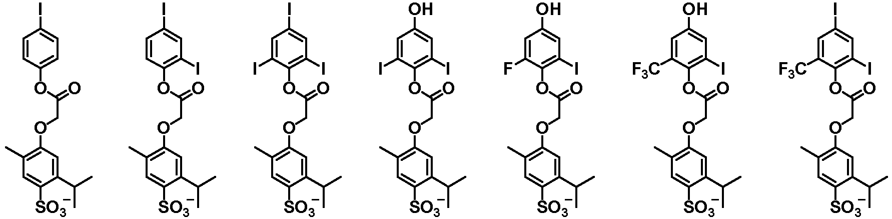

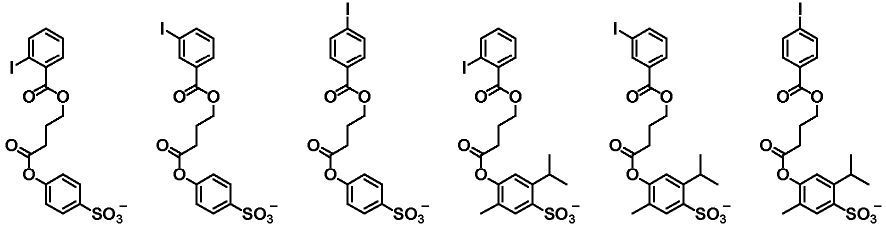

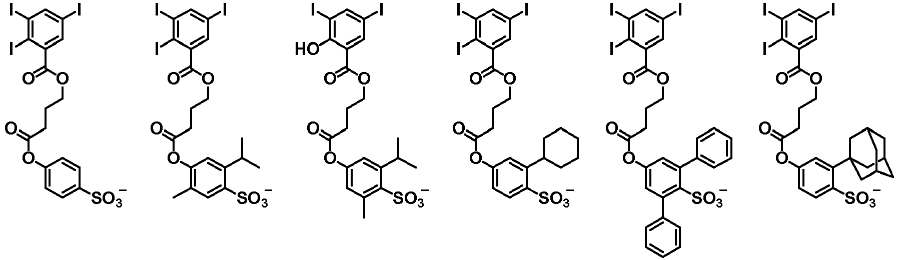

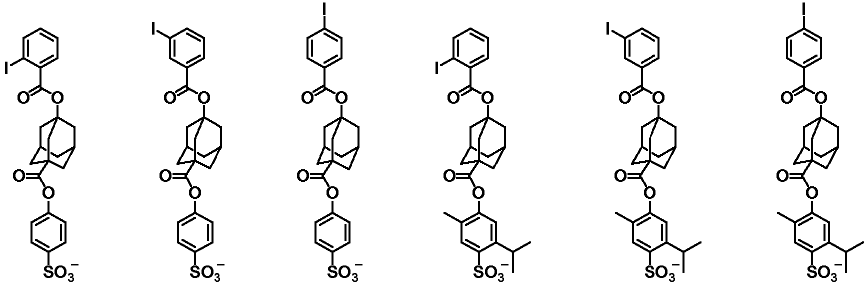

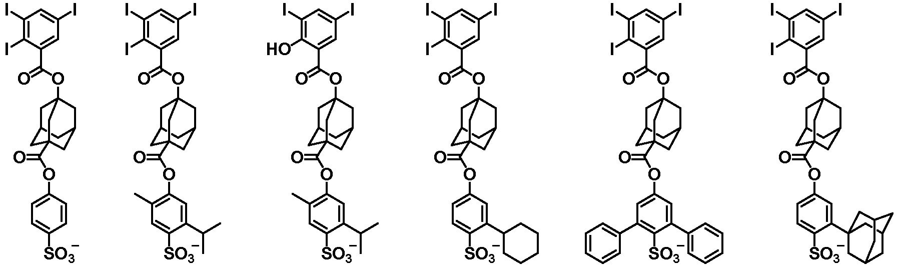

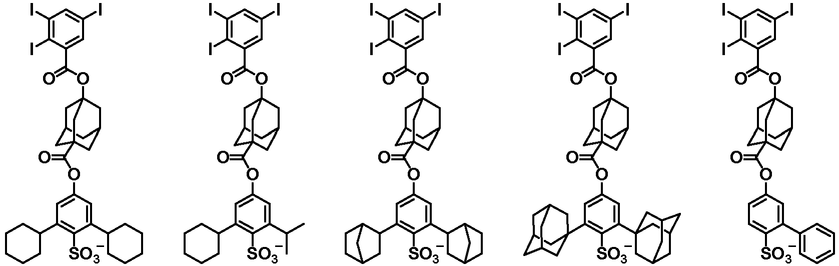

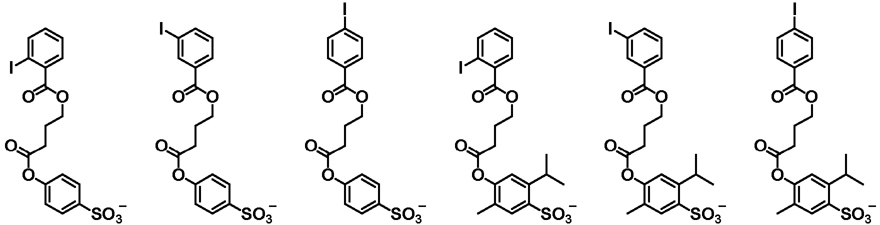

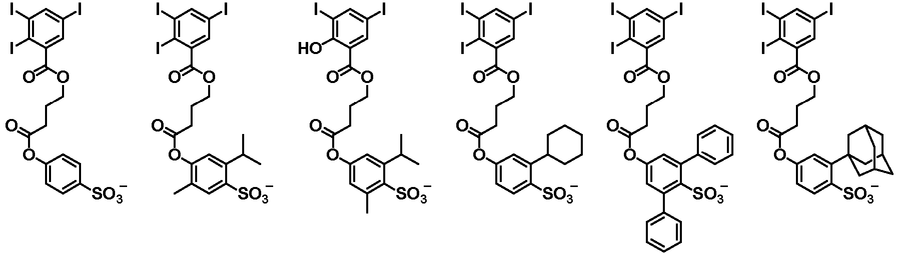

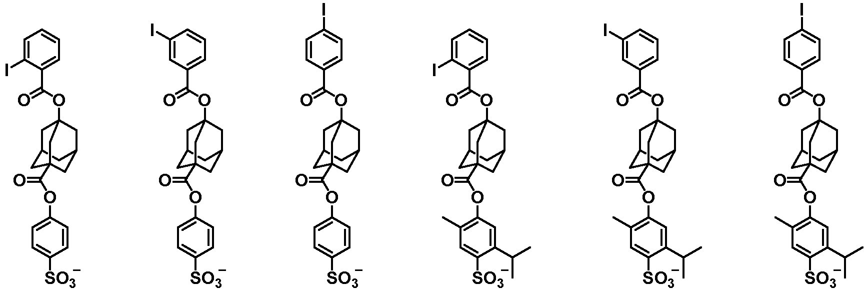

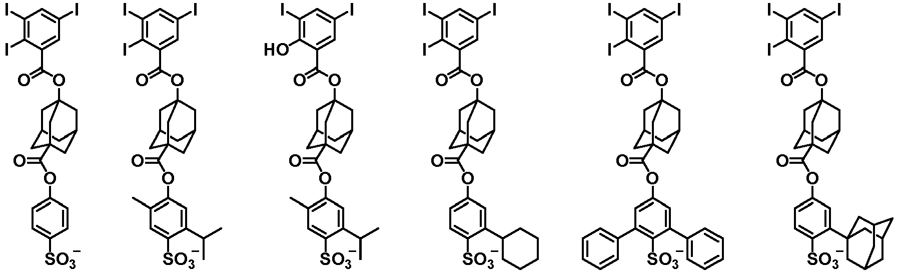

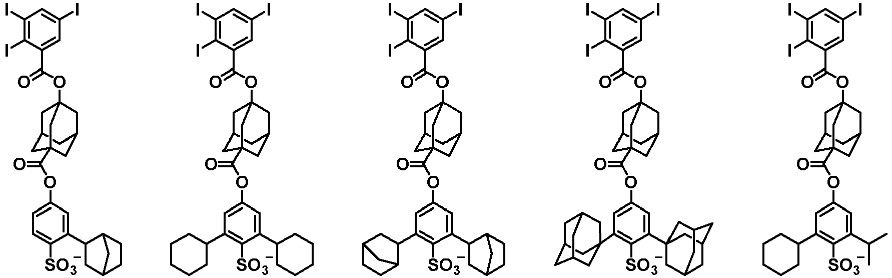

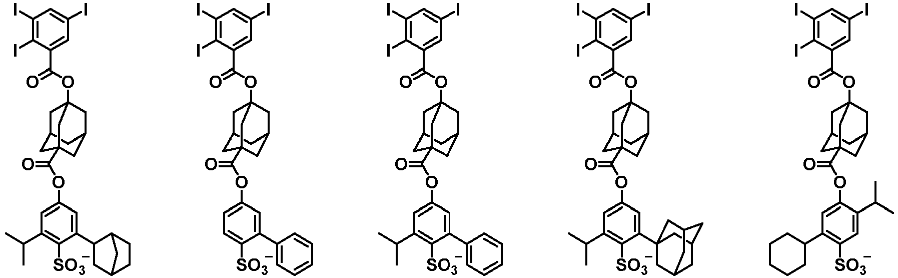

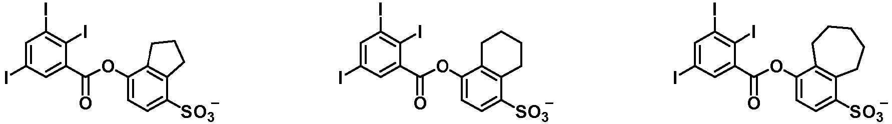

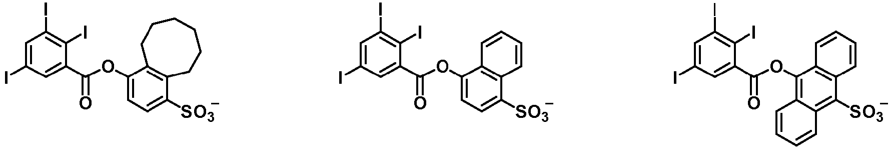

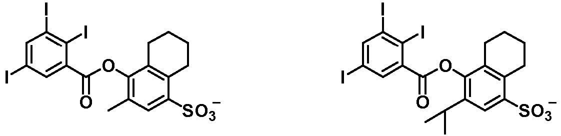

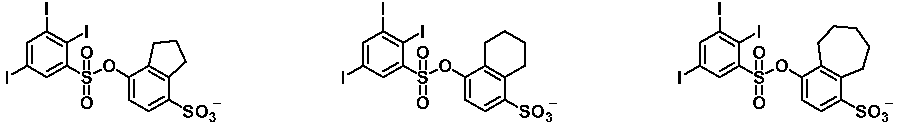

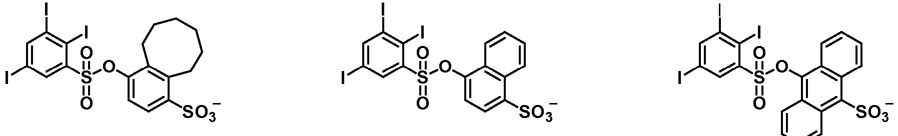

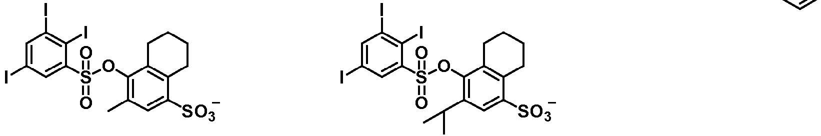

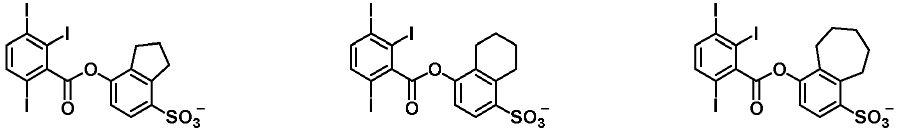

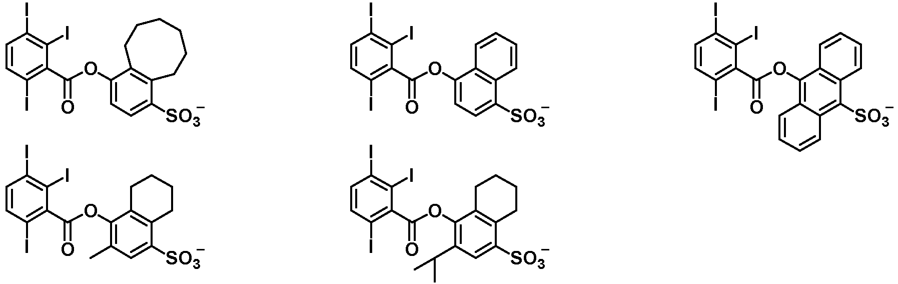

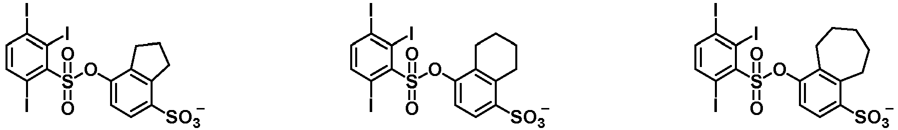

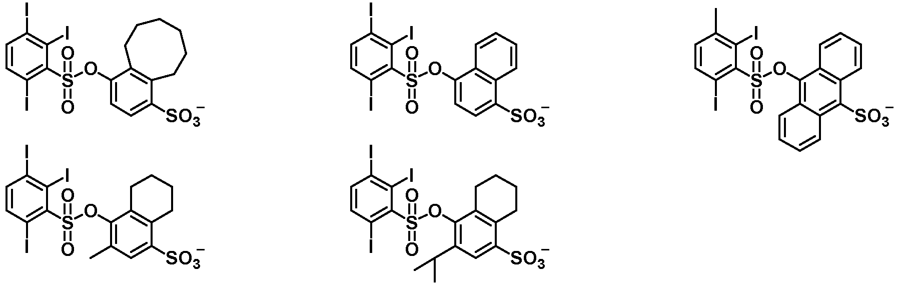

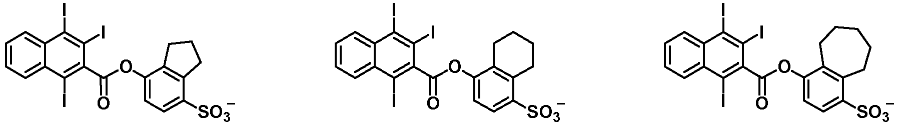

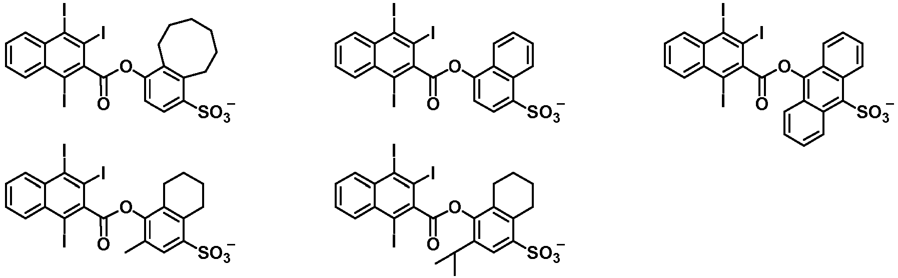

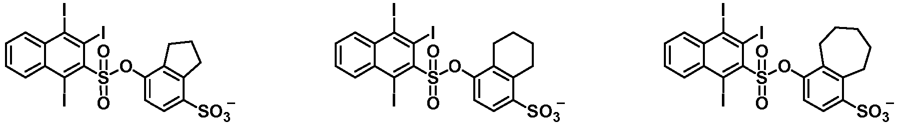

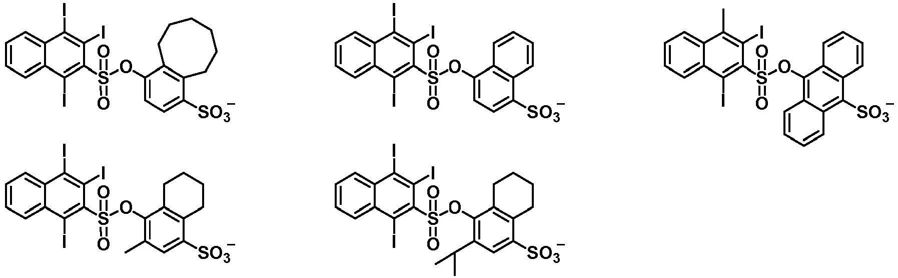

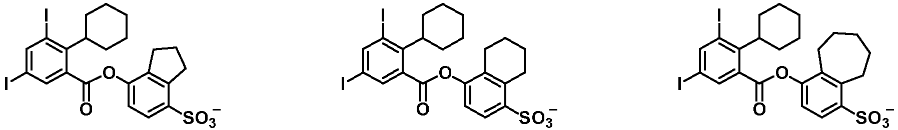

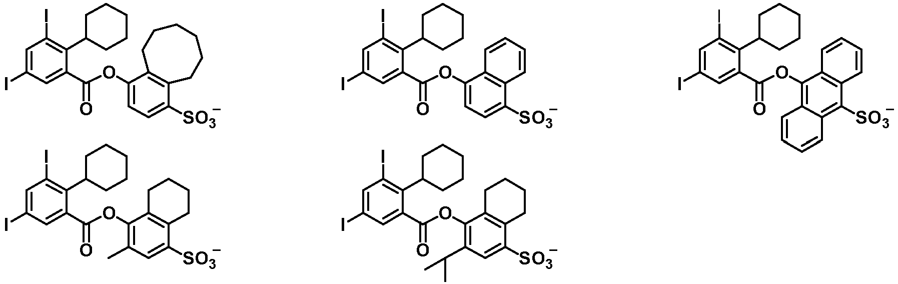

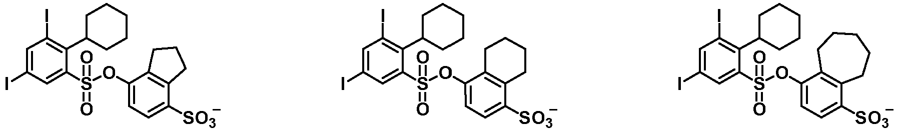

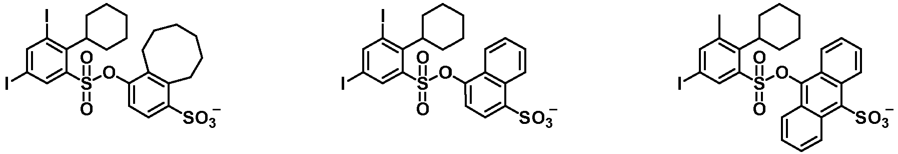

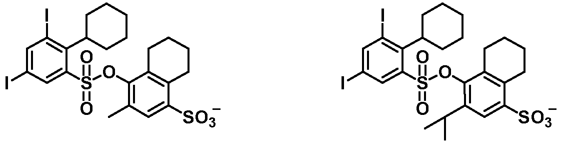

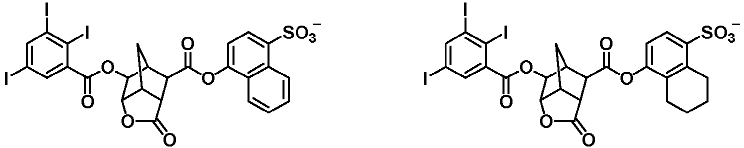

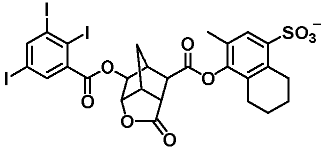

In formula (B), Z⁺ is an onium cation. The preferred onium cation is a sulfonium cation having the formula (cation-1) or iodonium cation having the formula (cation-2).

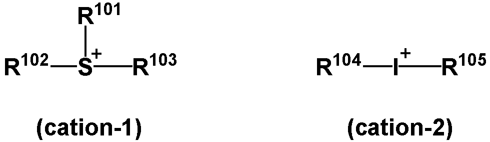

In formulae (cation-1) and (cation-2), R¹⁰¹ to R¹⁰⁵ are each independently halogen or a C₁-C₃₀ hydrocarbyl group which may contain a heteroatom.

Suitable halogen atoms include fluorine, chlorine, bromine, and iodine.

The hydrocarbyl group may be saturated or unsaturated and straight, branched or cyclic. Examples thereof include C₁-C₃₀ alkyl groups such as methyl, ethyl, n-propyl, isopropyl, n-butyl, isobutyl, sec-butyl, and tert-butyl; C₃-C₃₀ cyclic saturated hydrocarbyl groups such as cyclopropyl, cyclopentyl, cyclohexyl, cylopropylmethyl, 4-methylcyclohexyl, cyclohexylmethyl, norbornyl, and adamantyl; C₂-C₃₀ alkenyl groups such as vinyl, allyl, propenyl, butenyl, and hexenyl; C₃-C₃₀ cyclic unsaturated hydrocarbyl groups such as cyclohexenyl; C₆-C₃₀ aryl groups such as phenyl, naphthyl, and thienyl; C₇-C₃₀ aralkyl groups such as benzyl, 1-phenylethyl, and 2-phenylethyl, and combinations thereof. Of these, aryl groups are preferred. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, nitro moiety, fluorine, chlorine, bromine, iodine, carbonyl moiety, ether bond, ester bond, sulfonic ester bond, carbonate bond, lactone ring, sultone ring, carboxylic anhydride (-C(=O)-O-C(=O)-) or haloalkyl moiety.

Also, R¹⁰¹ and R¹⁰² may bond together to form a ring with the sulfur atom to which they are attached. Exemplary structures of the ring are shown below.

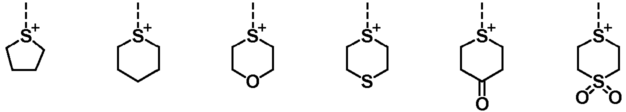

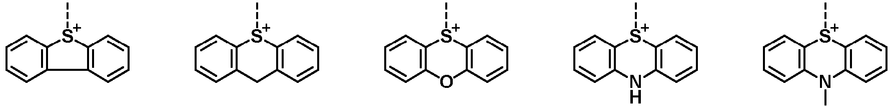

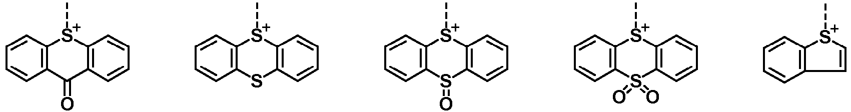

Herein the broken line designates a point of attachment to R¹⁰³.

Examples of the sulfonium cation having formula (cation-1) are shown below, but not limited thereto.

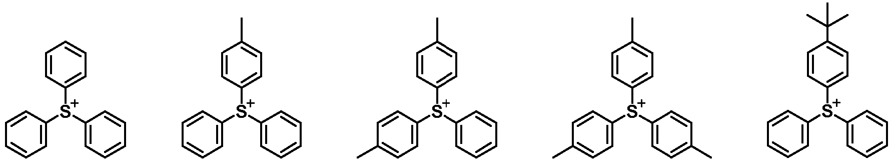

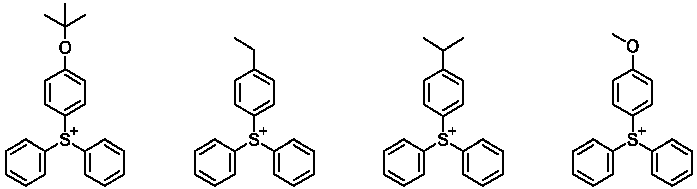

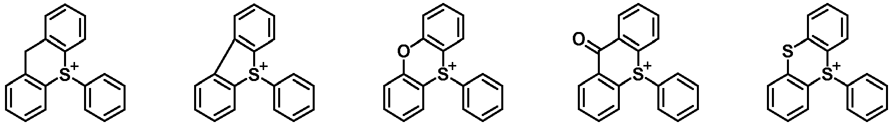

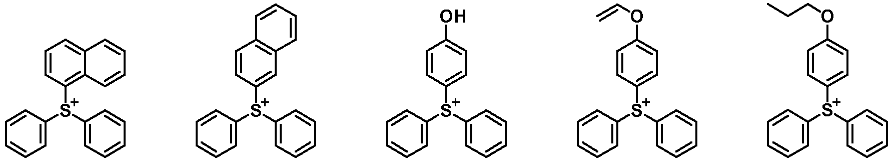

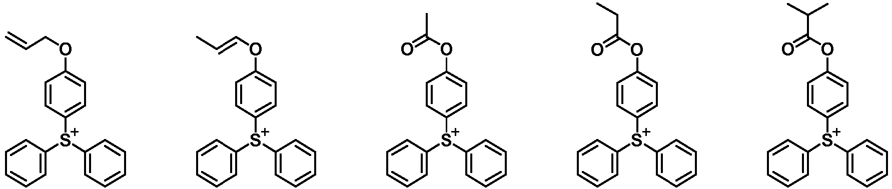

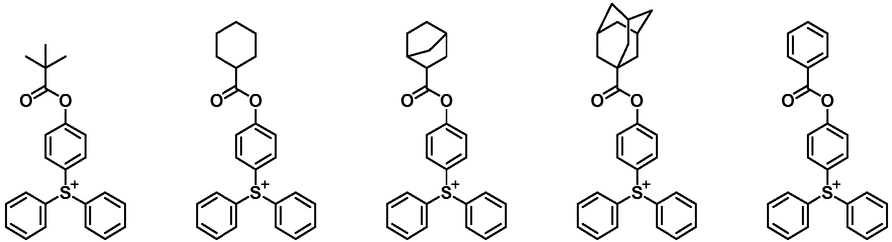

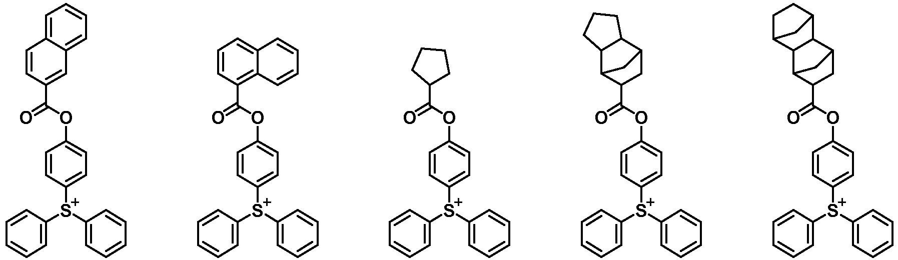

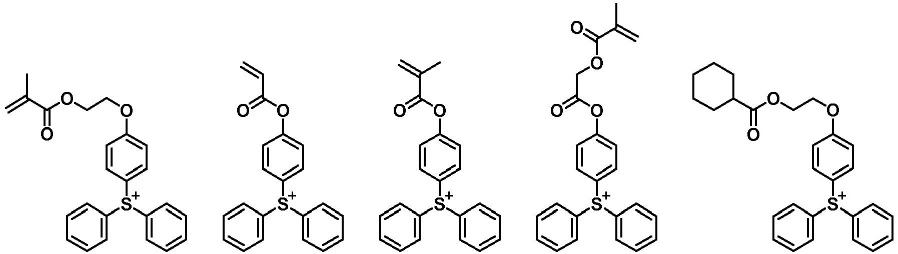

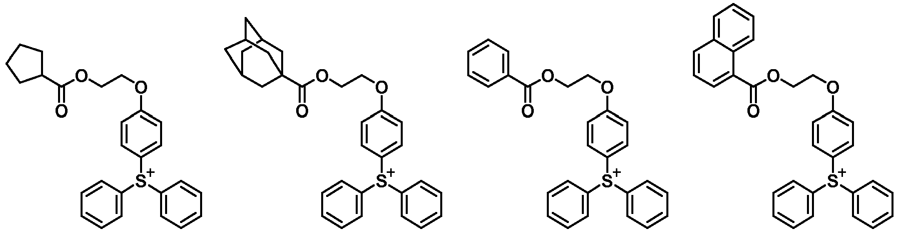

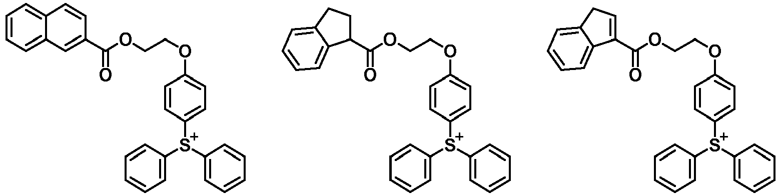

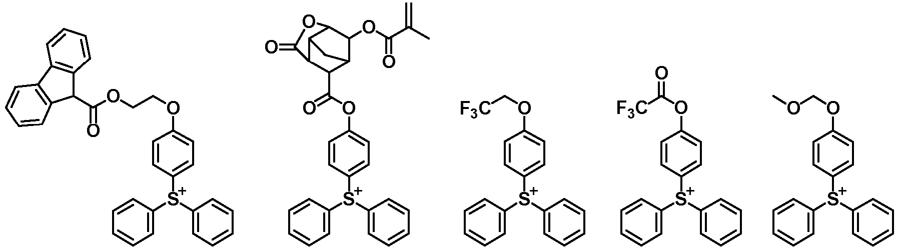

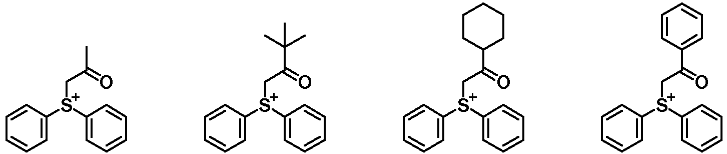

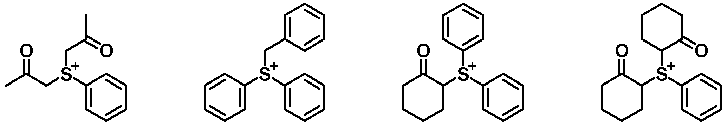

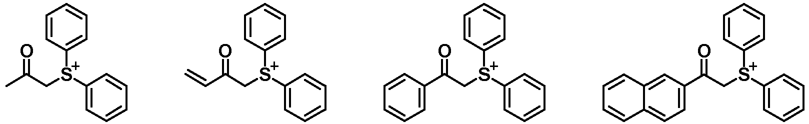

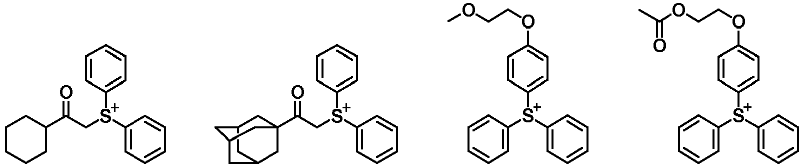

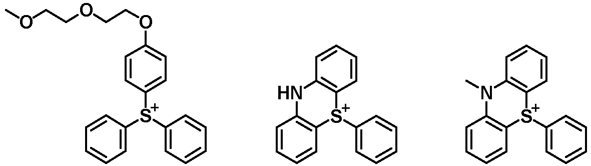

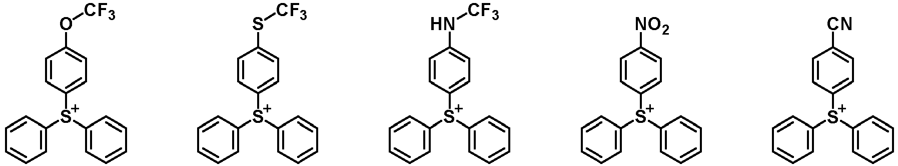

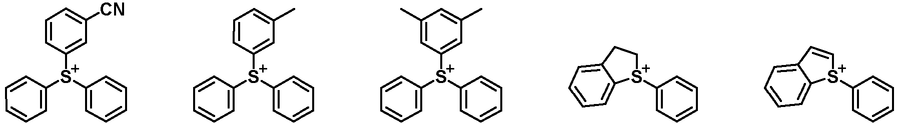

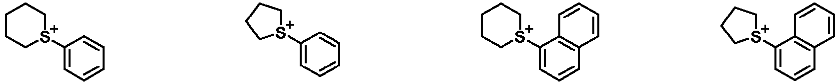

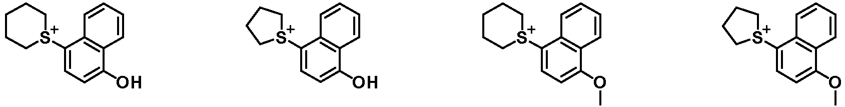

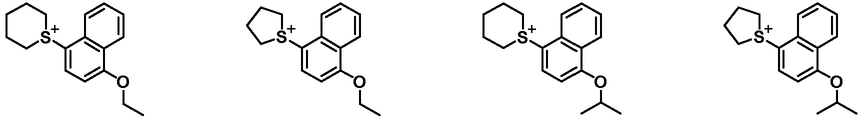

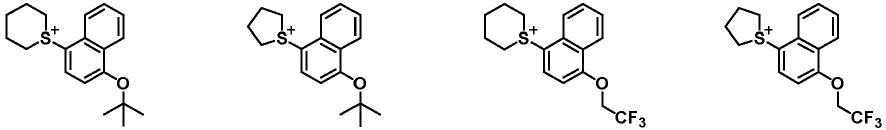

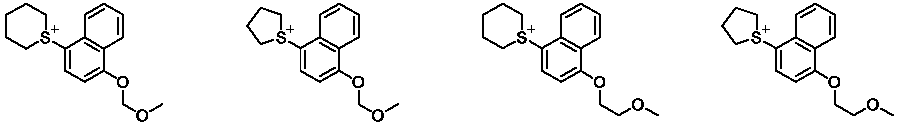

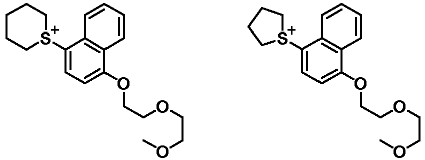

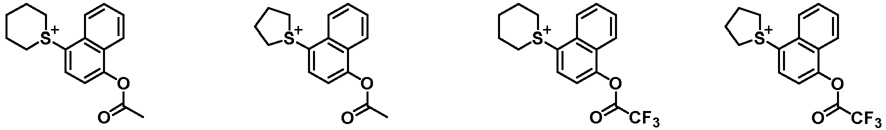

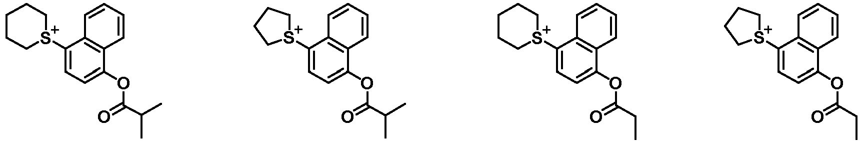

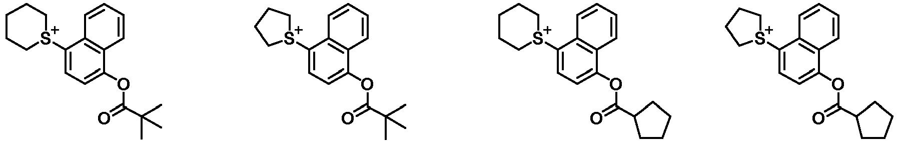

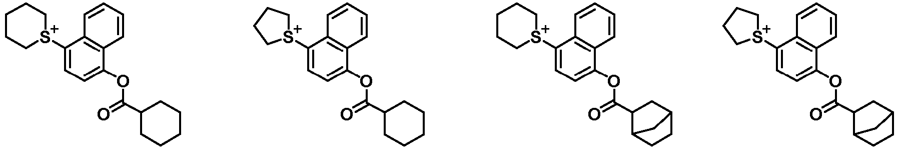

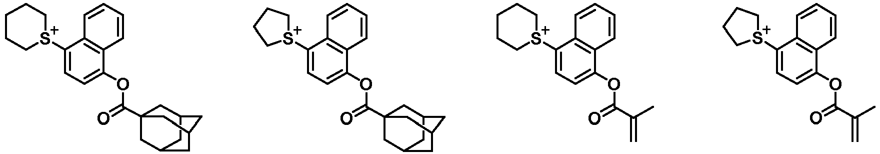

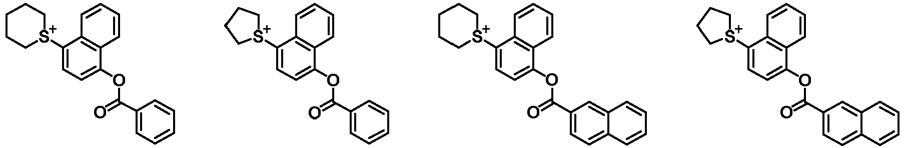

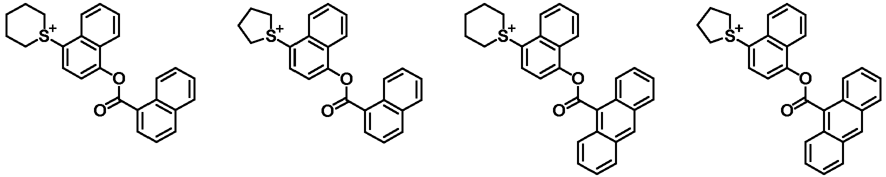

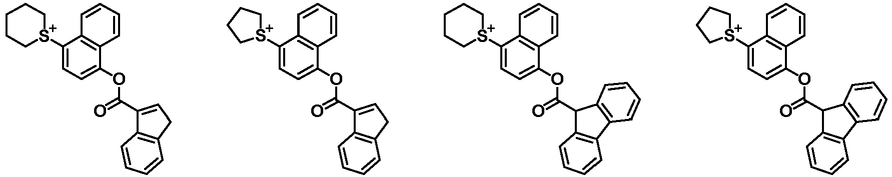

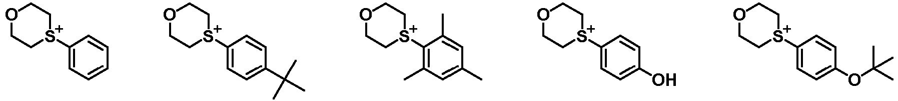

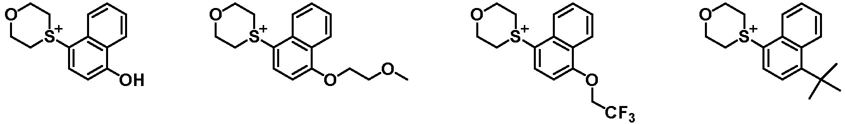

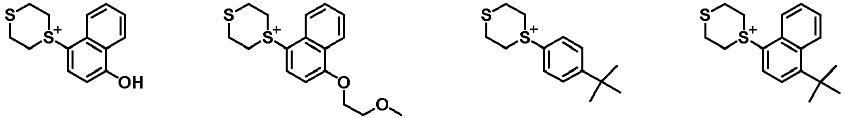

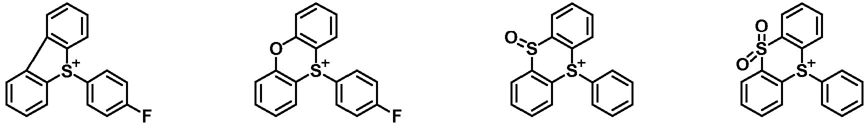

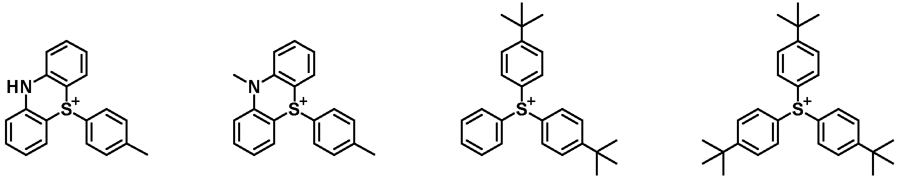

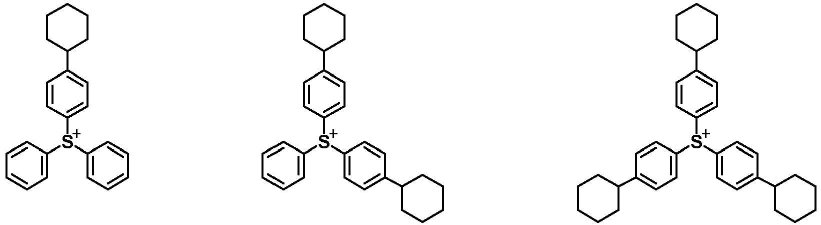

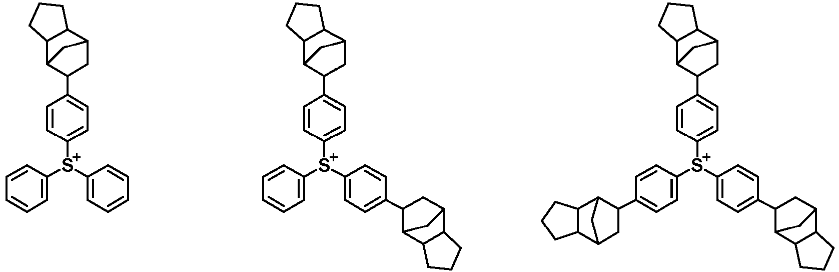

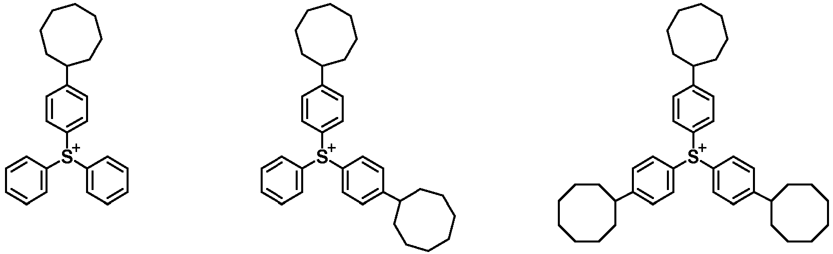

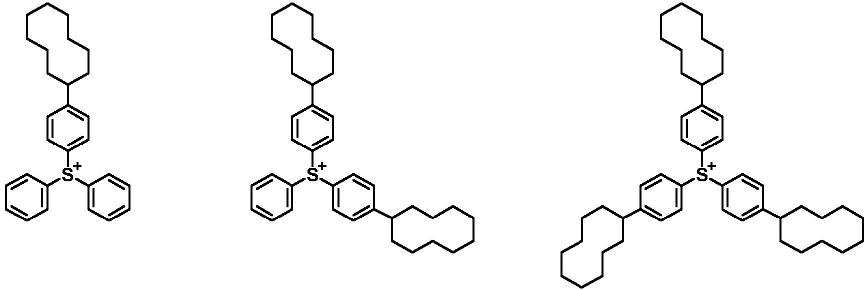

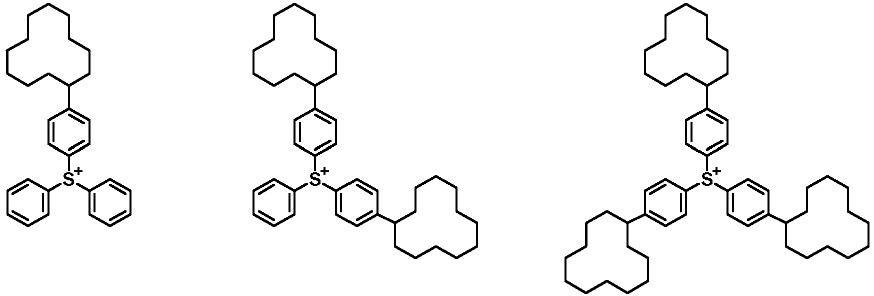

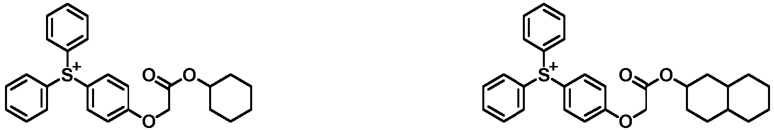

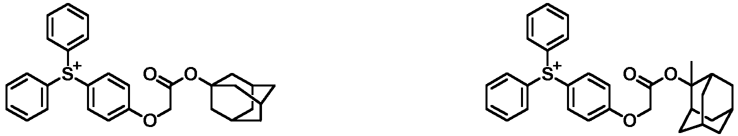

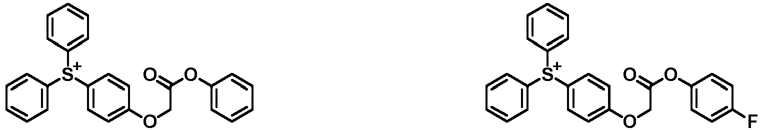

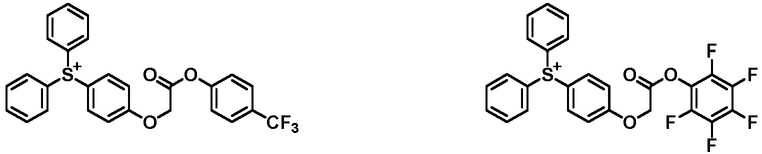

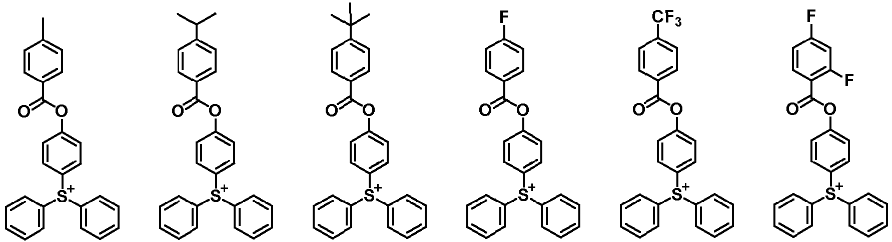

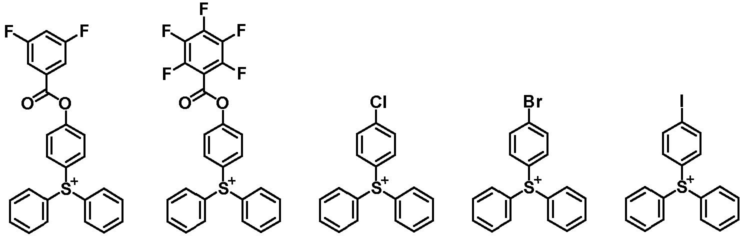

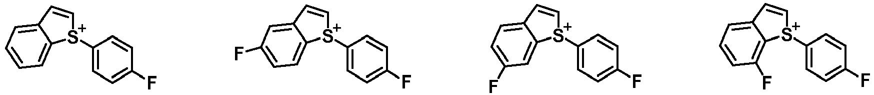

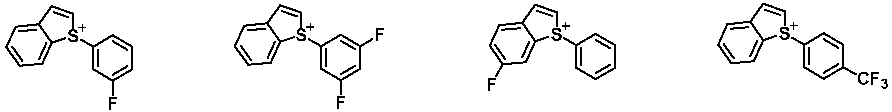

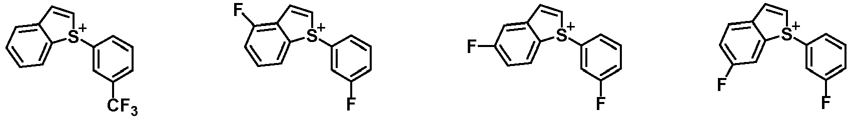

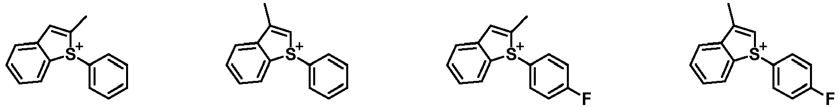

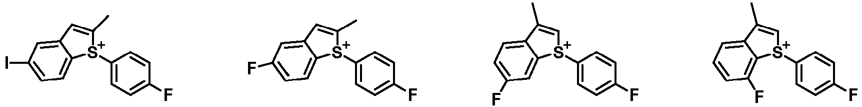

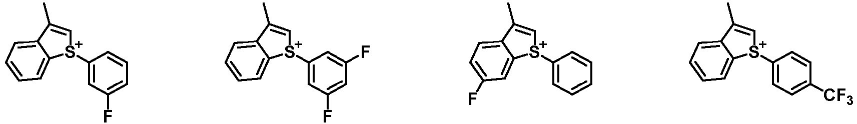

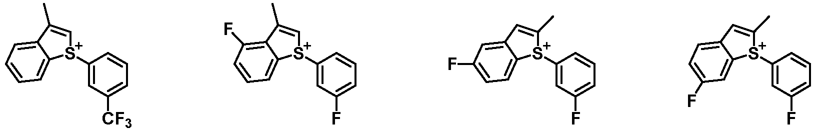

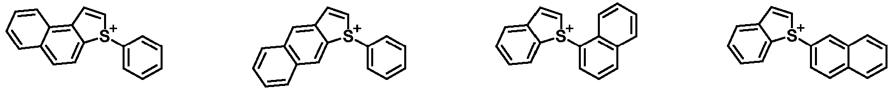

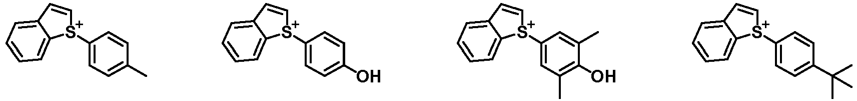

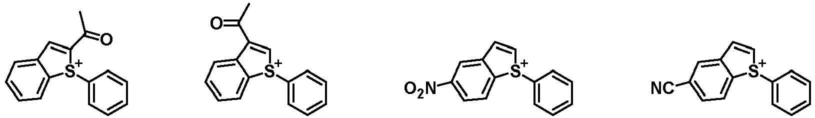

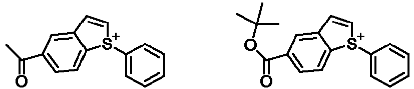

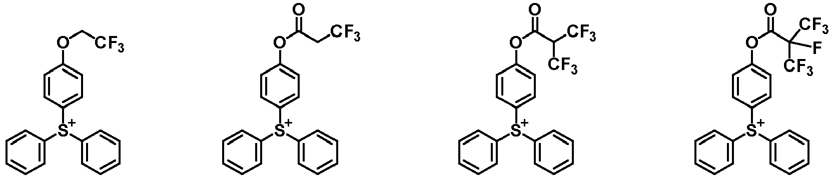

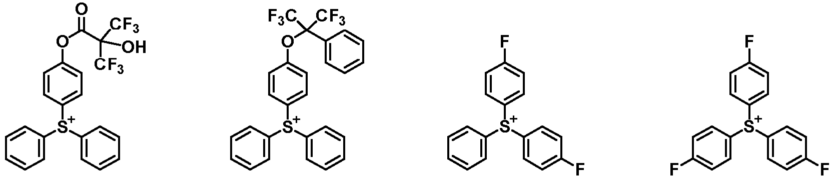

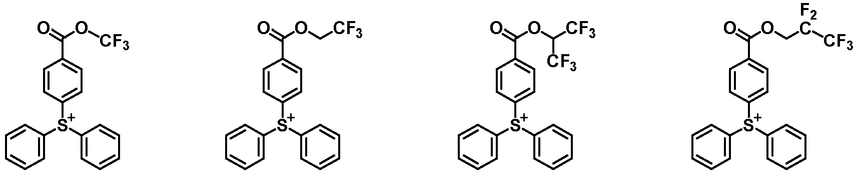

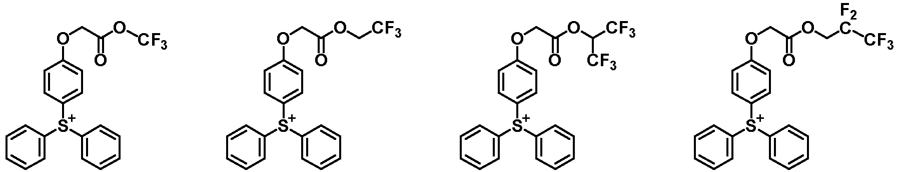

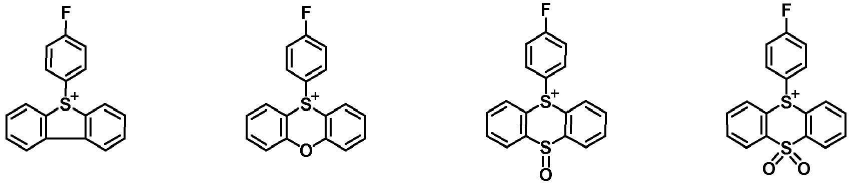

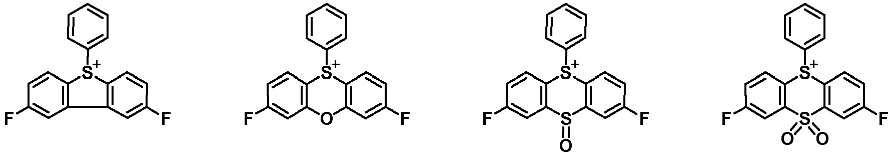

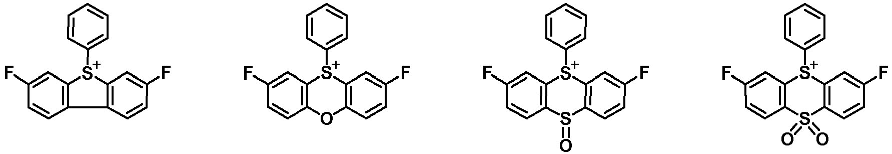

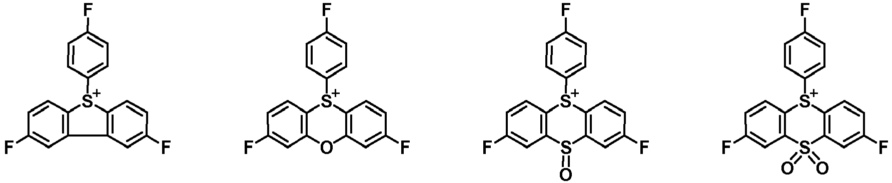

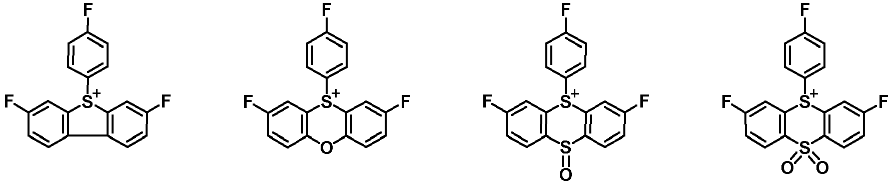

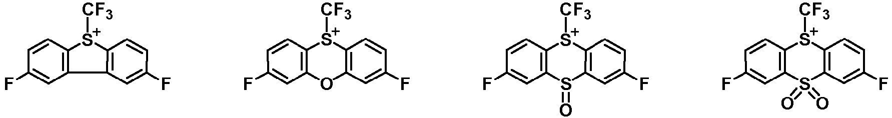

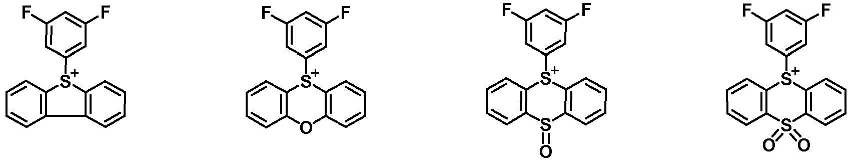

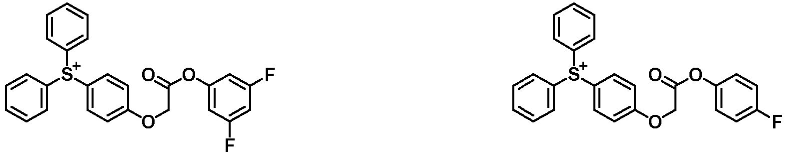

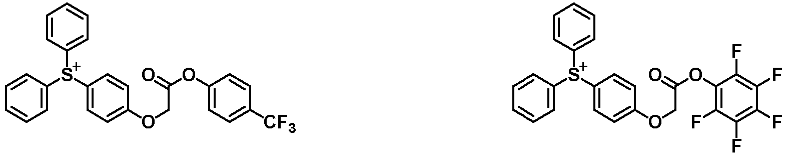

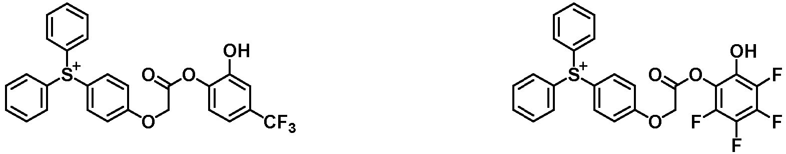

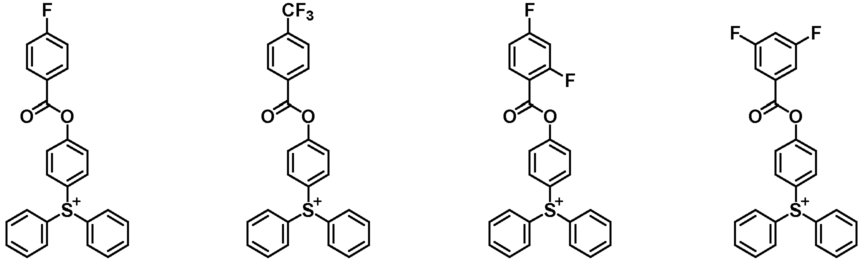

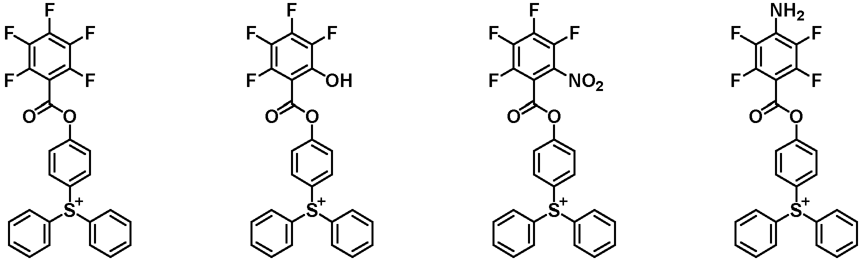

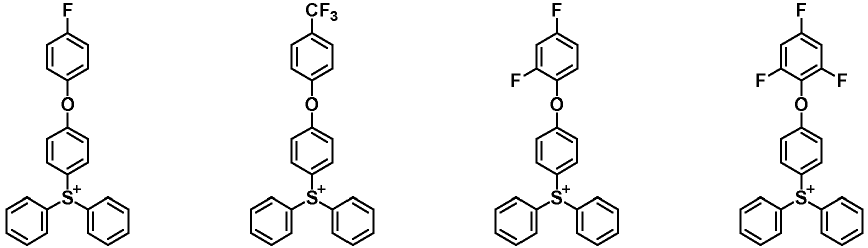

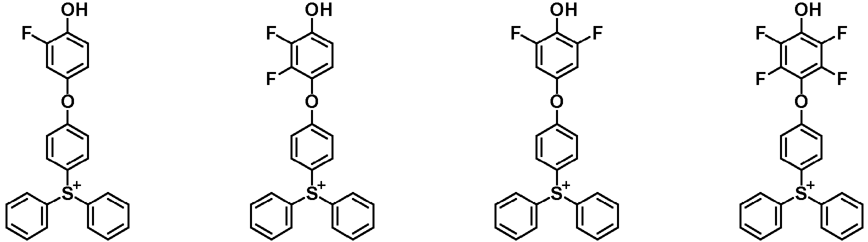

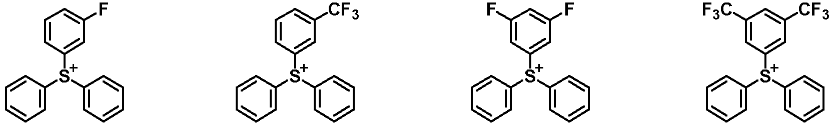

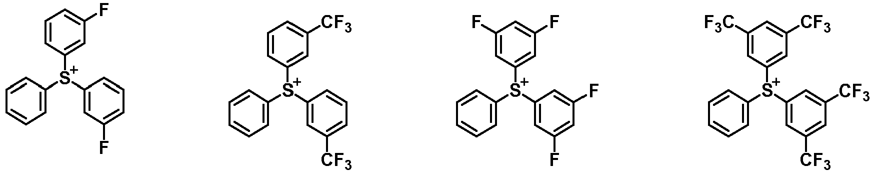

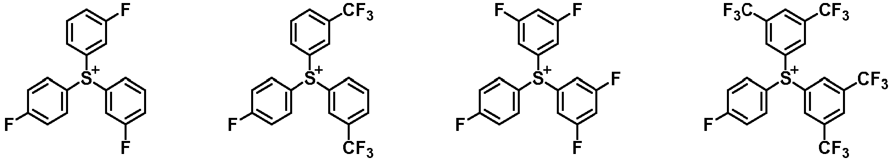

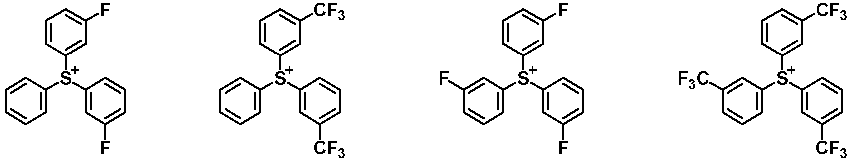

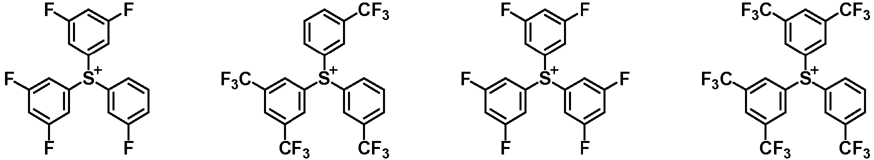

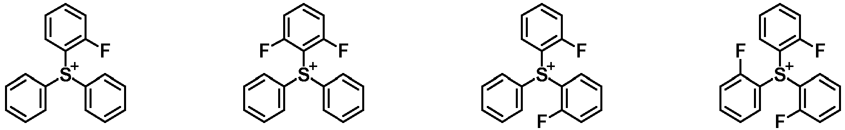

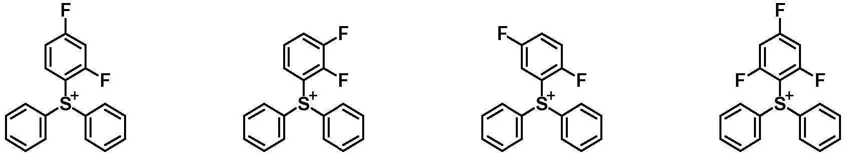

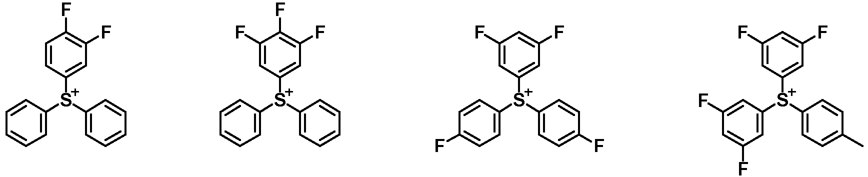

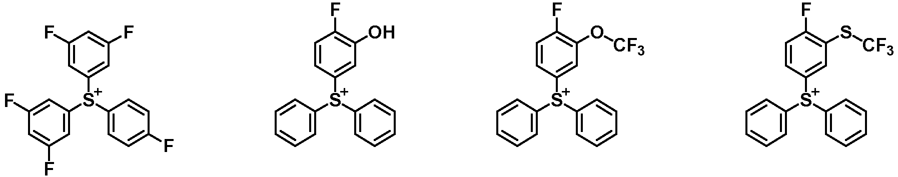

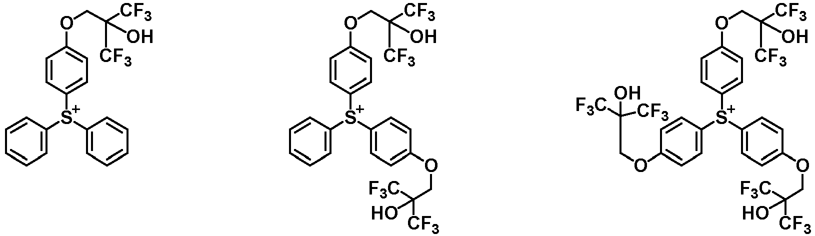

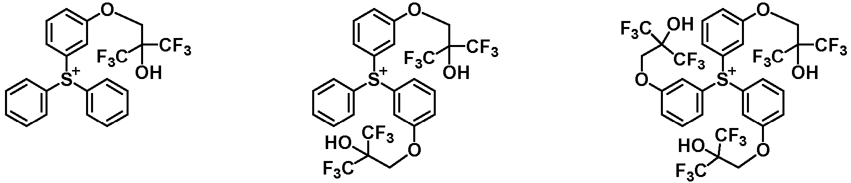

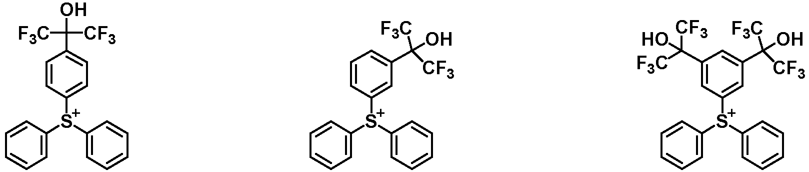

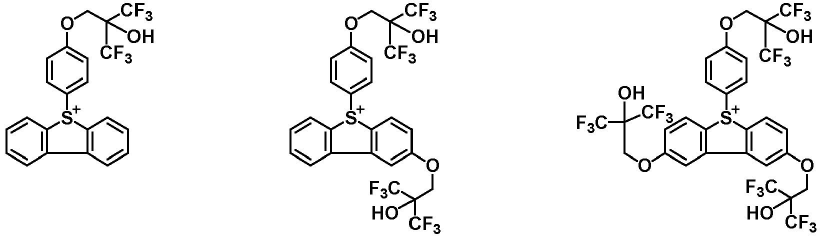

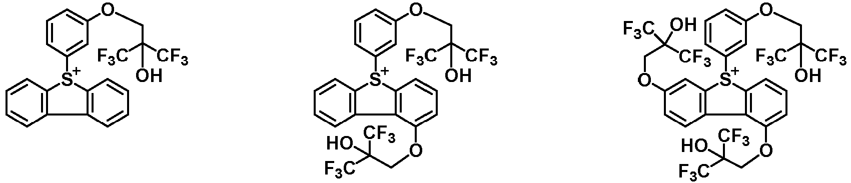

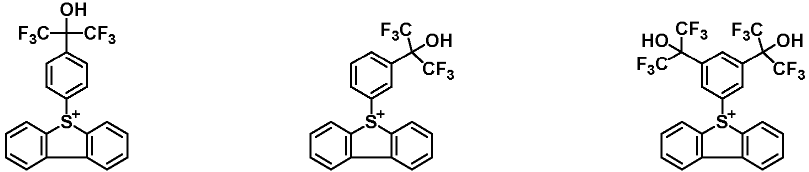

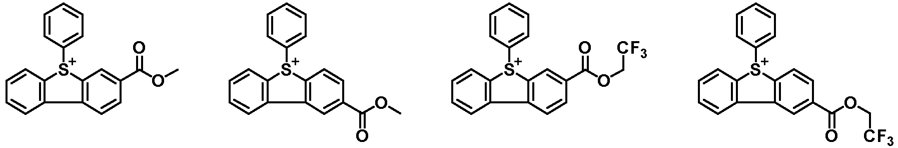

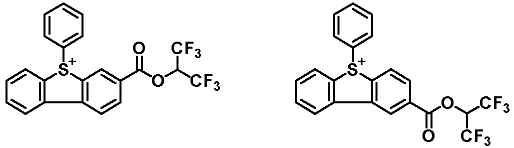

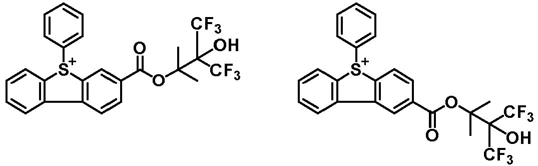

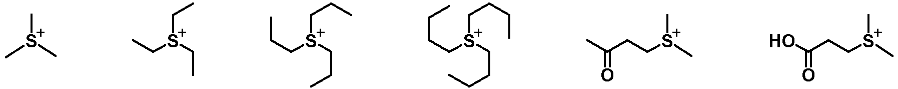

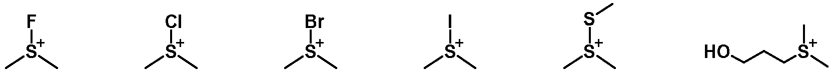

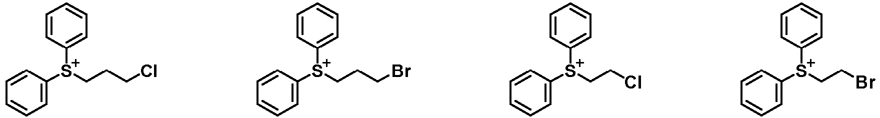

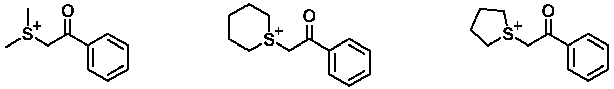

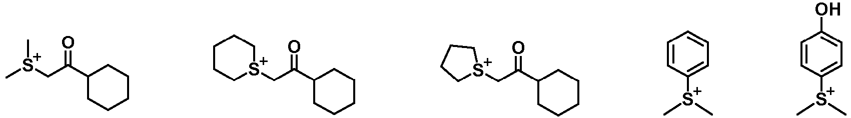

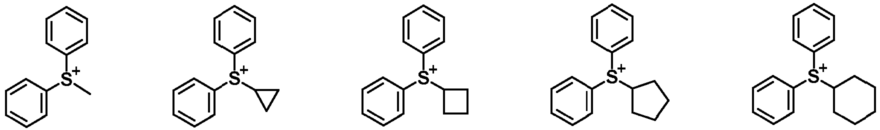

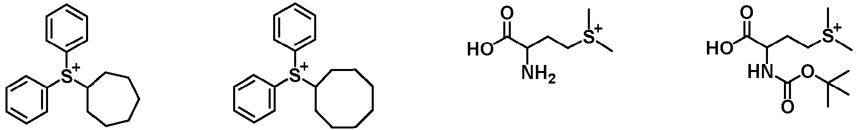

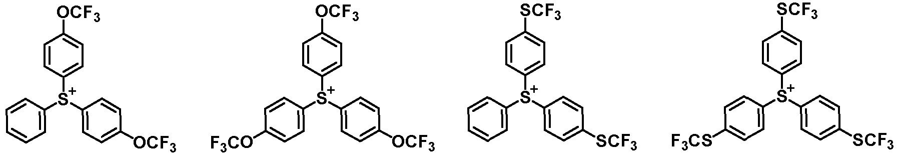

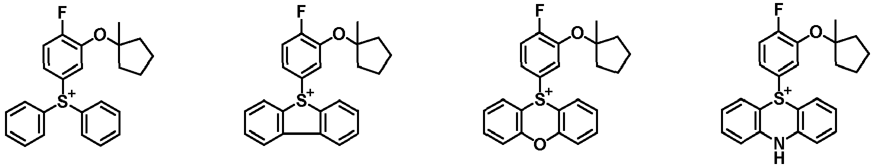

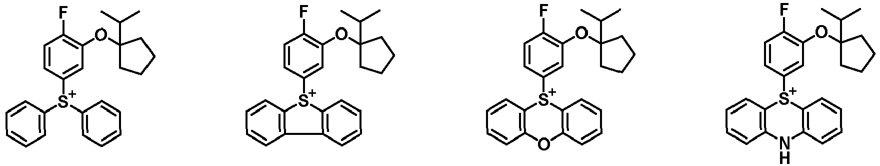

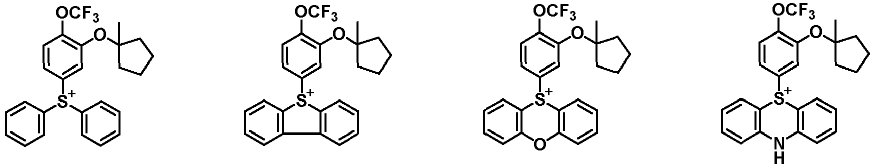

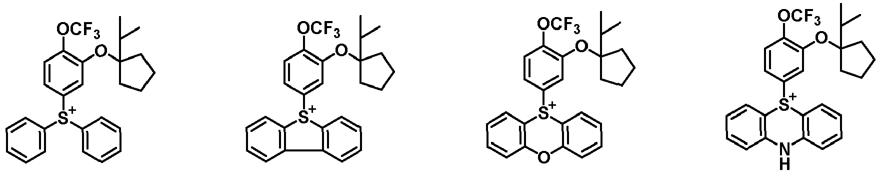

Examples of the iodonium cation having formula (cation-2) are shown below, but not limited thereto.

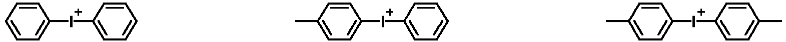

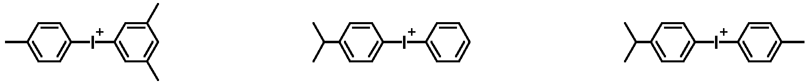

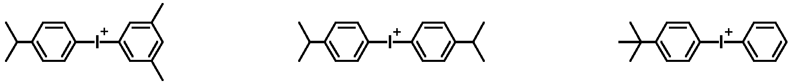

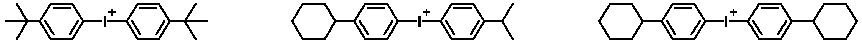

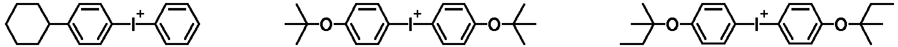

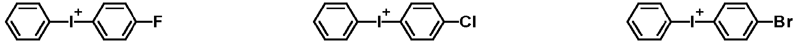

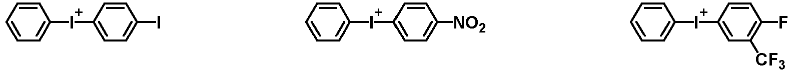

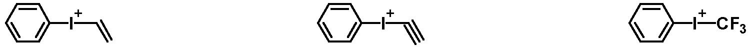

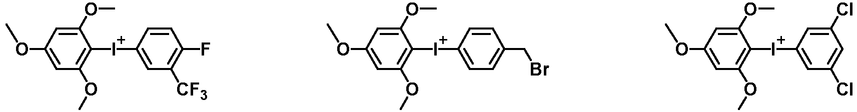

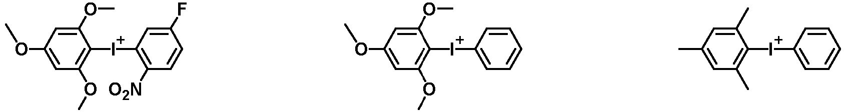

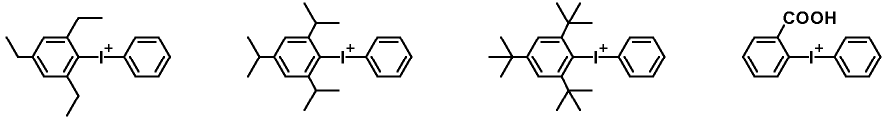

Examples of the PAG (B) include arbitrary combinations of the anion with the cation, both as exemplified above.

In the chemically amplified positive resist composition, the PAG (B) is preferably present in an amount of 0.1 to 20 parts by weight, more preferably 1 to 10 parts by weight per 80 parts by weight of the base polymer (A). An amount of PAG (B) in the range ensures storage stability and to form patterns of satisfactory profile because the acid is generated in an amount necessary to deprotect the acid labile group. The PAG may be used alone or in admixture.

In the resist composition, an acid generator other than the PAG (B), which is referred to as other acid generator, hereinafter, may be added for the purpose of correcting the profile of patterns. The other acid generator may be selected from well-known acid generators for resist compositions. The amount of the other acid generator is preferably 0 to 40 parts by weight, more preferably 0 to 30 parts by weight per 80 parts by weight of the base polymer (A) in view of sensitivity and acid diffusion-suppressing effect. The other acid generator may be used alone or in admixture.

### (C) Organic solvent

The chemically amplified positive resist composition further comprises an organic solvent as component (C). The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone and methyl-2-n-pentyl ketone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), ethyl lactate (EL), ethyl pyruvate, butyl acetate, methyl 3-methoxypropionate, ethyl 3-ethoxypropionate, tert-butyl acetate, tert-butyl propionate, and propylene glycol mono-tert-butyl ether acetate; and lactones such as γ-butyrolactone (GBL), and mixtures thereof. When an acid labile group of acetal type is used, a high-boiling alcohol solvent such as diethylene glycol, propylene glycol, glycerin, 1,4-butanediol or 1,3-butanediol may be added in order to accelerate the deprotection reaction of acetal.

Of the above organic solvents, it is recommended to use 1-ethoxy-2-propanol, PGMEA, PGME, cyclohexanone, EL, GBL, and mixtures thereof.

In the positive resist composition, the organic solvent (C) is preferably used in an amount of 200 to 10,000 parts, more preferably 400 to 5,000 parts by weight per 80 parts by weight of the base polymer (A). The organic solvent may be used alone or in admixture.

### (D) Quencher

The chemically amplified positive resist composition preferably comprises a quencher or acid diffusion inhibitor as component (D). The quencher is typically selected from conventional basic compounds. Conventional basic compounds include primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, and carbamate derivatives. Also included are primary, secondary, and tertiary amine compounds, specifically amine compounds having a hydroxy, ether bond, ester bond, lactone ring, cyano, or sulfonate ester group as described in JP-A 2008-111103, paragraphs [0146]-[0164], and compounds having a carbamate group as described in JP 3790649. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound may be effective for further suppressing the diffusion rate of acid in the resist film or correcting the pattern profile.

Onium salts such as sulfonium, iodonium and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. The α-non-fluorinated carboxylic acid functions as a quencher because it does not induce substantial deprotection reaction.

Examples of the onium salt of α-non-fluorinated carboxylic acid include compounds having the formula (D1).

**R²⁰¹-CO₂⁻ Mq_{A}⁺** **(D1)**

In formula (D1), R²⁰¹ is hydrogen or a C₁-C₄₀ hydrocarbyl group which may contain a heteroatom, exclusive of the hydrocarbyl group in which the hydrogen bonded to the carbon atom at α-position of the carboxy group is substituted by fluorine or fluoroalkyl.

The hydrocarbyl group R²⁰¹ may be saturated or unsaturated and straight, branched or cyclic. Examples thereof include C₁-C₄₀ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, and n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), di- or trialkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In the hydrocarbyl groups, some or all hydrogen may be substituted by a moiety containing a heteroatom such as oxygen, sulfur, nitrogen or halogen, and some -CH₂-may be replaced by a moiety containing a heteroatom such as oxygen, sulfur or nitrogen, so that the group may contain a hydroxy moiety, cyano moiety, carbonyl moiety, ether bond, thioether bond, ester bond, sulfonate ester bond, carbonate bond, lactone ring, sultone ring, carboxylic anhydride (-C(=O)-O-C(=O)-), or haloalkyl moiety. Suitable heteroatom-containing hydrocarbyl groups include heteroaryl groups such as thienyl; alkoxyphenyl groups such as 4-hydroxyphenyl, 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (D1), Mq_{A}⁺ is an onium cation. The onium cation is preferably selected from sulfonium, iodonium and ammonium cations, more preferably sulfonium and iodonium cations. Exemplary sulfonium cations are as exemplified above for the sulfonium cation having formula (cation-1). Exemplary iodonium cations are as exemplified above for the iodonium cation having formula (cation-2).

Examples of the anion in the onium salt having formula (D1) are shown below, but not limited thereto.

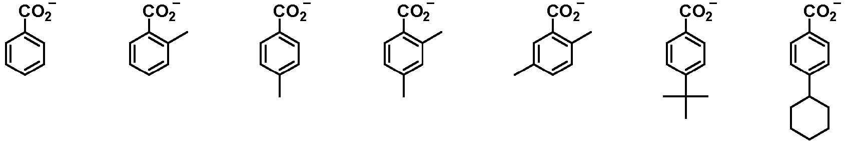

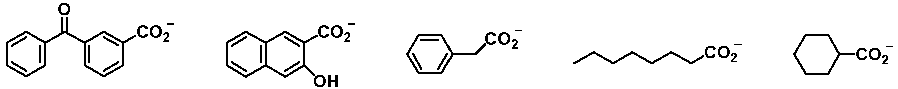

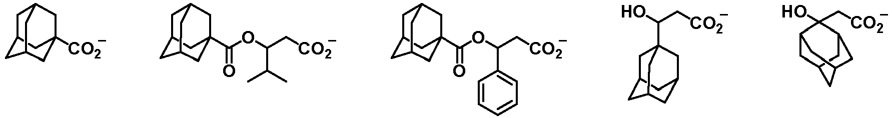

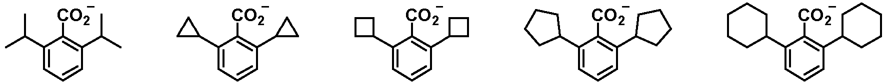

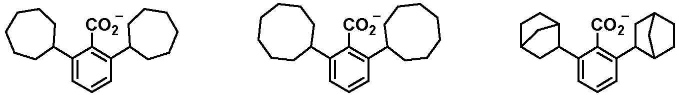

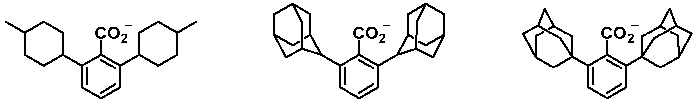

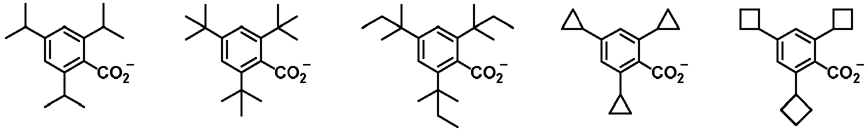

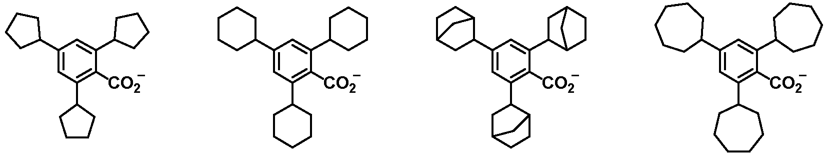

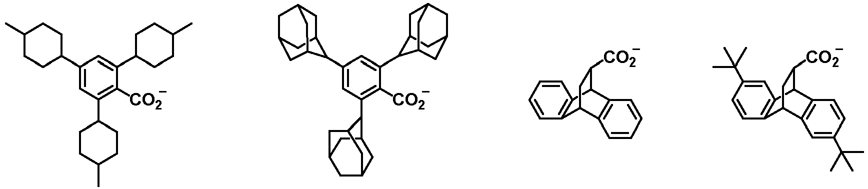

A sulfonium salt of iodized benzene ring-containing carboxylic acid having the formula (D2) is also useful as the quencher.

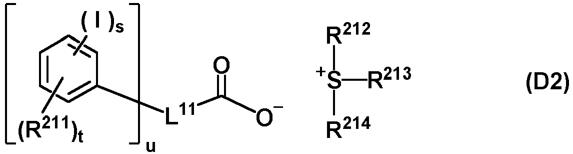

In formula (D2), s is an integer of 1 to 5, t is an integer of 0 to 3, s+t is from 1 to 5, and u is an integer of 1 to 3.

In formula (D2), R²¹¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy or C₁-C₄ saturated hydrocarbylsulfonyloxy group, in which some or all hydrogen may be substituted by halogen, or -N(R^{211A})-C(=O)-R^{211B}, or -N(R^{211A})-C(=O)-O-R^{211B}. R^{211A} is hydrogen or a C₁-C₆ saturated hydrocarbyl group. R^{211B} is a C₁-C₆ saturated hydrocarbyl or C₂-C₈ unsaturated aliphatic hydrocarbyl group. A plurality of R²¹¹ may be the same or different when t and/or u is 2 or 3.

In formula (D2), L¹¹ is a single bond or a C₁-C₂₀ (u+1)-valent linking group which may contain at least one moiety selected from ether bond, carbonyl moiety, ester bond, amide bond, sultone ring, lactam ring, carbonate bond, halogen, hydroxy moiety, and carboxy moiety. The saturated hydrocarbyl, saturated hydrocarbyloxy, saturated hydrocarbylcarbonyloxy, and saturated hydrocarbylsulfonyloxy groups may be straight, branched or cyclic.

In formula (D2), R²¹², R²¹³ and R²¹⁴ are each independently halogen, or a C₁-C₂₀ hydrocarbyl group which may contain a heteroatom. The hydrocarbyl group may be saturated or unsaturated and straight, branched or cyclic. Examples thereof include C₁-C₂₀ alkyl, C₂-C₂₀ alkenyl, C₆-C₂₀ aryl, and C₇-C₂₀ aralkyl groups. In these groups, some or all hydrogen may be substituted by hydroxy, carboxy, halogen, oxo, cyano, nitro, sultone ring, sulfo, or sulfonium salt-containing moiety, or some -CH₂- may be replaced by an ether bond, ester bond, carbonyl moiety, amide bond, carbonate bond or sulfonate ester bond. Also, R²¹² and R²¹³ may bond together to form a ring with the sulfur atom to which they are attached.

Examples of the compound having formula (D2) include those described in USP 10,295,904 (JP-A 2017-219836). These compounds exert a sensitizing effect due to remarkable absorption and an acid diffusion-controlling effect.

A nitrogen-containing carboxylic acid salt compound having the formula (D3) is also useful as the quencher.

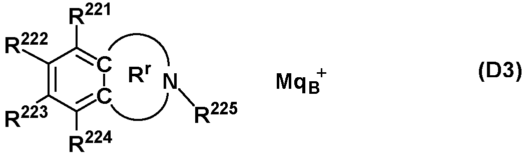

In formula (D3), R²²¹ to R²²⁴ are each independently hydrogen, -L¹²-CO₂⁻, or a C₁-C₂₀ hydrocarbyl group which may contain a heteroatom. R²²¹ and R²²², R²²² and R²²³, or R²²³ and R²²⁴ may bond together to form a ring with the carbon atom to which they are attached. L¹² is a single bond or a C₁-C₂₀ hydrocarbylene group which may contain a heteroatom. R²²⁵ is hydrogen or a C₁-C₂₀ hydrocarbyl group which may contain a heteroatom.

In formula (D3), the ring R^{r} is a C₂-C₆ ring containing the carbon and nitrogen atoms in the formula, in which some or all of the carbon-bonded hydrogen atoms may be substituted by a C₁-C₂₀ hydrocarbyl group or -L¹²-CO₂⁻ and in which some carbon may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (D3) has at least one -L¹²-CO₂⁻. That is, at least one of R²²¹ to R²²⁴ is -L¹²-CO₂⁻ , and/or at least one of hydrogen atoms bonded to carbon atoms in the ring R^{r} is substituted by -L¹²-CO₂⁻.

In formula (D3), Mq_{B}⁺ is a sulfonium, iodonium or ammonium cation, with the sulfonium cation being preferred. Examples of the sulfonium cation are as exemplified above for the sulfonium cation having formula (cation-1).

Examples of the anion in the compound having formula (D3) are shown below, but not limited thereto.

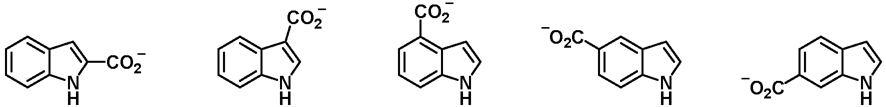

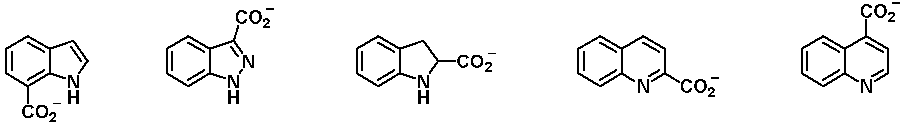

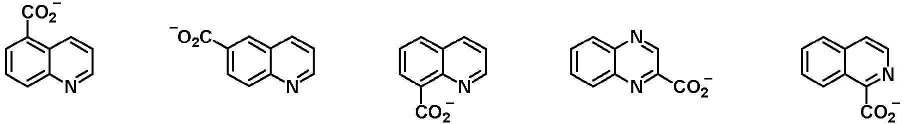

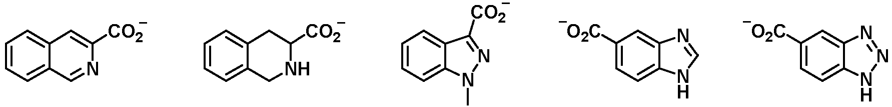

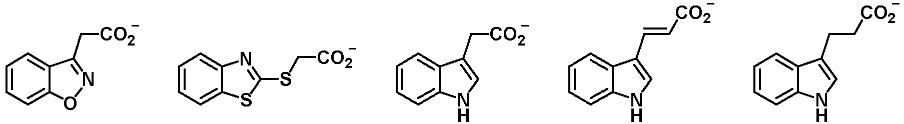

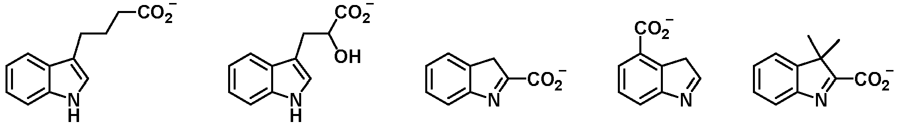

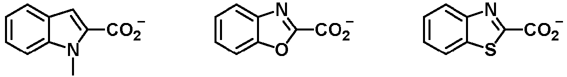

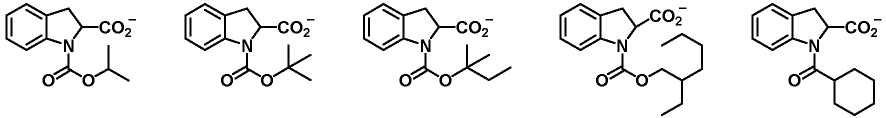

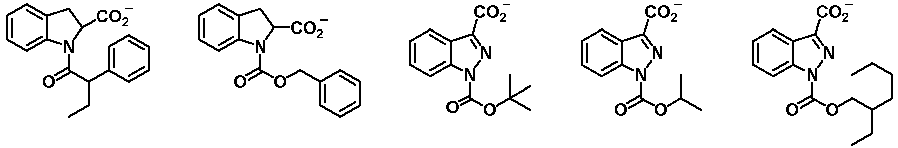

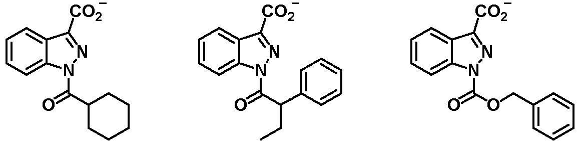

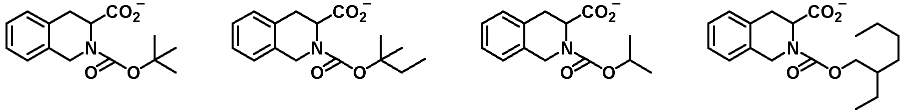

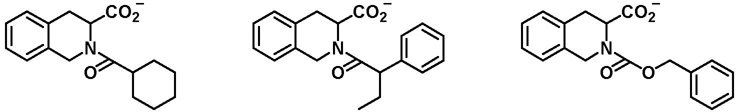

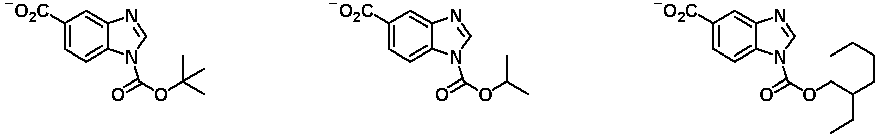

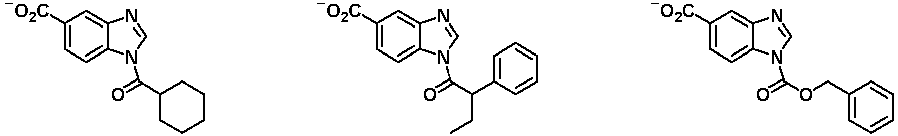

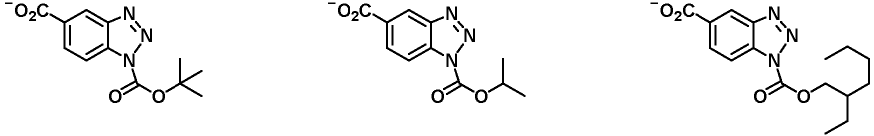

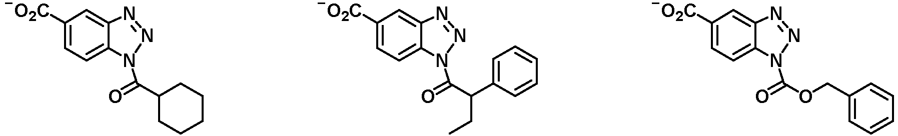

Weak acid betaine compounds are also useful as the quencher. Non-limiting examples thereof are shown below.

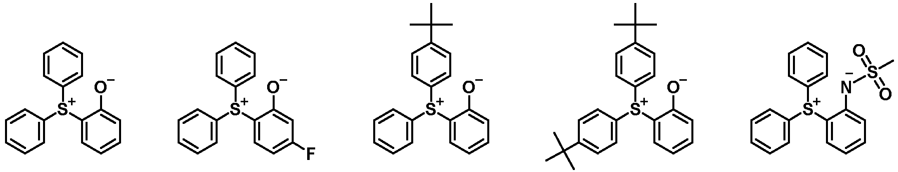

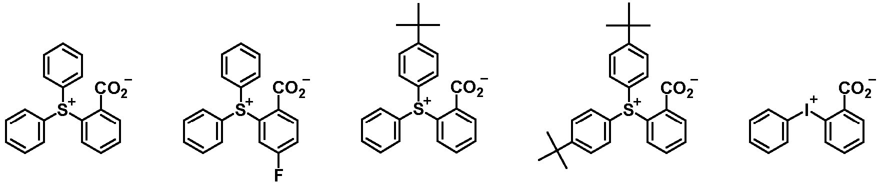

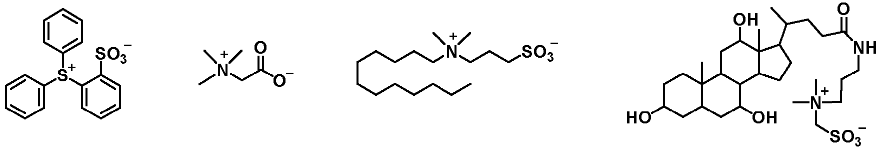

Also useful are quenchers of polymer type as described in USP 7,598,016 (JP-A 2008-239918). The polymeric quencher segregates at the resist surface after coating and thus enhances the rectangularity of resist pattern. When a protective film is applied as is often the case in the immersion lithography, the polymeric quencher is also effective for preventing a film thickness loss of resist pattern or rounding of pattern top.

When used, the quencher (D) is preferably added in an amount of 0 to 50 parts, more preferably 0.1 to 40 parts by weight per 80 parts by weight of the base polymer (A). The quencher may be used alone or in admixture.

When the chemically amplified positive resist composition contains both the PAG (B) and the quencher (D), the weight ratio of the PAG to the quencher, (B)/(D) is preferably less than 3/1, more preferably less than 2.5/1, even more preferably less than 2/1. As long as the weight ratio of the PAG to the quencher is in the range, the resist composition is able to fully suppress acid diffusion, leading to improved resolution and dimensional uniformity.

### (E) Fluorinated polymer

The chemically amplified positive resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (E1), repeat units having the formula (E2), repeat units having the formula (E3), and repeat units having the formula (E4). It is noted that repeat units having formulae (E1), (E2), (E3), and (E4) are also referred to as repeat units E1, E2, E3, and E4, respectively, hereinafter. Since the fluorinated polymer also has a surface active function, it can prevent insoluble residues from re-depositing onto the substrate during the development step and is thus effective for preventing development defects.

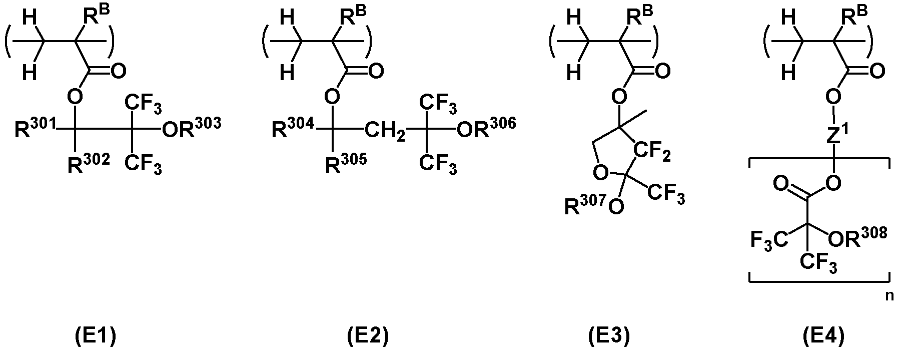

In formulae (E1) to (E4), R^{B} is each independently hydrogen, fluorine, methyl or trifluoromethyl. R³⁰¹, R³⁰², R³⁰⁴ and R³⁰⁵ are each independently hydrogen or a C₁-C₁₀ saturated hydrocarbyl group. R³⁰³, R³⁰⁶, R³⁰⁷ and R³⁰⁸ are each independently hydrogen, a C₁-C₁₅ hydrocarbyl group or fluorinated hydrocarbyl group, or an acid labile group. An ether bond or carbonyl moiety may intervene in a carbon-carbon bond in the hydrocarbyl groups or fluorinated hydrocarbyl groups represented by R³⁰³, R³⁰⁶, R³⁰⁷ and R³⁰⁸. Z¹ is a C₁-C₂₀ (n+1)-valent hydrocarbon group or C₁-C₂₀ (n+1)-valent fluorinated hydrocarbon group, and n is 1, 2 or 3.

The C₁-C₁₀ saturated hydrocarbyl group represented by R³⁰¹, R³⁰², R³⁰⁴ and R³⁰⁵ may be straight, branched or cyclic and examples thereof include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

The C₁-C₁₅ hydrocarbyl group represented by R³⁰³, R³⁰⁶, R³⁰⁷ and R³⁰⁸ may be straight, branched or cyclic and examples thereof include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

Examples of the C₁-C₂₀ (n+1)-valent hydrocarbon group Z¹ include the foregoing C₁-C₂₀ alkyl groups and C₃-C₂₀ cyclic saturated hydrocarbyl groups, with n number of hydrogen atoms being eliminated. Examples of the C₁-C₂₀ (n+1)-valent fluorinated hydrocarbon group Z¹ include the foregoing (n+1)-valent hydrocarbon groups in which at least one hydrogen atom is substituted by fluorine.

Examples of the repeat units E1 to E4 are given below, but not limited thereto. Herein R^{B} is as defined above.

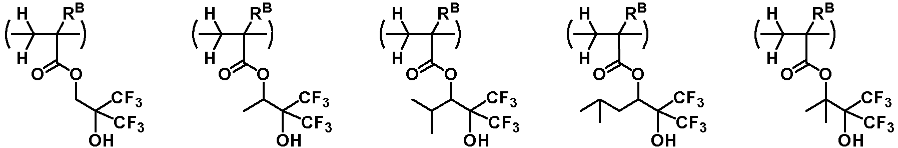

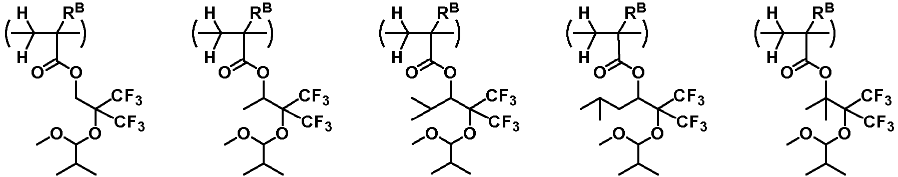

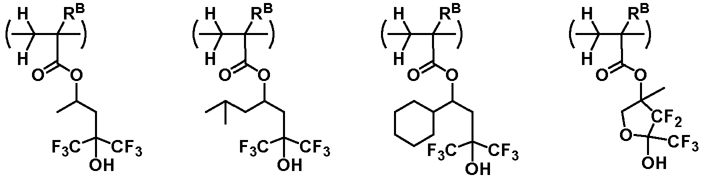

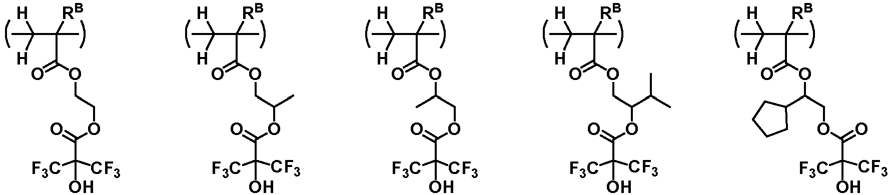

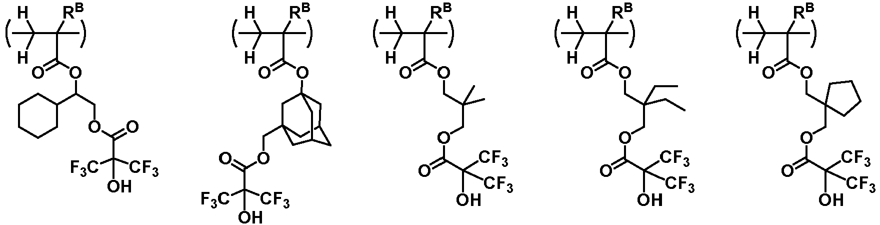

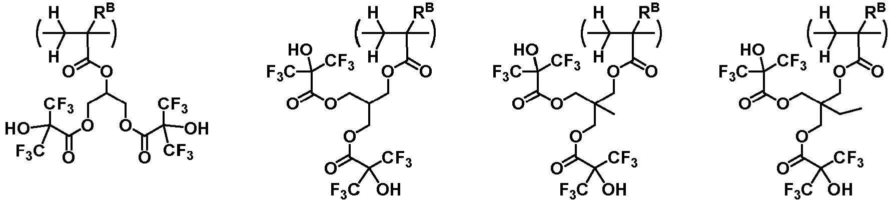

Preferably, the fluorinated polymer further contains repeat units of at least one type selected from repeat units having the formula (E5) and repeat units having the formula (E6). The repeat units having formulae (E5) and (E6) are also referred to as repeat units E5 and E6, respectively.

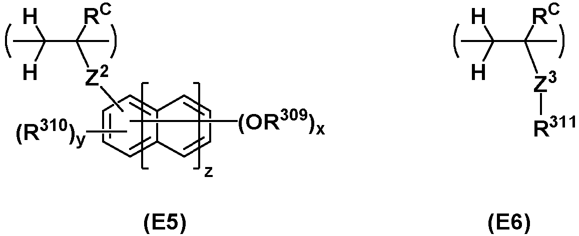

In formulae (E5) and (E6), R^{C} is each independently hydrogen or methyl. R³⁰⁹ is hydrogen or a C₁-C₅ straight or branched hydrocarbyl group in which a heteroatom-containing moiety may intervene in a carbon-carbon bond. R³¹⁰ is a C₁-C₅ straight or branched hydrocarbyl group in which a heteroatom-containing moiety may intervene in a carbon-carbon bond. R³¹¹ is a C₁-C₂₀ saturated hydrocarbyl group in which at least one hydrogen is substituted by fluorine and some constituent -CH₂- may be replaced by an ester bond or ether bond. The subscript x is 1, 2 or 3, y is an integer satisfying: 0 ≤ y ≤ 5+2z-x, and z is 0 or 1. Z² is a single bond, *-C(=O)-O- or *-C(=O)-NH-. Z³ is a single bond, -O-, *-C(=O)-O-Z³¹-Z³²- or *-C(=O)-NH-Z³¹-Z³²-. Z³¹ is a single bond or a C₁-C₁₀ saturated hydrocarbylene group, Z³² is a single bond, ester bond, ether bond or sulfonamide bond. The asterisk (*) designates a point of attachment to the carbon atom in the backbone.

Examples of the C₁-C₅ hydrocarbyl groups R³⁰⁹ and R³¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (E5), -OR³⁰⁹ is preferably a hydrophilic group. In this case, R³⁰⁹ is preferably hydrogen or a C₁-C₅ alkyl group in which oxygen intervenes in a carbon-carbon bond.

The C₁-C₂₀ saturated hydrocarbyl group in which at least one hydrogen is substituted by fluorine, represented by R³¹¹, may be straight, branched or cyclic. Examples thereof are C₁-C₂₀ alkyl groups and C₃-C₂₀ cyclic saturated hydrocarbyl groups in which at least one hydrogen atom is substituted by fluorine.

Z² is preferably *-C(=O)-O- or *-C(=O)-NH-. Also preferably R^{C} is methyl. The inclusion of carbonyl in Z² enhances the ability to trap the acid originating from the anti-charging film. A polymer wherein R^{C} is methyl is a robust polymer having a high glass transition temperature (Tg) which is effective for suppressing acid diffusion. As a result, the resist film is improved in stability with time, and neither resolution nor pattern profile is degraded.

The C₁-C₁₀ saturated hydrocarbylene group Z³ may be straight, branched or cyclic. Examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

Examples of the repeat unit E5 are given below, but not limited thereto. Herein R^{C} is as defined above.

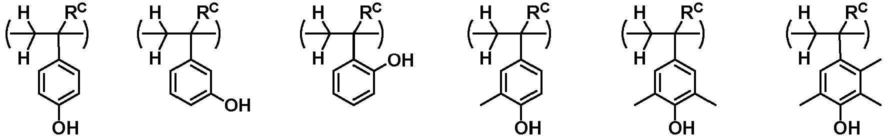

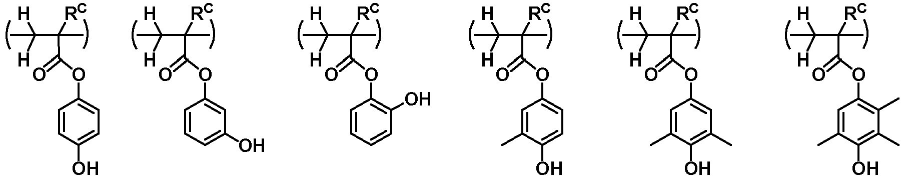

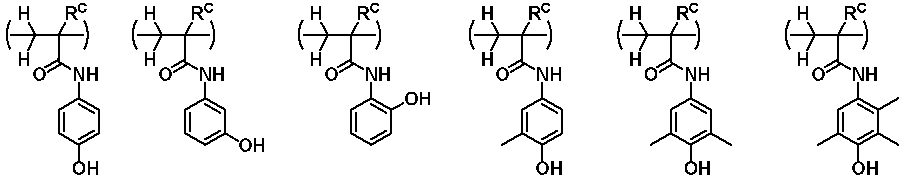

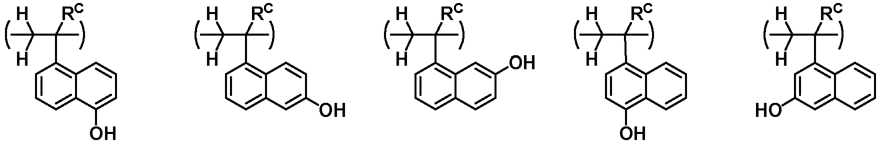

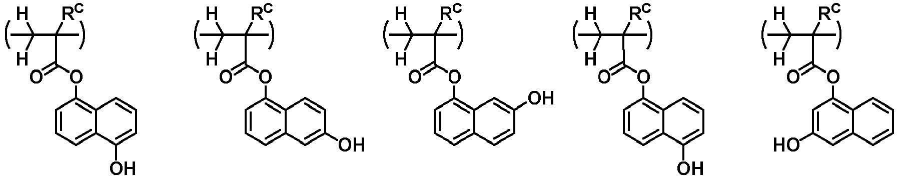

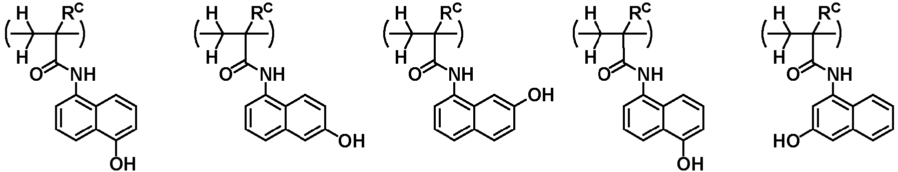

Examples of the repeat unit E6 are given below, but not limited thereto. Herein R^{C} is as defined above.

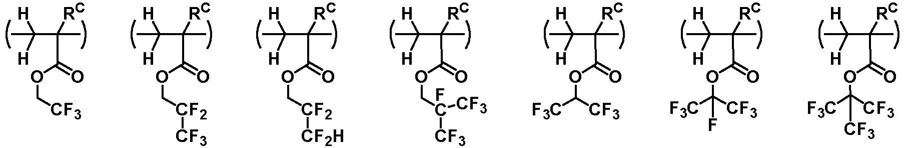

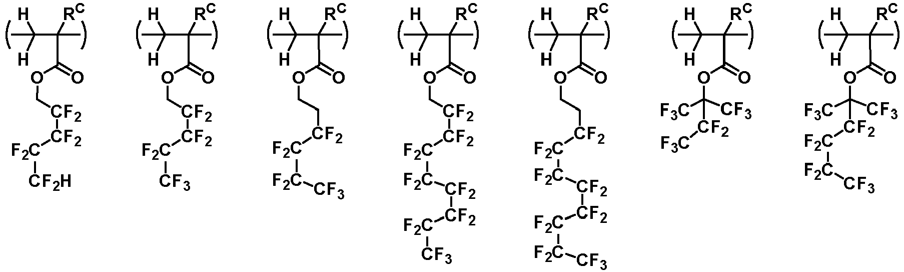

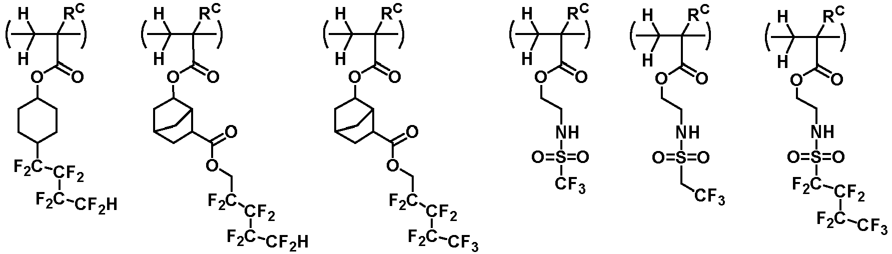

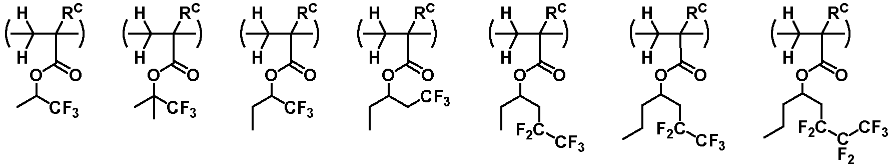

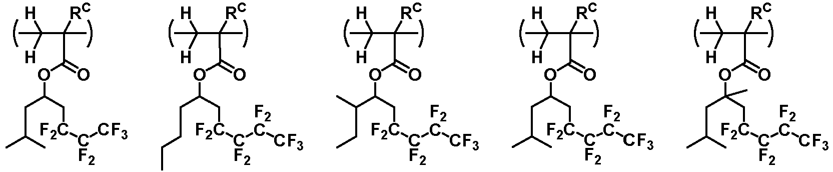

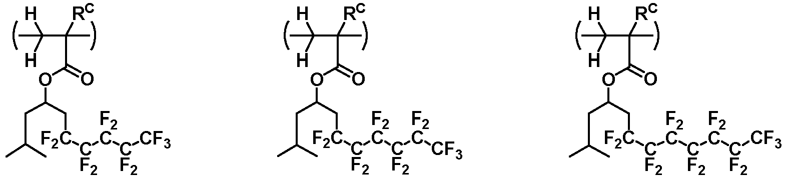

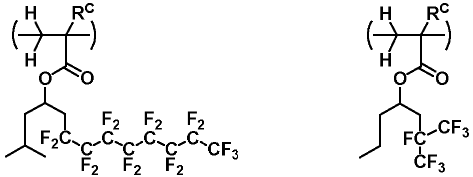

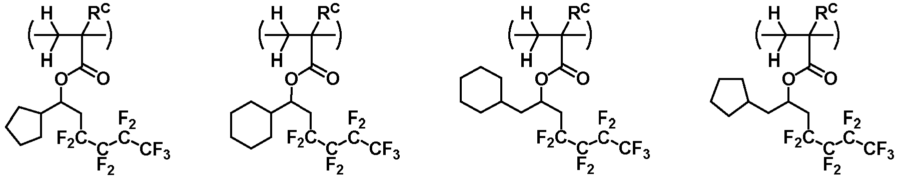

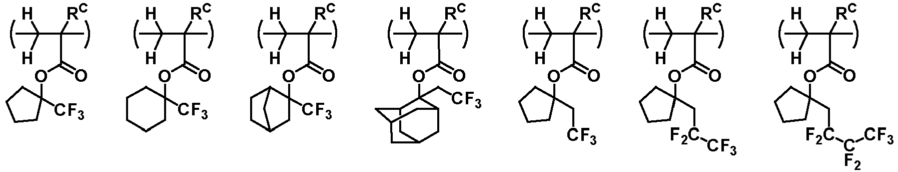

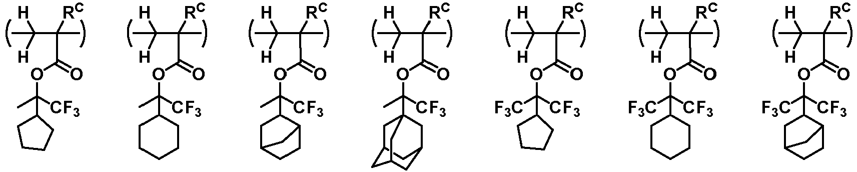

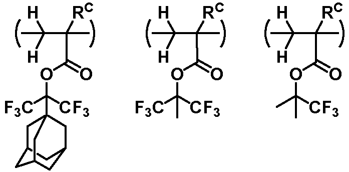

The content of repeat units E1 to E4 is preferably 15 to 95 mol%, more preferably 20 to 85 mol% based on the overall repeat units of the fluorinated polymer. The content of repeat unit E5 and/or E6 is preferably 5 to 85 mol%, more preferably 15 to 80 mol% based on the overall repeat units of the fluorinated polymer. Each of repeat units E1 to E6 may be used alone or in admixture.

The fluorinated polymer may comprise additional repeat units as well as the repeat units E1 to E6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the resist composition, the fluorinated polymer (E) is preferably used in an amount of 0.01 to 30 parts by weight, more preferably 0.1 to 20 parts by weight, even more preferably 0.5 to 10 parts by weight per 80 parts by weight of the base polymer (A). The fluorinated polymer may be used alone or in admixture.

### (F) Surfactant

The positive resist composition may contain any conventional surfactants for facilitating to coat the composition to the substrate. A number of surfactants are known in the art as described in JP-A 2004-115630, and any suitable one may be chosen therefrom. The amount of surfactant added is preferably 0 to 5 parts by weight per 80 parts by weight of the base polymer (A). It is noted that the surfactant need not be added when the positive resist composition contains a fluorinated polymer as mentioned above, which also plays the role of a surfactant.

The positive resist composition may be prepared by dissolving the base polymer and optionally other components in an organic solvent at the same time or in any desired order to form a uniform resist solution. The resist solution is preferably filtered. Using a filter of nylon or polyethylene for filtration, gel fractions and particles can be effectively removed from the resist solution. Also preferably, a filter having a pore size of up to 20 nm is used so that the quality of the resist solution may be maintained adequate for the lithography of the advanced generation.

The resist film formed from the chemically amplified positive resist composition in an unexposed region preferably has a dissolution rate in alkaline developer of up to 10 nm/min, more preferably up to 9 nm/min, even more preferably up to 8 nm/min. Where the resist film is in the thin film range of up to 100 nm, the influence of pattern film thickness loss in alkaline developer becomes greater. When the dissolution rate in unexposed region is no more than 10 nm/min, pattern collapse does not occur, succeeding in forming a small-size pattern. This becomes outstanding in the fabrication of photomasks requiring to be defectless and having a tendency of strong development process. It is noted that the dissolution rate of an unexposed region is computed by spin coating the positive resist composition onto a 150-mm (6-inch) silicon wafer, baking at 110°C for 240 seconds to form a resist film of 80 nm thick, developing the film in a 2.38 wt% TMAH aqueous solution at 23°C for 80 seconds, and measuring a loss of film thickness.

From the standpoint of improving the develop loading effect, the positive resist composition is preferably designed such that a resist film formed therefrom in an exposed region may have a dissolution rate in alkaline developer of at least 50 nm/sec, more preferably at least 80 nm/sec. As long as the dissolution rate is at least 50 nm/sec, the resist film is uniformly dissolved in alkaline developer independent of a pattern layout difference in the case of a grouped/isolated pattern, and the variation of line width can be minimized. It is noted that the dissolution rate of an exposed region is computed by spin coating the positive resist composition onto a 200-mm (8-inch) silicon wafer, baking at 110°C for 60 seconds to form a resist film of 90 nm thick, exposing the resist film to KrF excimer laser radiation in a sufficient energy dose to complete deprotection reaction on the polymer, baking at 110°C for 60 seconds, developing the film in a 2.38 wt% TMAH aqueous solution at 23°C, and measuring a loss of film thickness by means of a resist development analyzer.

### Pattern forming process

A still further embodiment of the invention is a process for forming a resist pattern comprising the steps of applying the chemically amplified positive resist composition onto a substrate to form a resist film thereon, exposing patternwise the resist film to high-energy radiation, and developing the exposed resist film in an alkaline developer.

The resist composition is first applied onto a substrate on which an integrated circuit is to be formed (e.g., Si, SiO, SiO₂, SiN, SiON, TiN, WSi, BPSG, SOG, or organic antireflective coating) or a substrate on which a mask circuit is to be formed (e.g., Cr, CrO, CrON, MoSi₂, Si, SiO, SiO₂, SiON, SiONC, CoTa, NiTa, TaBN, or SnO₂) by a suitable coating technique such as spin coating. The coating is prebaked on a hot plate at a temperature of preferably 60 to 150°C for 1 to 20 minutes, more preferably at 80 to 140°C for 1 to 10 minutes. The resulting resist film is generally 0.03 to 2 µm thick.

The resist film is then exposed to a desired pattern of high-energy radiation such as excimer laser radiation (e.g., KrF or ArF), EUV of wavelength 3 to 15 nm, or EB. Exposure using EB is preferred. For forming the desired pattern, EB is preferably irradiated so as to give a dose of 50 to 400 µC/cm². Since the polymer containing acetal acid labile groups is also effective for suppressing the influence of back scattering during EB image writing, the resist composition avoids the pattern profile from being inversely tapered in a sensitivity region of at least 50 µC/cm², preferably at least 80 µC/cm², more preferably at least 100 µC/cm² and displays excellent rectangular performance.

The exposure may be performed by conventional lithography whereas the immersion lithography of holding a liquid, typically water between the resist film and the mask may be employed if desired. In the case of immersion lithography, a protective film which is insoluble in water may be formed on the resist film.

After the exposure, the resist film may be baked (PEB) on a hotplate preferably at 60 to 150°C for 1 to 20 minutes, more preferably at 80 to 140°C for 1 to 10 minutes.

After the exposure or PEB, the resist film is developed in a developer in the form of an aqueous alkaline solution for preferably 0.1 to 3 minutes, more preferably 0.5 to 2 minutes by conventional techniques such as dip, puddle and spray techniques. A typical developer is a 0.1 to 5 wt%, preferably 2 to 3 wt% aqueous solution of tetramethylammonium hydroxide (TMAH) or another alkali. In this way, the desired pattern is formed on the substrate.

From the positive resist composition, a pattern with a satisfactory isolated-space resolution and reduced LER can be formed. The resist composition is effectively applicable to a substrate, specifically a substrate having a surface layer of material to which a resist film is less adherent and which is likely to invite pattern stripping or pattern collapse. A typical substrate has an outermost surface of a material containing at least one element selected from chromium, silicon, tantalum, molybdenum, cobalt, nickel, tungsten, and tin. Preferred are substrates having sputter deposited on their outermost surface metallic chromium or a chromium compound containing at least one light element selected from oxygen, nitrogen and carbon and substrates having an outermost surface layer of SiO, SiOₓ, or a tantalum compound, molybdenum compound, cobalt compound, nickel compound, tungsten compound or tin compound. The substrate to which the positive resist composition is applied is most typically a photomask blank which may be either of transmission or reflection type. A mask blank of transmission or reflection type which is coated with the chemically amplified positive resist composition is also contemplated herein.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

The resist pattern forming process is successful in forming patterns having a high resolution, suppressed influences of develop loading and residue defects, and a small size difference independent of pattern density (grouped and isolated patterns), even on a substrate (typically mask blank of transmission or reflection type) whose outermost surface is made of a material tending to affect resist pattern profile such as a chromium, silicon or tantalum-containing material.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards.

### [1] Synthesis of polymers

### Synthesis Example 1

### Synthesis of Polymer P-1

### (1) Synthesis of poly(p-tert-butoxycarbonyloxystyrene)

A 2-L flask was charged with 1,200 ml of THF solvent and 0.005 mol of n-butyllithium as a polymerization initiator and cooled at -78°C. A solution of 60 g of p-tert-butoxycarbonyloxystyrene monomer in 50 ml of THF, which had been cooled at -78°C, was added to the flask whereupon living anion polymerization took place for 1 hour. The reaction solution turned red. Methanol, 10 g, was added to the reaction solution to quench the reaction. The polymerization solution was poured to 1,000 ml of methanol for precipitation. The resulting precipitate was collected by filtration and dried, obtaining 60 g of poly(p-tert-butoxycarbonyloxystyrene). The polymer was analyzed by ¹H-NMR, ¹³C-NMR, and GPC, with the analytical results shown below.

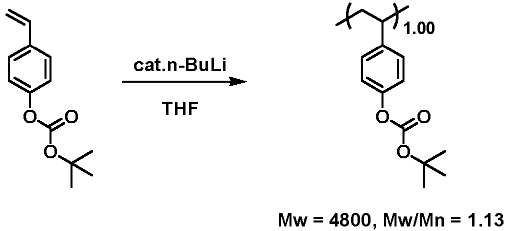

### (2) Synthesis of poly(p-hydroxystyrene)

In a 2-L flask, 50 g of poly(p-tert-butoxycarbonyloxystyrene) was dissolved in 1,500 ml of acetone. A trace of hydrochloric acid was added to the solution at 60°C, which was stirred for 8 hours. The reaction solution was cooled at room temperature and poured to 2,000 ml of water for precipitation. The resulting precipitate was collected by filtration and dried, obtaining 30 g of poly(p-hydroxystyrene). The polymer was analyzed by ¹H-NMR, ¹³C-NMR, and GPC, with the analytical results shown below.

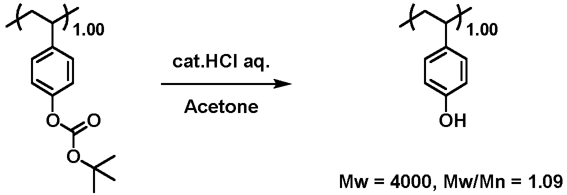

### (3) Synthesis of Polymer P-1

A 100-ml flask was charged with 20 g of poly(p-hydroxystyrene) and 46.7 g of THF solvent. In nitrogen atmosphere, 0.5 g of methanesulfonic acid was added to the solution at ~25°C, after which 13.5 g of acetal modifier AC-1 was added dropwise. The solution was held at room temperature for 4.5 hours for reaction. At the end of reaction, 1.0 g of triethylamine was added to the reaction solution, which was added dropwise to 500 g of hexane for precipitation. The polymer precipitate was collected by filtration and washed twice with 120 g of hexane. The polymer was dissolved in a mixture of 60 g of ethyl acetate and 20 g of water. The resulting solution was transferred to a separatory funnel. After 0.7 g of acetic acid was added to the solution, separatory operation was carried out. With the lower layer removed, 20 g of water and 0.9 g of pyridine were added to the organic layer, followed by separatory operation. With the lower layer removed, 20 g of water was added to the organic layer, followed by water washing and separatory operation. The water washing and separatory operation was carried out 5 times in total. Thereafter, the organic layer was concentrated, the concentrate was dissolved in 40 g of PGME, and the solution was added dropwise to 600 g of water. The resulting precipitate was collected by filtration, washed with water, and dried, obtaining 23.3 g of the target polymer P-1 as a white polymer. Polymer P-1 was analyzed by ¹H-NMR, ¹³C-NMR, and GPC, with the analytical results shown below.

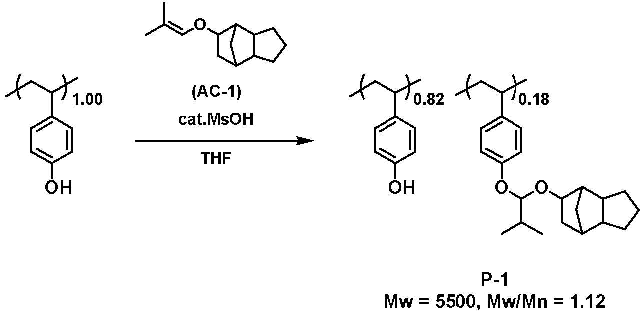

### Synthesis Examples 2 to 20

### Synthesis of Polymers P-2 to P-20

Polymers P-2 to P-20 were synthesized by the same procedure as in Synthesis Example 1 except that the polymer and/or acetal modifier was changed.

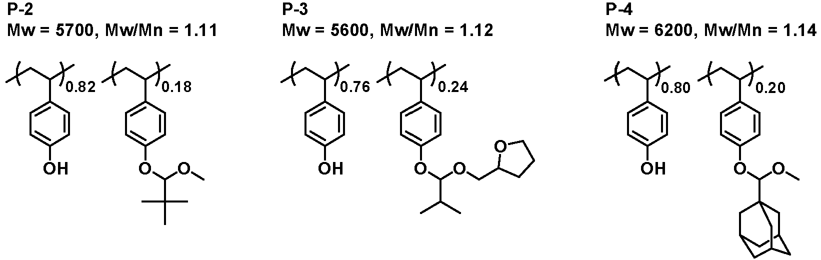

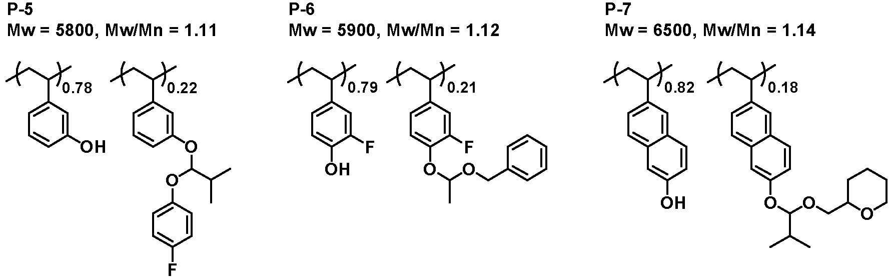

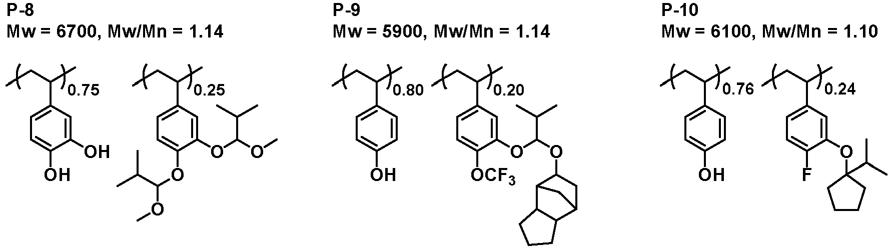

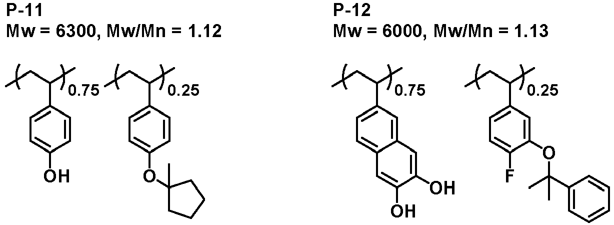

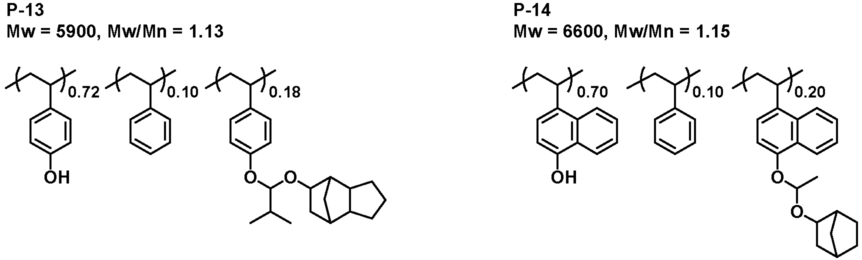

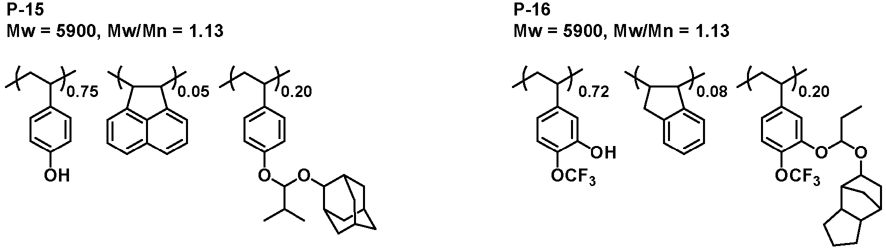

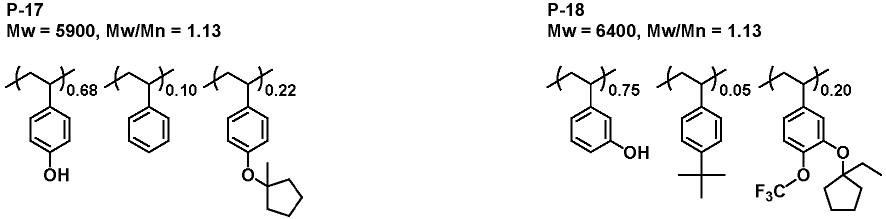

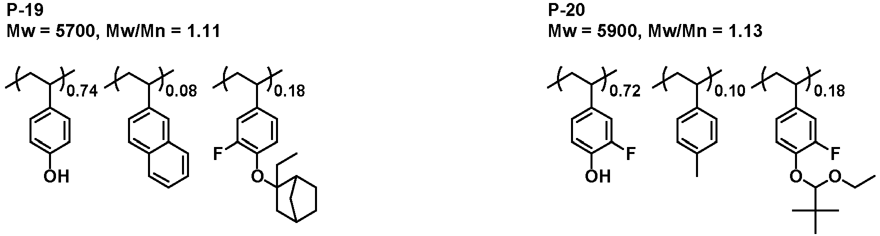

### Comparative Synthesis Examples 1 to 12

### Synthesis of Polymers CP-1 to CP-12

Polymers CP-1 to CP-12 were synthesized by a well-known radical polymerization method using monomers in combination.

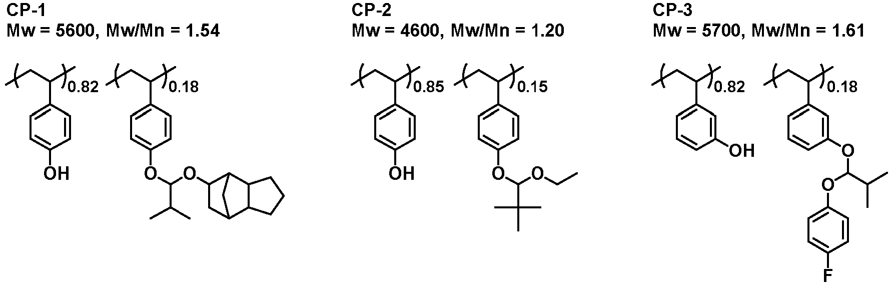

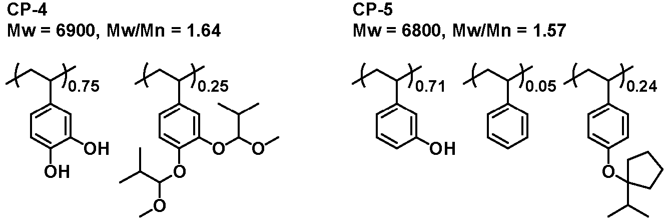

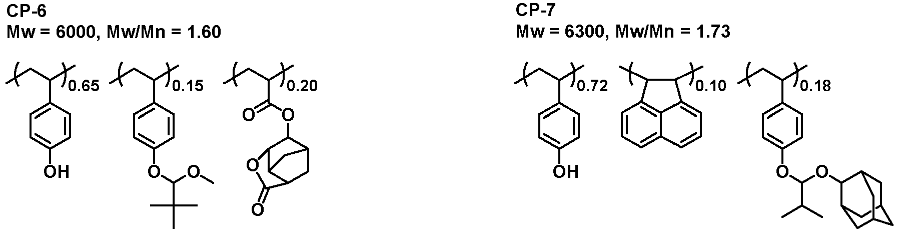

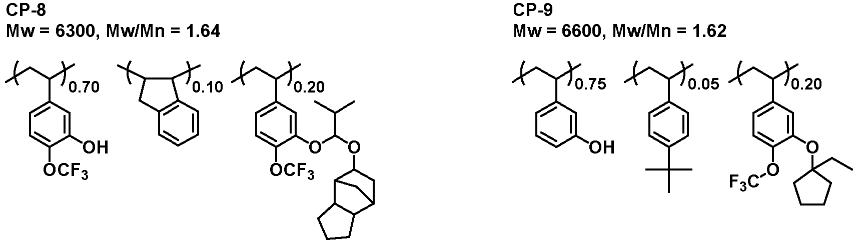

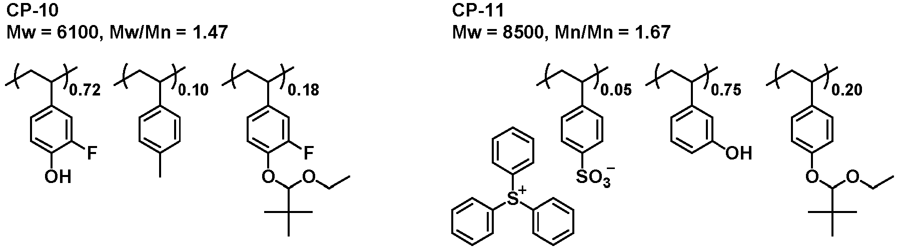

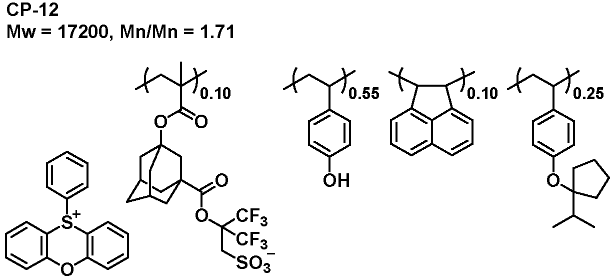

### [2] Preparation of chemically amplified positive resist composition

### Examples 1-1 to 1-50 and Comparative Examples 1-1 to 1-36

A chemically amplified positive resist composition was prepared by dissolving selected components in an organic solvent in accordance with the formulation shown in Tables 1 to 3 and filtering the solution through a nylon filter with a pore size of 5 µm and a UPE filter with a pore size of 1 nm. The organic solvent was a mixture of 940 pbw of PGMEA, 1,870 pbw of EL, and 1,870 pbw of PGME.

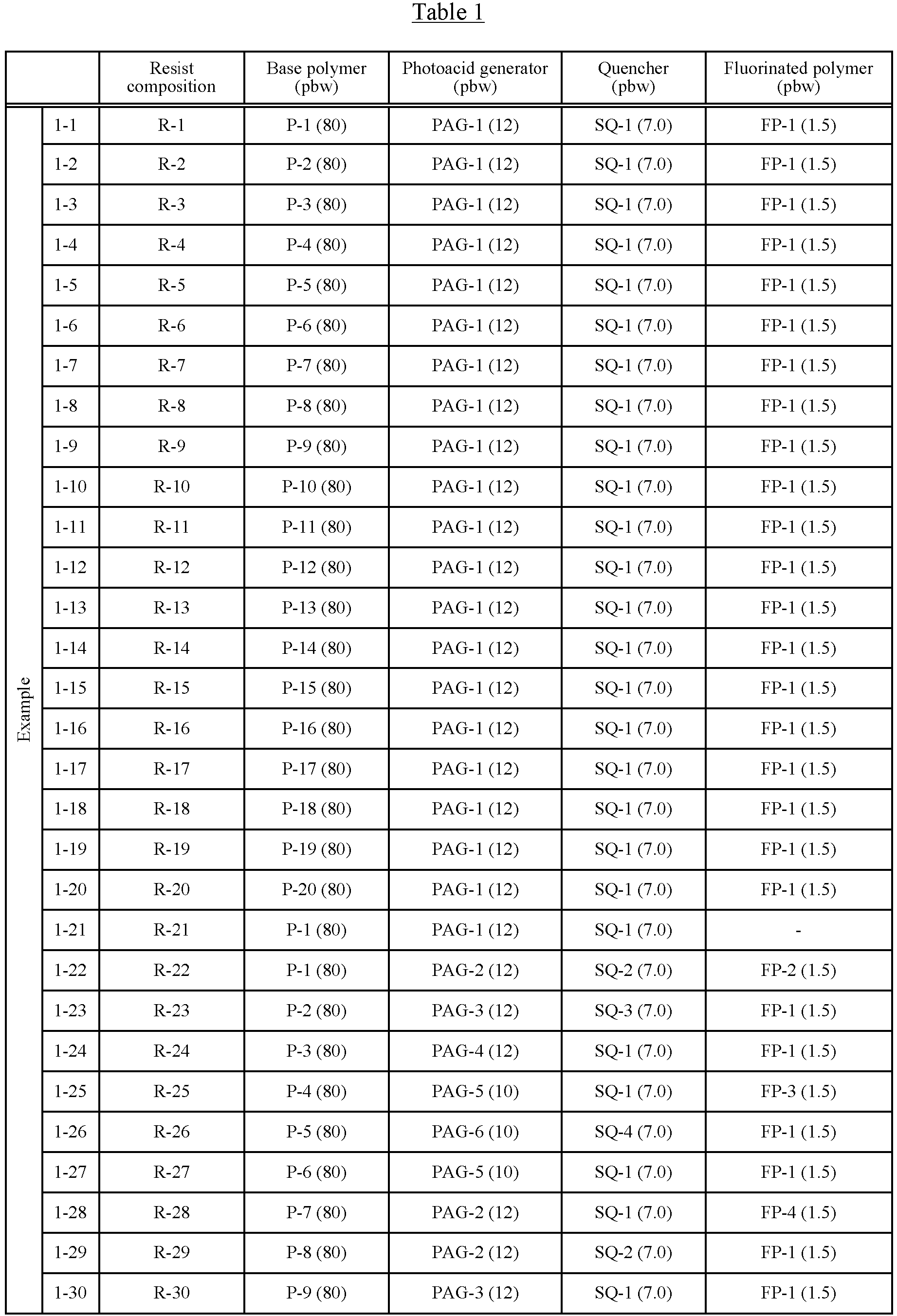

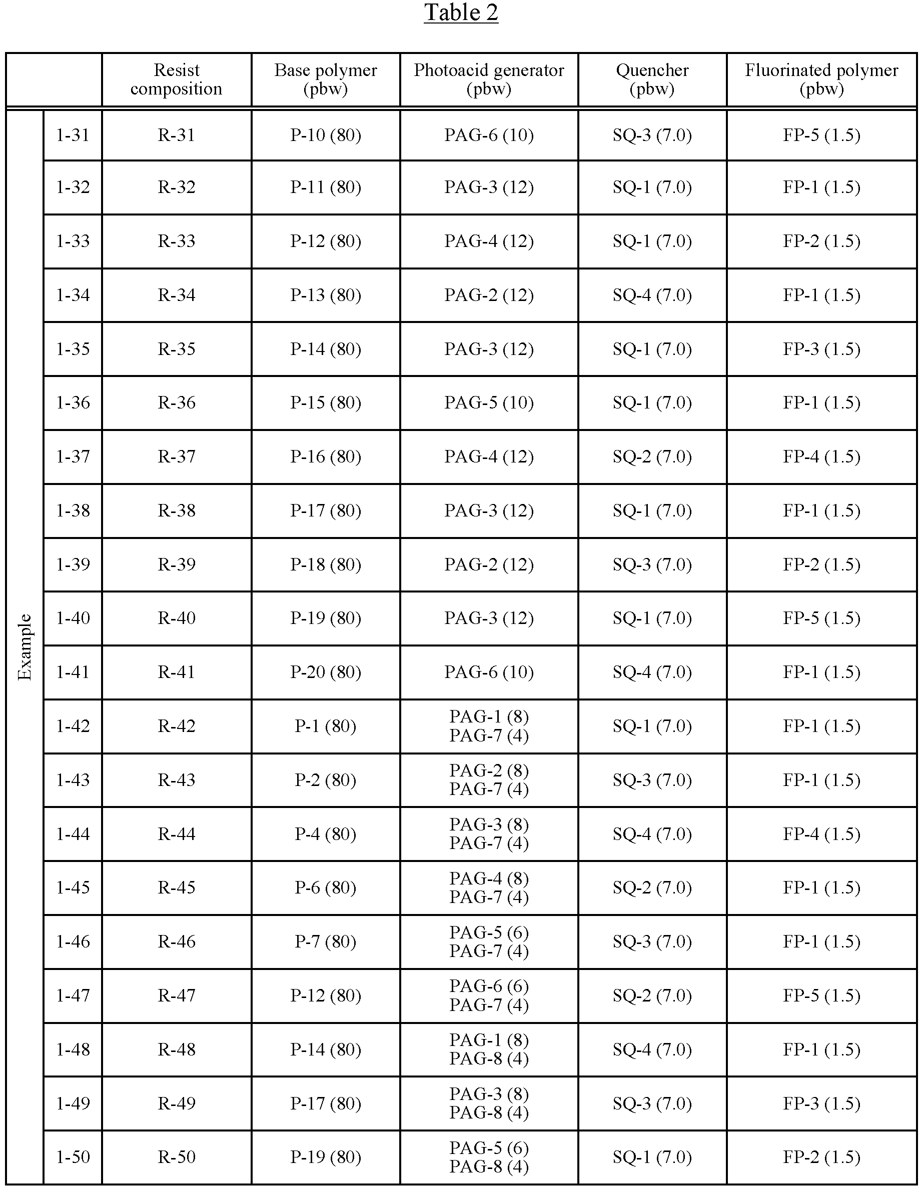

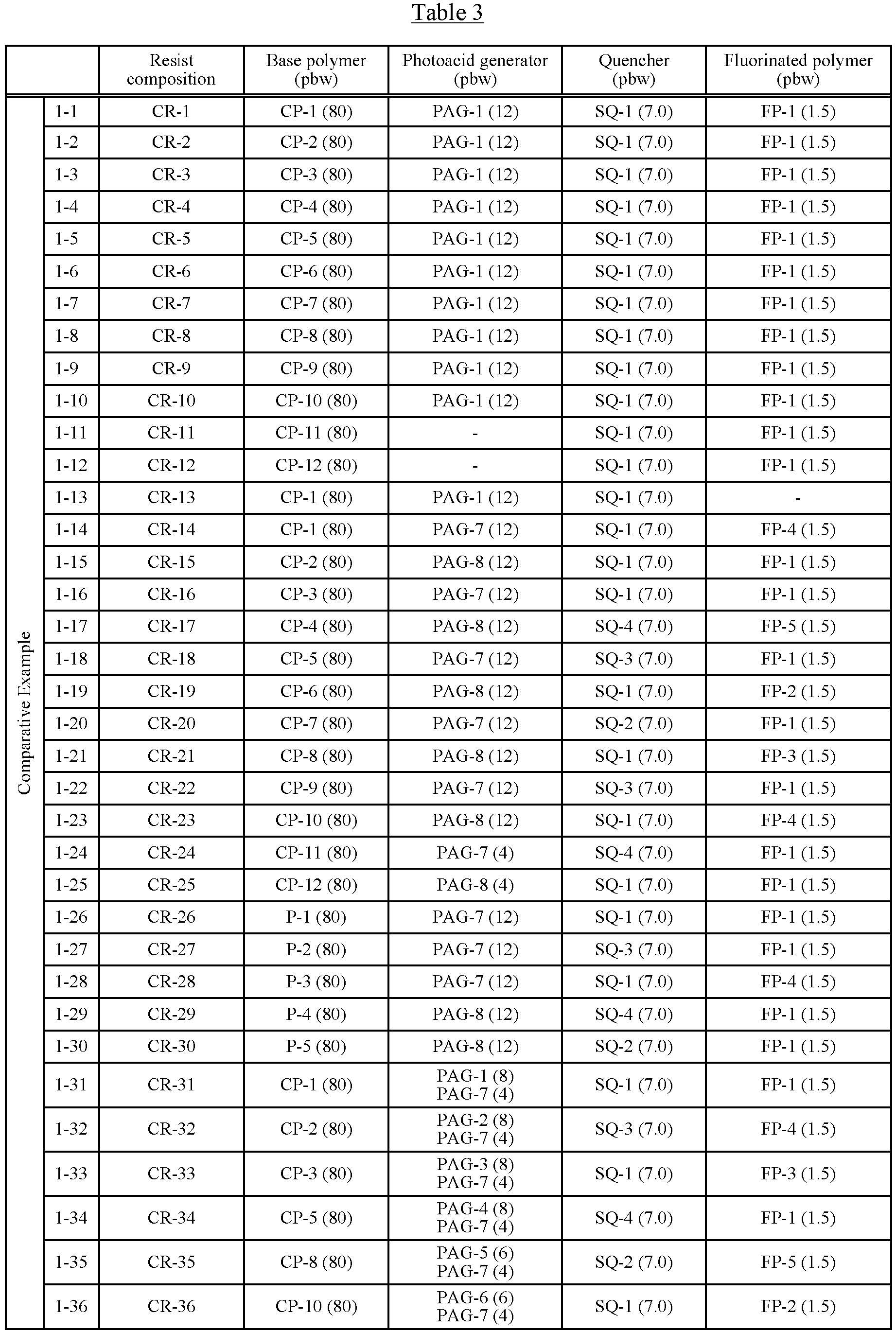

The components in Tables 1 to 3 are identified below.

### Photoacid generators: PAG-1 to PAG-8

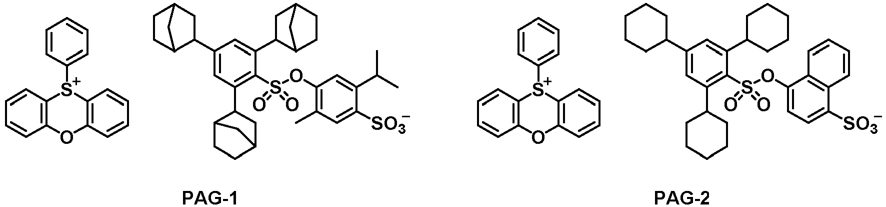

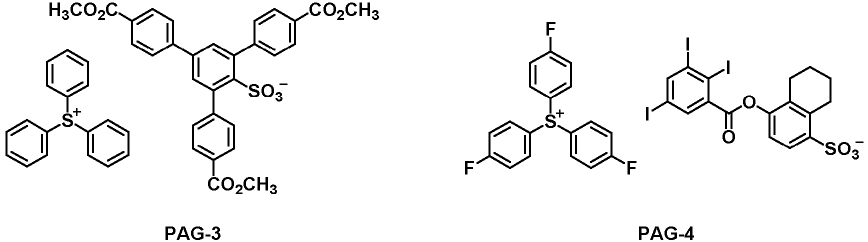

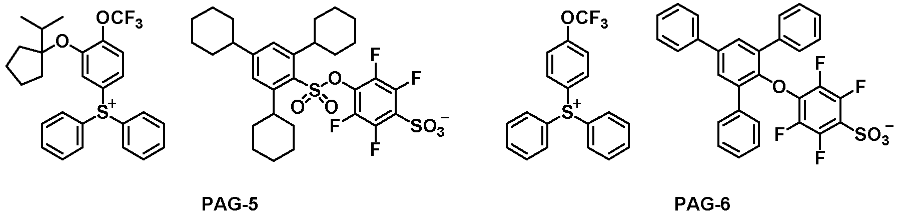

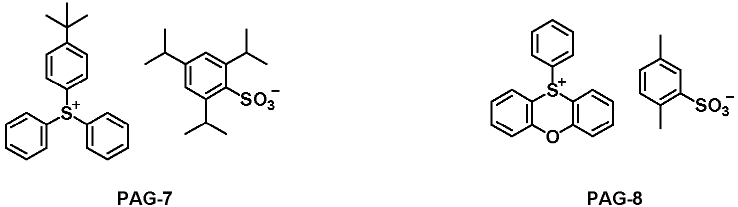

### Quenchers: Q-1 to Q-4

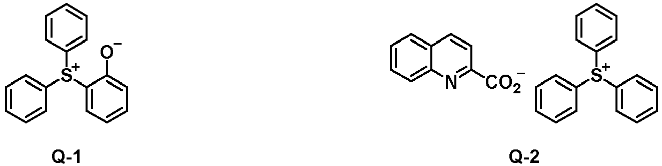

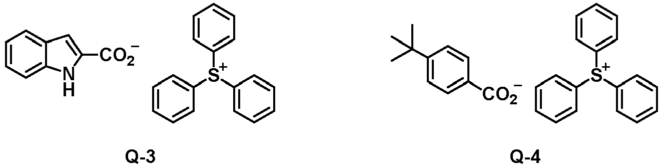

### Fluorinated polymers: FP-1 to FP-5

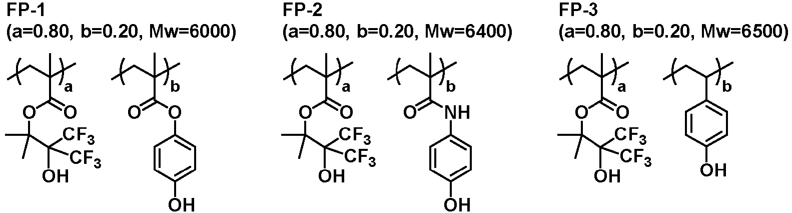

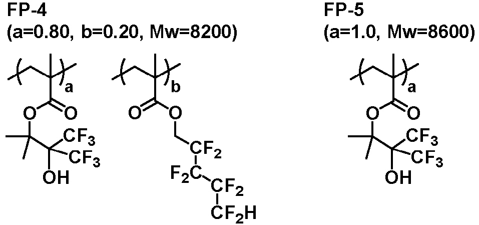

### [3] EB lithography test

### Examples 2-1 to 2-50 and Comparative Examples 2-1 to 2-36

There was furnished a reflection type mask blank for EUV lithography masks. Namely, a mask blank was furnished by forming a multilayer reflective film of 40 Mo/Si layers having a thickness of 284 nm on a low thermal expansion glass substrate of 6 inch squares, then successively depositing thereon a Ru film of 3.5 nm thick as a protective film, a TaN film of 70 nm thick as an absorber layer, and a CrN film of 6 nm thick as a hard mask.

Using a coater/developer system ACT-M (Tokyo Electron Ltd.), each of the positive resist compositions (R-1 to R-50, CR-1 to CR-36) was spin coated onto the reflection type photomask blank and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding an outer rim portion extending 10 mm inward from the periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1:1 resolution at the top and bottom of a 200-nm 1:1 line-and-space (LS) pattern. The resolution (or maximum IS resolution) was defined as the minimum size at the dose which provided a 9:1 resolution for an isolated space (IS) of 200 nm. The edge roughness (LER) of a 200-nm LS pattern was measured under SEM. Also, the pattern was visually observed to judge whether or not the profile was rectangular. The results are shown in Tables 4 to 6.

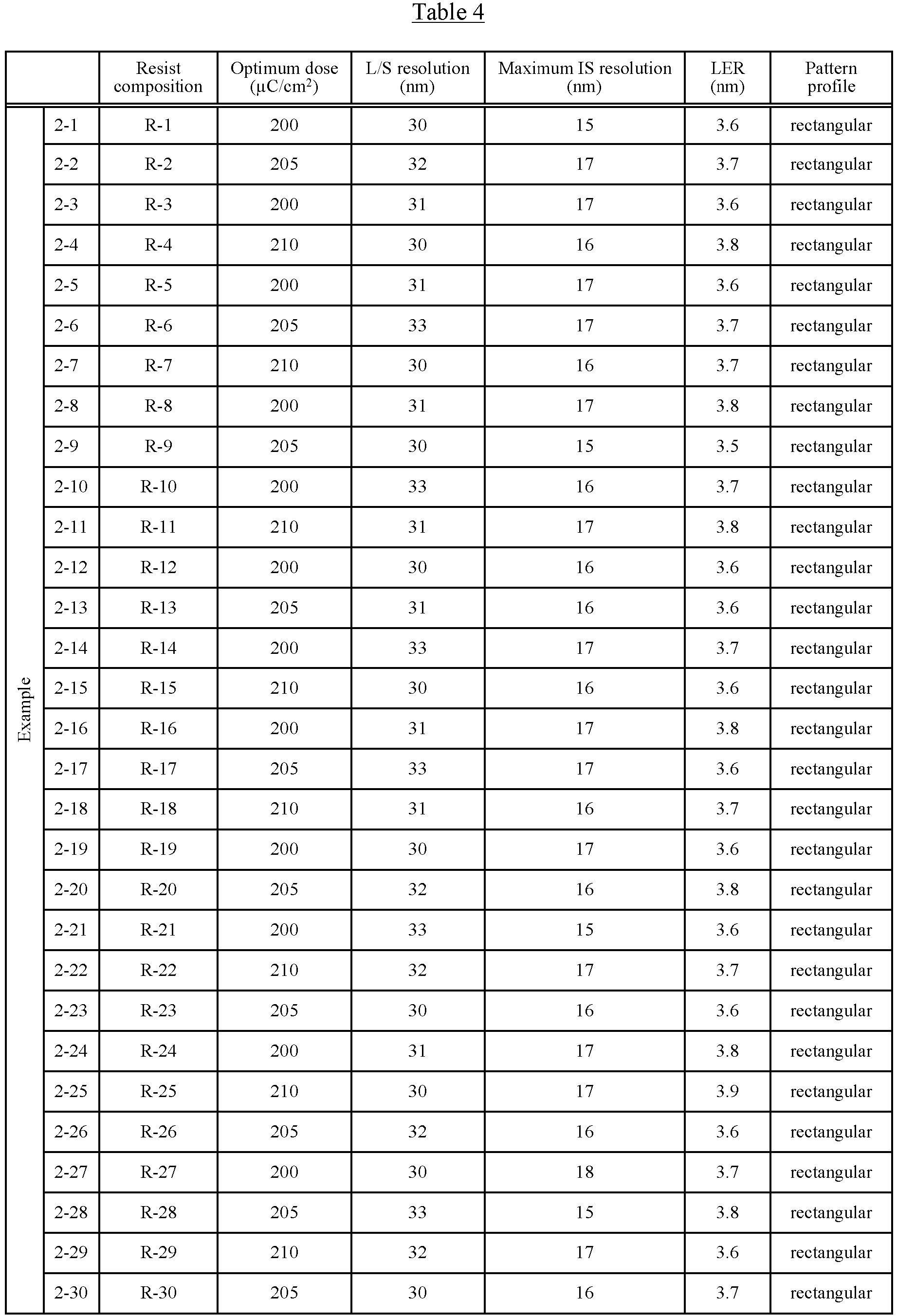

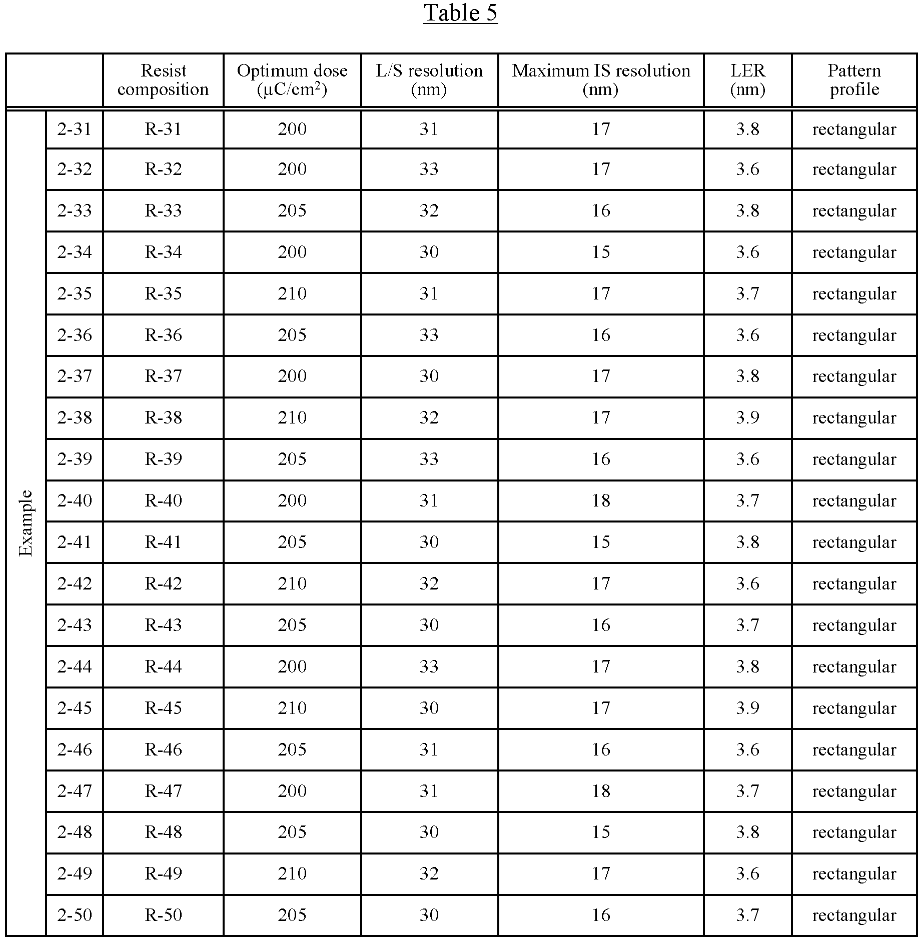

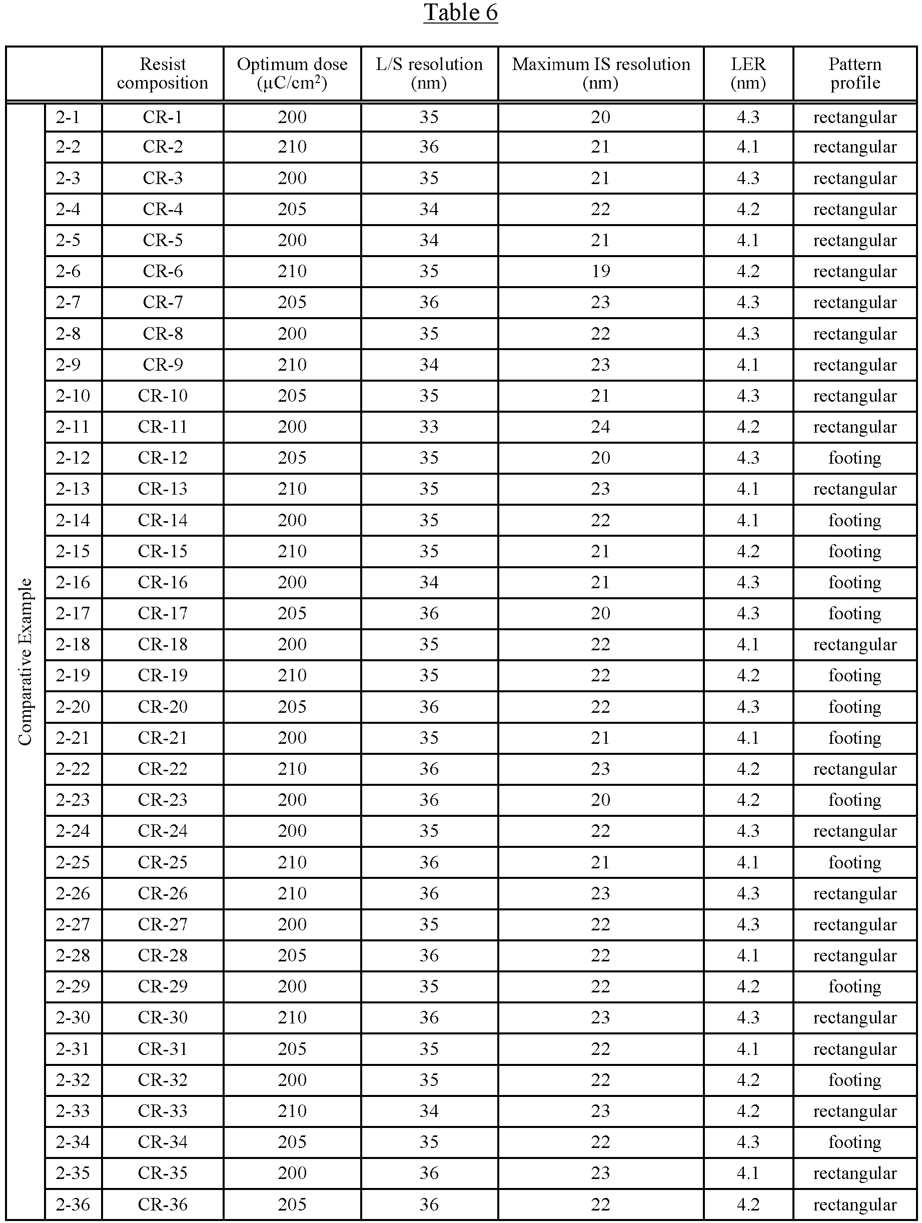

All the chemically amplified positive resist compositions (R-1 to R-50) within the scope of the invention show satisfactory L/S resolution, IS resolution, LER and pattern rectangularity, as compared with comparative resist compositions (CR-1 to CR-36).

### [4] Dry etching test

### Examples 3-1 to 3-20 and Comparative Examples 3-1 to 3-12

Each of the polymers (Polymers P-1 to P-20 and CP-1 to CP-12 in Tables 1 and 2), 2 g, was thoroughly dissolved in 10 g of cyclohexanone, and passed through a filter having a pore size of 0.2 µm, obtaining a polymer solution. The polymer solution was spin coated onto a mask blank of 152 mm squares having a chromium film as the outermost surface and baked to form a polymer film of 300 nm thick. Using a mask dry etching instrument Gen-4 (Plasma Thermo Ltd.), the polymer film was etched with chlorine gas under the following conditions.

| | |
|---|---|
| Chamber pressure: | 6.0 mTorr |
| RF power: | 700 V |
| Cl₂ gas flow rate: | 185 sccm |
| O₂ flow rate: | 55 sccm |
| He flow rate: | 9 sccm |
| Time: | 75 sec |

The difference in film thickness before and after etching was determined. A smaller value of film thickness difference, i.e., a smaller loss indicates better etching resistance. The results of dry etching resistance are shown in Tables 7 to 8.

**Table 7**

| | | Polymer | Cl₂/O₂ gas etching rate (nm/min) |
|---|---|---|---|
| | 3-1 | P-1 | 93 |
| | 3-2 | P-2 | 94 |
| | 3-3 | P-3 | 95 |
| | 3-4 | P-4 | 94 |
| | 3-5 | P-5 | 94 |
| | 3-6 | P-6 | 95 |
| | 3-7 | P-7 | 94 |
| | 3-8 | P-8 | 94 |
| | 3-9 | P-9 | 94 |
| Example | 3-10 | P-10 | 95 |
| | 3-11 | P-11 | 94 |
| | 3-12 | P-12 | 95 |
| | 3-13 | P-13 | 94 |
| | 3-14 | P-14 | 94 |
| | 3-15 | P-15 | 95 |
| | 3-16 | P-16 | 94 |
| | 3-17 | P-17 | 95 |
| | 3-18 | P-18 | 94 |
| | 3-19 | P-19 | 94 |
| | 3-20 | P-20 | 95 |

**Table 8**

| | | Polymer | Cl₂/O₂ gas etching rate (nm/min) |
|---|---|---|---|
| | 3-1 | CP-1 | 101 |
| | 3-2 | CP-2 | 100 |
| | 3-3 | CP-3 | 102 |
| | 3-4 | CP-4 | 99 |
| | 3-5 | CP-5 | 98 |
| Comparative Example | 3-6 | CP-6 | 99 |
| | 3-7 | CP-7 | 98 |
| | 3-8 | CP-8 | 101 |
| | 3-9 | CP-9 | 103 |
| | 3-10 | CP-10 | 102 |
| | 3-11 | CP-11 | 114 |
| | 3-12 | CP-12 | 103 |

As is evident from the results shown in Tables 7 to 8, the inventive polymers display excellent etching resistance against Cl₂/O₂ gas.

It has been demonstrated that the chemically amplified positive resist compositions and resist pattern forming process according to the invention are useful in the photolithography for the fabrication of semiconductor devices, especially the processing of photomask blanks of transmission and reflection types.

## Claims

1. A chemically amplified positive resist composition comprising
(A) a base polymer comprising repeat units derived from hydroxystyrene or hydroxynaphthalene, and repeat units derived from hydroxystyrene having a hydroxy group protected with an acid labile group or hydroxynaphthalene having a hydroxy group protected with an acid labile group, and adapted to increase its solubility in alkaline aqueous solution under the action of acid, the base polymer having a dispersity of 1.0 to 1.19,
(B) a photoacid generator having the formula (B), and
(C) an organic solvent, 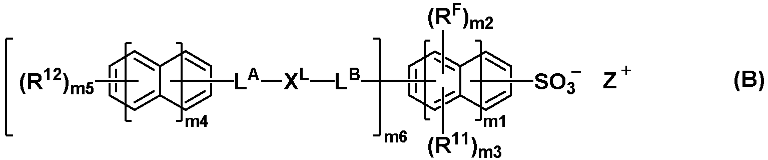 wherein m1 is 0 or 1, m2 is 0, 1, 2, 3 or 4, m3 is 0, 1, 2, 3, 4, 5 or 6, m1 to m3 are in the range: 0 ≤ m2+m3 ≤ 4 when m1=0, and 0 ≤ m2+m3 ≤ 6 when m1=1, m4 is 0 or 1, m5 is 0, 1, 2, 3 or 4 when m4=0 and m5 is 0, 1, 2, 3, 4, 5 or 6 when m4=1, m6 is 0 or 1,
R¹¹ is halogen exclusive of fluorine, hydroxy, nitro, cyano, or a C₁-C₂₀ hydrocarbyl group which may contain a heteroatom, a plurality of R¹¹ may bond together to form a ring with the carbon atoms to which they are attached when m3 is 2 or more,
R¹² is halogen, hydroxy, nitro, cyano, or a C₁-C₂₀ hydrocarbyl group which may contain a heteroatom, a plurality of R¹² may bond together to form a ring with the carbon atoms to which they are attached when m5 is 2 or more,
R^{F} is fluorine, a C₁-C₆ fluorinated saturated hydrocarbyl group, C₁-C₆ fluorinated saturated hydrocarbyloxy group, or C₁-C₆ fluorinated saturated hydrocarbylthio group,
L^{A} and L^{B} are each independently a single bond, ether bond, ester bond, sulfonate ester bond, sulfonamide bond, carbonate bond or carbamate bond,
X^{L} is a single bond or a C₁-C₄₀ hydrocarbylene group which may contain a heteroatom, and
Z⁺ is an onium cation.

2. The resist composition of claim 1 wherein the base polymer has a weight average molecular weight of 1,000 to 50,000.

3. The resist composition of claim 1 or 2 wherein the repeat units derived from hydroxystyrene or hydroxynaphthalene have the formula (A1): 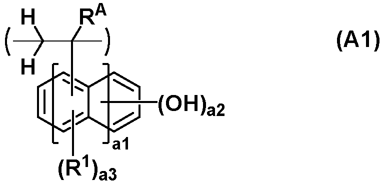 wherein a1 is 0 or 1, a2 is 1, 2 or 3, a3 is 0, 1, 2, 3 or 4, a1 to a3 are in the range: 1 ≤ a2+a3 ≤ 4 when a1=0 and 1 ≤ a2+a3 ≤ 6 when a1=1,
R^{A} is hydrogen, fluorine, methyl or trifluoromethyl, and
R¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group.

4. The resist composition of any one of claims 1 to 3 wherein the repeat units derived from hydroxystyrene having a hydroxy group protected with an acid labile group or hydroxynaphthalene having a hydroxy group protected with an acid labile group have the formula (A2): 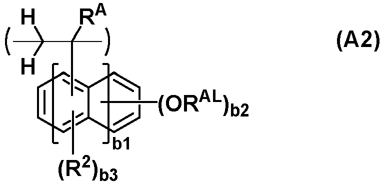 wherein b1 is 0 or 1, b2 is 1, 2 or 3, b3 is 0, 1, 2, 3 or 4, b1 to b3 are in the range: 1 ≤ b2+b3 ≤ 4 when b1=0 and 1 ≤ b2+b3 ≤ 6 when b1=1,
R^{A} is hydrogen, fluorine, methyl or trifluoromethyl,
R² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
when b2=1, R^{AL} is an acid labile group, and when b2=2 or 3, R^{AL} is hydrogen or an acid labile group, at least one thereof being an acid labile group,
the acid labile group has any one of the formulae (AL-1) to (AL-3): 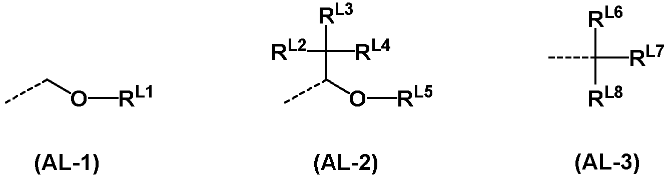 wherein R^{L1} is a C₁-C₂₀ hydrocarbyl group which may contain a heteroatom,
R^{L2}, R^{L3} and R^{L4} are each independently hydrogen or a C₁-C₂₀ hydrocarbyl group which may contain a heteroatom, any two or three of R^{L2}, R^{L3} and R^{L4} may bond together to form a ring with the carbon atom to which they are attached,
R^{L5} is a C₁-C₂₀ hydrocarbyl group which may contain a heteroatom, any one of R^{L2}, R^{L3} and R^{L4} and R^{L5} may bond together to form a ring with the carbon and oxygen atoms to which they are attached,
R^{L6}, R^{L7} and R^{L8} are each independently a C₁-C₂₀ hydrocarbyl group which may contain a heteroatom, any two of R^{L6}, R^{L7} and R^{L8} may bond together to form a ring with the carbon atom to which they are attached,
the broken line designates a point of attachment to the oxygen atom in formula (A2).

5. The resist composition of any one of claims 1 to 4 wherein the base polymer further comprises repeat units of at least one type selected from repeat units having the formula (A3), repeat units having the formula (A4), and repeat units having the formula (A5): 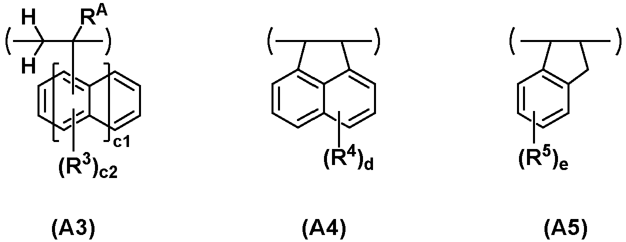 wherein c1 is 0 or 1, c2 is 0, 1, 2, 3, 4 or 5, d is 0, 1, 2, 3, 4, 5 or 6, e is 0, 1, 2, 3 or 4,
R^{A} is hydrogen, fluorine, methyl or trifluoromethyl,
R³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, or cyano, R³ may also be hydroxy when c1=1,
R⁴ and R⁵ are each independently hydroxy, halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group.

6. The resist composition of any one of claims 1 to 5 wherein the photoacid generator has the formula (B1): 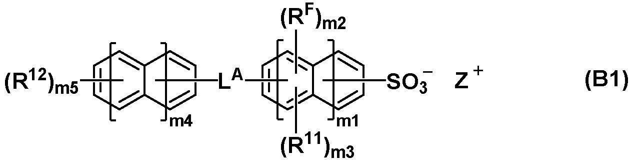 wherein m1 to m5, R¹¹, R¹², R^{F}, L^{A} and Z⁺ are as defined above.

7. The resist composition of any one of claims 1 to 6 wherein Z⁺ is a sulfonium cation having the formula (cation-1) or iodonium cation having the formula (cation-2): 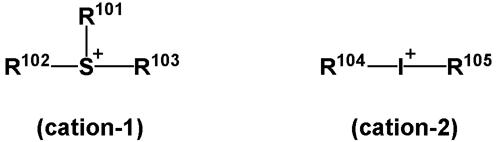 wherein R¹⁰¹ to R¹⁰⁵ are each independently halogen or a C₁-C₃₀ hydrocarbyl group which may contain a heteroatom, and R¹⁰¹ and R¹⁰² may bond together to form a ring with the sulfur atom to which they are attached.

8. The resist composition of any one of claims 1 to 7, further comprising (D) a quencher.

9. The resist composition of any one of claims 1 to 8, further comprising a fluorinated polymer comprising repeat units of at least one type selected from repeat units having the formula (E1), repeat units having the formula (E2), repeat units having the formula (E3), and repeat units having the formula (E4): 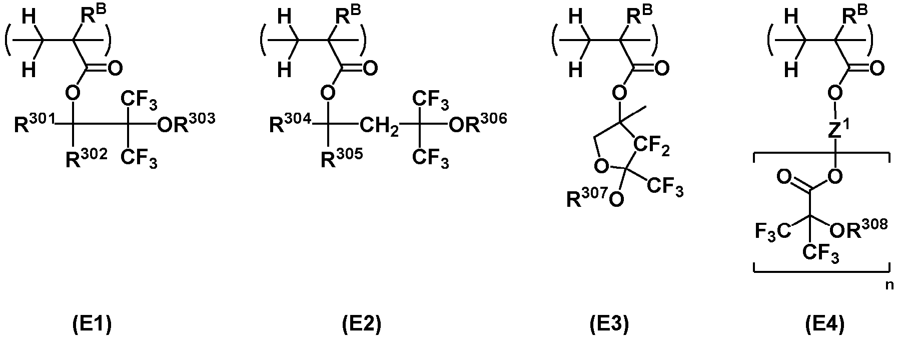 wherein R^{B} is each independently hydrogen, fluorine, methyl or trifluoromethyl,
R³⁰¹, R³⁰², R³⁰⁴ and R³⁰⁵ are each independently hydrogen or a C₁-C₁₀ saturated hydrocarbyl group,
R³⁰³, R³⁰⁶, R³⁰⁷ and R³⁰⁸ are each independently hydrogen, a C₁-C₁₅ hydrocarbyl group, C₁-C₁₅ fluorinated hydrocarbyl group, or acid labile group, and when R³⁰³, R³⁰⁶, R³⁰⁷ and R³⁰⁸ each are a hydrocarbyl or fluorinated hydrocarbyl group, an ether bond or carbonyl moiety may intervene in a carbon-carbon bond,
n is 1, 2 or 3, and
Z¹ is a C₁-C₂₀ (n+1)-valent hydrocarbon group or C₁-C₂₀ (n+1)-valent fluorinated hydrocarbon group.

10. The resist composition of claim 9 wherein the fluorinated polymer further comprises repeat units of at least one type selected from repeat units having the formula (E5) and repeat units having the formula (E6): 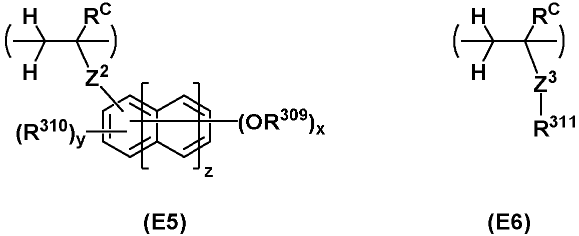 wherein R^{C} is each independently hydrogen or methyl,
R³⁰⁹ is hydrogen or a C₁-C₅ straight or branched hydrocarbyl group in which a heteroatom-containing moiety may intervene in a carbon-carbon bond,
R³¹⁰ is a C₁-C₅ straight or branched hydrocarbyl group in which a heteroatom-containing moiety may intervene in a carbon-carbon bond,
R³¹¹ is a C₁-C₂₀ saturated hydrocarbyl group in which at least one hydrogen is substituted by fluorine, and in which some constituent -CH₂- may be replaced by an ester bond or ether bond,
x is 1, 2 or 3, y is an integer satisfying 0 ≤ y ≤ 5+2z-x, z is 0 or 1,
Z² is a single bond, *-C(=O)-O- or *-C(=O)-NH-,
Z³ is a single bond, -O-, *-C(=O)=O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and
* designates a point of attachment to the carbon atom in the backbone.

11. A resist pattern forming process comprising the steps of:
applying the chemically amplified positive resist composition of any one of claims 1 to 10 onto a substrate to form a resist film thereon,
exposing the resist film patternwise to high-energy radiation, and
developing the exposed resist film in an alkaline developer.

12. The process of claim 11 wherein the high-energy radiation is KrF excimer laser, ArF excimer laser, EUV or EB.

13. The process of claim 11 or 12 wherein the substrate has the outermost surface of a material containing at least one element selected from chromium, silicon, tantalum, molybdenum, cobalt, nickel, tungsten, and tin.

14. The process of any one of claims 11 to 13 wherein the substrate is a mask blank of transmission or reflection type.

15. A mask blank of transmission or reflection type which is coated with the chemically amplified positive resist composition of any one of claims 1 to 10.
